(19) Europäisches Patentamt
European Patent Office
Office européen des brevets

(11) EP 2 821 855 A1

(12) **EUROPEAN PATENT APPLICATION**
published in accordance with Art. 153(4) EPC

(43) Date of publication:
**07.01.2015 Bulletin 2015/02**

(21) Application number: **13755610.6**

(22) Date of filing: **15.02.2013**

(51) Int Cl.:
***G03F 7/033*** (2006.01) ***B41N 1/14*** (2006.01)
***G03F 7/00*** (2006.01) ***G03F 7/004*** (2006.01)
***G03F 7/027*** (2006.01) ***G03F 7/11*** (2006.01)
***G03F 7/32*** (2006.01) ***G03F 7/38*** (2006.01)

(86) International application number:
**PCT/JP2013/053617**

(87) International publication number:
**WO 2013/129127 (06.09.2013 Gazette 2013/36)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **29.02.2012 JP 2012043518**

(71) Applicant: **Fujifilm Corporation**
**Minato-ku**
**Tokyo 106-0031 (JP)**

(72) Inventor: **ABE Junya**
**Haibara-gun**
**Shizuoka 421-0396 (JP)**

(74) Representative: **Hoffmann Eitle**
**Patent- und Rechtsanwälte PartmbB**
**Arabellastraße 30**
**81925 München (DE)**

# (54) LITHOGRAPHIC PRINTING PLATE ORIGINAL AND METHOD FOR PRODUCING LITHOGRAPHIC PRINTING PLATE

(57) To provide a lithographic printing plates having excellent printing durability, chemical resistance, scratch resistance, and ink adhesion while retaining staining resistance as well as processes for preparing such lithographic printing plates.

A lithographic printing plate precursor comprising a support and a photosensitive layer on the support, wherein the photosensitive layer comprises (A) a polymerizable compound, (B) a polymerization initiator, (C) a polyvinyl acetal resin containing at least one hydroxyl group, (D) a crosslinker capable of reacting with at least one of the hydroxyl group and acid group in the polyvinyl acetal to form a crosslink, and (E) a (meth)acrylic resin.

Fig.1

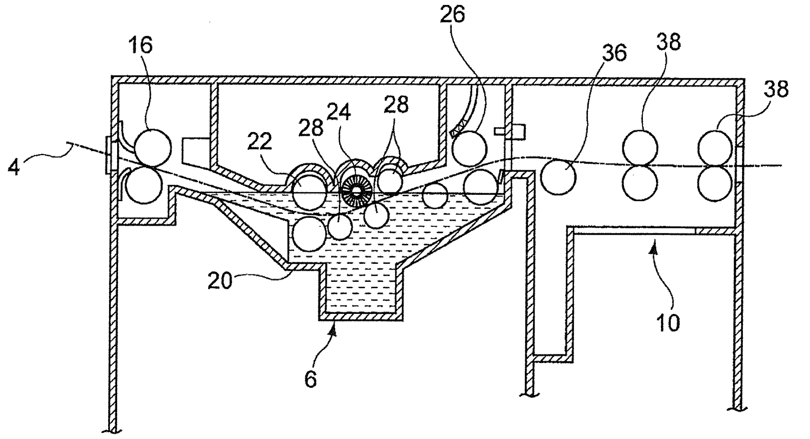




Printed by Jouve, 75001 PARIS (FR)

## Description

The present invention relates to a lithographic printing plate precursor and a method of manufacturing a lithographic printing plate, according to which a printing plate is directly manufacturable based on digital signal output from a computer or the like using various types of laser, the technique being so-called direct plate making, and particularly to a lithographic printing plate precursor and a method of manufacturing planographic a printing plate suitable for simplified processes.

Description of the Related Art

Solid-state laser, semiconductor laser, and gas laser capable of emitting ultraviolet radiation, visible light and infrared radiation, over a wavelength range of 300 nm to 1200 nm, have been becoming more readily available in larger output and smaller size, and these types of laser are very important as recording light sources in direct plate making process using digital data output from a computer or the like. Various recording materials sensitive to these types of laser light have been investigated. The first category of the materials are those adaptive to infrared laser recording at an image recording wavelength of 760 nm or longer, which are exemplified by positive recording material (Patent Document 1), and negative recording material causing acid-catalyzed crosslinking (Patent Document 2). The second category of the materials are those adoptive to ultraviolet or visible light laser recording over the wavelength range from 300 nm to 700 nm, which are exemplified by radical-polymerizable negative recording material (Patent Document 3, Patent Document 4).

The conventional lithographic printing plate precursor (also referred to as "PS plate", hereinafter) have essentially needed, after exposure for image forming, a process of solubilizing and removing the non-image-forming area using an aqueous strong alkaline solution (development process), and have also needed water washing of the developed printing plate, rinsing with a rinsing solution containing a surfactant, and post-treatment such as using a desensitization solution containing gum arabic or a starch derivative. Indispensableness of these additional wet processes has been a big issue of the conventional PS plate. This is because, even if the former half of the plate making process (pattern-wise exposure) may be simplified by virtue of digital processing, the effect of simplification is limitative so long as the latter half (development process) relies upon such labor-consuming wet process.

In particular in recent years, friendliness to the global environment has been a great matter of interest across the whole area of industry, so that issues to be solved from the environmental viewpoint include use of a developer more close to neutral, and reduction in volume of waste liquid. Among others, the wet post-treatment have been desired to be simplified, or replaced with a dry process.

From this point of view, there has been known methods of simplifying the post-treatment process, exemplified by single-liquid treatment or single-bath treatment, by which development and gum solution are proceeded at the same time. More specifically, they belong to a sort of simplified development process by which the original plate is exposed pattern-wise without pre-water washing; removal of a protective layer, removal of the non-image-forming area, and coating of gum solution are implemented concomitantly using a single solution or in a single bath; the original plate is dried without post-water washing, and then put into the printing process. The lithographic printing plate precursor suitable for this sort of simplified development, implemented without the post-water washing, necessarily has a photosensitive layer soluble into a process solution not so strongly alkaline, and the support thereof necessarily has a hydrophilic surface in view of improving staining resistance of the non-image-forming area. However, it was practically impossible to achieve high printing durability and chemical resistance with conventional PS plates while satisfying such requirements.

One approach for simplifying process steps is a method called on-press development by which exposed lithographic printing plate precursors are mounted on a cylinder of a printing press and supplied with a dampening water and an ink while the cylinder is rotated to remove non-image areas of the lithographic printing plate precursors. In other words, lithographic printing plate precursors are mounted on a printing press directly after they are image-exposed so that development is completed during the normal printing process.

Lithographic printing plate precursors suitable for such on-press development are required to have not only an image-forming layer soluble in dampening waters and ink solvents but also lightroom handling suitability for development on a printing press in a lightroom. However, it was practically impossible to sufficiently satisfy such requirements with conventional PS plates.

To satisfy such requirements, lithographic printing plate precursors comprising a photosensitive layer containing thermoplastic hydrophobic polymer microparticles dispersed in a hydrophilic binder polymer on a hydrophilic substrate were proposed (see e.g., Patent Document 7). They were converted into plates by exposing them to an infrared laser to form an image with the thermoplastic hydrophobic polymer microparticles coalesced (fused together) by the heat generated by opto-thermal conversion and then mounting them on a cylinder of a printing press and supplying at least any one of a dampening water and an ink to develop the image on press. The lithographic printing plate precursors are also suitable for handling in a lightroom because the image is recorded in the infrared region.

However, the image formed by coalescing (fusing together) the thermoplastic hydrophobic polymer microparticles is insufficient in fastness so that the resulting lithographic printing plates are disadvantageous in printing durability.

On the other hand, lithographic printing plate precursors comprising microcapsules incorporating a polymerizable compound instead of thermoplastic microparticles were proposed (see e.g., Patent Document 8, Patent Document 9, Patent Document 10, Patent Document 11, Patent Document 12, and Patent Document 13). The lithographic printing plate precursors according to such proposals have the advantage that the polymer images formed by a reaction of the polymerizable compound are superior in fastness to the images formed by coalescence of microparticles. Further, it has often been proposed to isolate the polymerizable compound by using microcapsules because it is highly reactive. Moreover, it has been proposed to use thermodegradable polymers for the shells of the microcapsules.

However, the conventional lithographic printing plate precursors described in Patent Documents 7 to 13 are insufficient in the printing durability of the images formed by laser exposure and should be further improved. Thus, substrates having highly hydrophilic surfaces were used in these easy-to-handle lithographic printing plate precursors, with the result that image areas were readily separated from the substrates with dampening waters during printing and sufficient printing durability could not be attained. If the substrate surfaces are hydrophobic, however, inks also deposit on non-image areas during printing to cause print staining. Thus, it is very difficult to improve both printing durability and staining resistance, and any lithographic printing plate precursor suitable for on-press development with good staining resistance and sufficient printing durability has not been known.

On the other hand, lithographic printing plate precursors comprising a hydrophilic layer with high adhesion to substrate surfaces to improve both printing durability and staining resistance have been known. For example, Patent Document 14 discloses a substrate for lithographic printing plates comprising a hydrophilic layer composed of a polymer compound directly chemically bound to the surface of the substrate and having a hydrophilic functional group on the substrate. Patent Document 15 and Patent Document 16 disclose substrates for lithographic printing plates comprising an aluminum substrate or silicated aluminum substrate having a hydrophilic surface to which is chemically bound a hydrophilic polymer having a reactive group capable of being chemically bound to the substrate surface directly or through a moiety having a crosslinking structure. Patent Document 17 discloses a lithographic printing plate precursor comprising a photosensitive layer containing a polymerization initiator, a polymerizable compound, and a binder polymer soluble or swellable in water or aqueous alkaline solutions on a substrate, wherein the photosensitive layer or an extra layer contains a copolymer comprising a repeating unitrepeating unit having at least one ethylenically unsaturated bond and a repeating unitrepeating unit having at least one functional group interacting with the substrate surface. Patent Document 18 discloses a lithographic printing plate precursor comprising a substrate, a hydrophilic layer formed of a hydrophilic polymer chemically bound to the surface of the substrate and an image-forming layer in order, wherein the hydrophilic polymer comprises at least one of a reactive group capable of being directly chemically bound to the surface of the substrate and a reactive group capable of being chemically bound to the surface of the substrate through a crosslinking structure and a positively and negatively charged substructure.

On the other hand, there have recently been demands for not only improving both printing durability and staining resistance, but also improving chemical resistance and scratch resistance to ease handling of lithographic printing plates during printing after a lapse of time following the preparation of the lithographic printing plates. Further, there have also been demands for improving ink adhesion to provide preprinted matters more stably. Thus, there have been demands for improving not only printing durability and staining resistance but also chemical resistance, scratch resistance, and ink adhesion while striking a balance among them at a high level. However, it is very difficult to satisfy these demands by single bath processes or on-press development due to the lack of the step of protecting the plate surface after development.

To achieve a balance among them, lithographic printing plates using polyvinyl butyral and an acrylic binder in image areas have been proposed (e.g., see patent document 19).

REFERENCES

PATENT DOCUMENTS

Patent document 1: US Patent No. 4708925
Patent document 2: JP-A-H8-276558
Patent document 3: US Patent No. 2850445
Patent document 4: JP-B-S44-20189
Patent document 7: Japanese Patent No. 2938397
Patent document 8: JP-A2000-211262
Patent document 9: JP-A2001-277740

Patent document 10: JP-A2002-29162
Patent document 11: JP-A2002-46361
Patent document 12: JP-A2002-137562
Patent document 13: JP-A2002-326470
Patent document 14: JP-A2001-166491
Patent document 15: JP-A2003-63166
Patent document 16: JP-A2004-276603
Patent document 17: JP-A2008-213177
Patent document 18: JP-A2007-118579
Patent document 19: JP-A2009-516222

## SUMMARY OF THE INVENTION

## PROBLEMS TO BE SOLVED BY THE INVENTION

Under these circumstances, we examined the lithographic printing plate precursors described in patent document 19 to find that their printing durability and scratch resistance were still insufficient. Especially, they had the disadvantage that when the dampening water in undiluted form comes into contact with image areas after they have been converted into lithographic printing plates, the image areas are removed by chemical attack so that printing durability is not provided at all.

One of the factors of the loss of printing durability and chemical resistance was found to lie in the insufficient strength of the binder of the photosensitive layer used in the conventional lithographic printing plates. They also had the disadvantage that if an attempt was made to improve these properties by increasing the strength (film strength) of the binder, it would not dissolve in the developer and rather hamper imaging.

Accordingly, an object of the present invention is to provide lithographic printing plate precursors that can be converted into lithographic printing plates having excellent printing durability, chemical resistance, scratch resistance, chemical resistance, staining resistance, and ink adhesion as well as processes for preparing such lithographic printing plates.

## MEANS TO SOLVE THE PROBLEMS

As a result of careful studies, we concluded that when at least (C) a resin comprising a polyvinyl acetal containing one hydroxyl group, (D) a crosslinker capable of reacting with at least one of the hydroxyl group and acid group in the polyvinyl acetal to form a crosslink, and (E) a (meth)acrylic resin are used in combination in a photosensitive layer, the resin comprising a polyvinyl acetal is crosslinked to improve film strength and printing durability and the incorporation of the (meth) acrylic resin invites changes in the structure of the crosslinked blend polymer to improve the behaviors influenced by the properties of the film surface, i.e. chemical resistance, scratch resistance, and ink adhesion. Thus, we found that the problems described above can be solved by using lithographic printing plate precursors and processes for preparing lithographic printing plates characterized as follows.

Specifically, the problems were solved by the configuration [1], preferably by configurations [2] to [21] below.

[1] A lithographic printing plate precursor comprising a support and a photosensitive layer on the support, wherein the photosensitive layer comprises (A) a polymerizable compound, (B) a polymerization initiator, (C) a polyvinyl acetal resin containing at least one hydroxyl group, (D) a crosslinker capable of reacting with at least one of the hydroxyl group and acid group in the polyvinyl acetal to form a crosslink, and (E) a (meth)acrylic resin.

[2] The lithographic printing plate precursor according to [1], wherein the polyvinyl acetal resin (C) is a polyvinyl butyral resin.

[3] The lithographic printing plate precursor according to [1] or [2], wherein 1 mol % or less of the crosslinker (D) capable of reacting with at least one of the hydroxyl group and acid group in the polyvinyl acetal to form a crosslink is a compound containing a polymerizable group having an ethylenically unsaturated bond.

[4] The lithographic printing plate precursor according to any one of [1] to [3], wherein 1 mol % or less of structural units constituting the polyvinyl acetal resin (C) containing at least one hydroxyl group and acid group is a structural unit having an ethylenically unsaturated bond.

[5] The lithographic printing plate precursor according to any one of [1] to [4], wherein the polymerizable compound (A) contains a urethane bond.

[6] The lithographic printing plate precursor according to any one of [1] to [5], wherein the polymerizable compound (A) contains a urea bond.

[7] The lithographic printing plate precursor according to any one of [1] to [6], wherein the polyvinyl acetal resin

containing at least one hydroxyl group (C) is a modified polyvinyl butyral resin.
[8] The lithographic printing plate precursor according to [7], wherein the modified polyvinyl acetal resin is polyvinyl butyral modified with trimellitic acid.
[9] The lithographic printing plate precursor according to any one of [1] to [8], wherein the support is treated with a polymer containing a phosphoric acid group.
[10] The lithographic printing plate precursor according to any one of [1] to [8], wherein the support is treated with poly(vinylphosphonic acid).
[11] The lithographic printing plate precursor according to any one of [1] to [10], wherein the crosslinker capable of reacting with at least one of the hydroxyl group and acid group in the polyvinyl acetal to form a crosslink (D) is selected from a group consisting of a compound having an aldehyde group, a compound having a hydroxy group or a methylol group, a phenol resin (novolac type or resol type), a melamine resin, a compound having a vinyl sulfone group, a compound having an epoxy group, an epoxy resin, a compound having a carboxylic acid, a compound having a carboxylic anhydride, a compound having an isocyanate group, borane, boric acid, phosphoric acid, a phosphoric acid ester compound, a metal alkoxide, alkoxysilane, or a compound having a combination thereof.
[12] The lithographic printing plate precursor according to any one of [1] to [11], wherein the crosslinker capable of reacting with at least one of the hydroxyl group and acid group in the polyvinyl acetal to form a crosslink (D) forms a crosslinking bond via any one of dehydration condensation, esterification, transesterification and chelation reactions.
[13] The lithographic printing plate precursor according to any one of [1] to [12], wherein the crosslinker capable of reacting with at least one of the hydroxyl group and acid group in the polyvinyl acetal to form a crosslink (D) is selected from at least one of phenol resins, bisphenol epoxy resins, and novolac epoxy resins.
[14] The lithographic printing plate precursor according to any one of [1] to [13], wherein the crosslinker capable of reacting with at least one of the hydroxyl group and acid group in the polyvinyl acetal to form a crosslink (D) has a weight average molecular weight (Mw) of 5000 or more.
[15] The lithographic printing plate precursor according to any one of [1] to [14], wherein the crosslinker capable of reacting with at least one of the hydroxyl group and acid group in the polyvinyl acetal to form a crosslink (D) is present in an amount of 70 % by weight or less relative to the amount of the acetal resin added.
[16] The lithographic printing plate precursor according to any one of [1] to [15], wherein the polyvinyl acetal resin containing at least one hydroxyl group (C) is a polyvinyl butyral resin represented by the structure shown below.

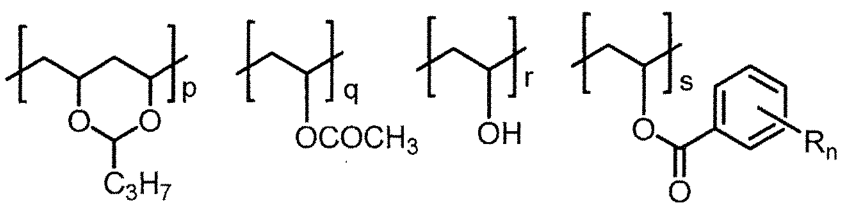

wherein p represents 10 to 90 mol %, q represents 0 to 25 mol %, r represents 1 to 40 mol %, s represents 0 to 25 mol %, and n represents an integer of 0 to 5. R represents a hydrogen atom, -COOH, or $-COOR^1$ wherein $R^1$ represents Na, K, or an alkyl group containing 1 to 8 carbon atoms.
[17] A process for preparing a lithographic printing plate, comprising:

imagewise exposing a lithographic printing plate precursor according to any one of claims 1 to 16; and
developing the exposed lithographic printing plate precursor in the presence of a developer at pH 2 to 14 to remove the photosensitive layer in non-exposed areas.

[18] The process for preparing a lithographic printing plate according to [17], wherein the exposing step comprises heating the exposed precursor at a temperature of 80 °C or more in a preheating unit.
[19] The process for preparing a lithographic printing plate according to [17], wherein the developing step comprises removing the photosensitive layer in non-exposed areas and the protective layer simultaneously in the presence of the developer further containing a surfactant provided that no water-washing step is included.
[20] The process for preparing a lithographic printing plate according to any one of [17] to [19], comprising controlling the pH of the developer at 2 to 14.
[21] A process for preparing a lithographic printing plate, comprising:

imagewise exposing a lithographic printing plate precursor according to any one of claims 1 to 16; and
supplying a printing ink and a dampening water to remove the photosensitive layer in non-exposed areas on a

printing press.

## ADVANTAGES OF THE INVENTION

The present invention makes it possible to provide lithographic printing plates having excellent printing durability, chemical resistance, scratch resistance, and ink adhesion while retaining staining resistance as well as processes for preparing such lithographic printing plates.

## BRIEF DESCRIPTION OF THE DRAWINGS

FIG. 1 is an explanatory drawing illustrating an exemplary configuration of an automatic processor; and
FIG. 2 is an explanatory drawing illustrating another exemplary configuration of the automatic processor.

## THE BEST MODES FOR CARRYING OUT THE INVENTION

The present invention will be explained in detail below. The description of essential features below may be sometimes based on representative embodiments of the present invention, but the present invention is not limited to such embodiments. As used herein, the numerical ranges expressed with "to" are used to mean the ranges including the values indicated before and after "to" as lower and upper limits.
As used herein, any reference to a group in a compound represented by a formula without indicating that the group is substituted or unsubstituted includes the group not only unsubstituted but also substituted if the group may be further substituted, unless otherwise specified. For examples, the reference in a formula that "R represents alkyl, aryl or heterocyclyl" means that "R represents unsubstituted alkyl, substituted alkyl, unsubstituted aryl, substituted aryl, unsubstituted heterocyclyl or substituted heterocyclyl". As used herein, "(meth)acryl" refers to the concept including both methacryl and acryl.

### [Lithographic printing plate precursors]

The lithographic printing plate precursors of the present invention are explained in detail below. The lithographic printing plate precursors of the present invention comprise a support and a photosensitive layer on the support, wherein the photosensitive layer comprises (A) a polymerizable compound, (B) a polymerization initiator, (C) a polyvinyl acetal resin containing at least one hydroxyl group, (D) a crosslinker capable of reacting with at least one of the hydroxyl group and acid group in the polyvinyl acetal to form a crosslink, and (E) a (meth)acrylic resin. The polyvinyl acetal resin containing at least one hydroxyl group (C) is hereinafter sometimes referred to as specific polyvinyl butyral resin or specific PVB resin. Also, the crosslinker capable of reacting with at least one of the hydroxyl group and acid group in the polyvinyl acetal to form a crosslink (D) is hereinafter sometimes simply referred to as crosslinker.
In the lithographic printing plate precursors of the present invention, the photosensitive layer comprises (C) a polyvinyl acetal resin containing at least one hydroxyl group, (D) a crosslinker capable of reacting with at least one of the hydroxyl group and acid group in the polyvinyl acetal to form a crosslink, and (E) a (meth) acrylic resin, whereby the advantages of the present invention can be achieved for the reasons explained below.
The specific polyvinyl acetal resin in the photosensitive layer contains a hydroxyl group or an acid group derived by modification of it as a crosslinking point. Upon heat generation by exposure or preheating after exposure before development, the hydroxyl group / acid group in the specific polyvinyl acetal resin reacts with the crosslinker to form a crosslink, thereby improving film strength in image areas. Film strength is also somewhat improved in non-image areas but not to the extent that image-forming property and developability are influenced, whereby printing durability can be improved without influencing developability and staining resistance. Further, the specific polyvinyl acetal is crosslinked, thereby significantly changing the state of the polymer blend with monomers cured by exposure. This seems to contribute to the compatibility between the polyvinyl acetal resin and the acrylic resin, thus conferring more hydrophobic and scratch-resistant surface conditions on the top of the photosensitive layer, which made it possible to provide lithographic printing plate precursors having excellent chemical resistance, scratch resistance and ink adhesion as well as processes for preparing lithographic printing plates therefrom.
Preferably, the lithographic printing plate precursor of the present invention can be directly converted into a plate using various lasers from digital signals of computers or the like, i.e., it is applicable to so-called computer-to-plate. Preferably, it can also be developed in aqueous solutions at pH 2.0 to 10.0 or less or on a printing press.
Preferred embodiments of the lithographic printing plate precursors of the present invention are explained in detail below.

The lithographic printing plate precursors of the present invention comprise a support and a photosensitive layer provided on the support. As an alternative to embodiments of the lithographic printing plate precursors of the present invention comprising the photosensitive layer on the surface of the support, a primer layer may be provided as an intermediate layer between the support and the photosensitive layer.

Further, the lithographic printing plate precursors of the present invention may optionally comprise a primer layer as an intermediate layer between the support and the photosensitive layer. Furthermore, the lithographic printing plate precursors of the present invention may comprise other component layers. In the present invention, the support and the intermediate layer are preferably contiguous to each other, and more preferably the support, the intermediate layer and the photosensitive layer are contiguous to each other in this order. However, an additional intermediate layer (primer layer) may be provided between the support and the intermediate layer and between the intermediate layer and the photosensitive layer without departing from the spirit of the present invention. Preferably, the lithographic printing plate precursors of the present invention comprise a protective layer on the surface of the photosensitive layer opposite to the support. Further, the lithographic printing plate precursors of the present invention may comprise a back coating layer on the bottom of the support as appropriate.

To make it easy to understand how to form the lithographic printing plate precursors of the present invention, the support, intermediate layer, photosensitive layer, additional layer, protective layer, and back coating layer constituting the lithographic printing plate precursors of the present invention are explained below in order.

[Support]

The support used for the lithographic printing plate precursors of the present invention is not specifically limited, but may be any dimensionally stable hydrophilic support in the form of a plate. Especially, it is preferably an aluminum support.

Among aluminum supports, those subjected to surface treatments such as graining and anodization are preferred. Details about an aluminum support subjected to such surface treatments as graining and anodization are described in JP-A2009-516222 and WO 2007/057348, and reference can be made to these documents.

An acid is used for graining aluminum supports. The acid used for graining can be e.g. an acid comprising nitric acid, sulfuric acid, or hydrogen chloride, preferably an acid comprising hydrogen chloride. Also, mixtures of e.g. hydrogen chloride and acetic acid can be used.

Further, the relation between electrochemical graining and anodizing parameters such as electrode voltage, nature and concentration of the acid electrolyte or power consumption on the one hand and the obtained lithographic quality in terms of Ra and anodic weight ($g/m^2$ of $Al_2O_3$ formed on the aluminum surface) on the other hand has already been known, and more details can be found in e.g. the article "Management of Change in the Aluminium Printing Industry" by F. R. Mayers, published in the ATB Metallurgie Journal, volume 42 nr. 1-2 (2002) pag. 69.

The anodized aluminum support may be subjected to a so-called post-anodic treatment to improve the hydrophilic properties of its surface. For example, the aluminum support may be silicated by treating its surface with a sodium silicate solution at elevated temperature, e.g. 95 °C. Alternatively, a phosphate treatment may be applied which involves treating the aluminum oxide surface with a phosphate solution that may further contain an inorganic fluoride. Further, the aluminum oxide surface may be rinsed with a citric acid or citrate solution. This treatment may be carried out at room temperature or may be carried out at a slightly elevated temperature of about 30 to 50 °C. Further, the aluminum oxide surface may be rinsed with a bicarbonate solution. Still further, the aluminum oxide surface may be treated with polyvinylphosphonic acid, polyvinylmethylphosphonic acid, phosphoric acid esters of polyvinyl alcohols, polyvinylsulfonic acid, polyvinylbenzenesulfonic acid, sulfuric acid esters of polyvinyl alcohols, and acetals of polyvinyl alcohols produced by reaction with a sulfonated aliphatic aldehyde.

Another useful post-anodic treatment may be carried out with a solution of polyacrylic acid or a polymer comprising at least 30 mol % of acrylic acid monomeric units, e.g. GLASCOL E15, a polyacrylic acid commercially available from ALLIED COLLOIDS.

The grained and anodized aluminum support may be a sheet-like material such as a plate or it may be a cylindrical element such as a sleeve which can be slid around a print cylinder of a printing press.

Besides the surface treatments such as graining and anodization, the support may be subjected to e.g. mechanical surface-roughening treatments, electrochemical surface-roughening treatments (surface-roughening treatments by which surfaces are electrochemically dissolved), and chemical surface-roughening treatments (surface-roughening treatments by which surfaces are selectively chemically dissolved). For these treatments, the methods described in paragraphs [0241] to [0245] of JP-A2007-206217 can be preferably used.

Preferably, the support has a center line average roughness of 0.10 to 1.2 $\mu$m. When it is in this range, good adhesion to the photosensitive layer, good printing durability and good stain resistance can be obtained. Further, the support preferably has a color density of 0.15 to 0.65 expressed as reflection density. When it is in this range, halation is prevented during imagewise exposure, thereby providing good image-forming property and good visual inspection

after development.
Preferably, the support has a thickness of 0.1 to 0.6 mm, more preferably 0.15 to 0.4 mm, even more preferably 0.2 to 0.3 mm.

The support can also be a flexible support provided with a hydrophilic layer (hereinafter also referred to as "base layer"). The flexible support is e.g. paper, plastic film or aluminum or the like. Preferred examples of plastic film include polyethylene terephthalate film, polyethylene naphthalate film, cellulose acetate film, polystyrene film, polycarbonate film, etc., and the plastic film support may be opaque or transparent.

The base layer is preferably a cross-linked hydrophilic layer obtained from a hydrophilic binder cross-linked with a hardening agent such as formaldehyde, glyoxal, polyisocyanate or a hydrolyzed tetraalkyl orthosilicate. The latter is particularly preferred. The thickness of the hydrophilic base layer may vary in the range of 0.2 to 25 μm and is preferably 1 to 10 μm. More details of preferred embodiments of the base layer can be found in e.g. EP-A 1 025 992.

[The support may be hydrophilized or provided with a primer layer]

In the lithographic printing plate precursors of the present invention, it is also preferred that the surface of the support is hydrophilized or a primer layer is provided between the support and the photosensitive layer to improve hydrophilicity and prevent print staining in non-image areas.

Methods of hydrophilization of the surface of the support include alkali metal silicate treatment by which the support is dipped into an aqueous solution of sodium silicate or the like, for electrolytic treatment; treatment using potassium fluorozirconate; and treatment using polyvinyl phosphonate. The method using an aqueous solution of polyvinyl phosphonate is preferably used.

The primer layer used is preferably a primer layer comprising a compound containing an acid group such as phosphonic acid, phosphoric acid, sulfonic acid or the like. Preferably, these compounds further contain a polymerizable group in order to improve adhesion to the photosensitive layer. Other preferred compounds include compounds containing a hydrophilicity-imparting group such as an ethylene oxide group or the like.
These compounds may be small molecules or high-molecular polymers. Preferred examples include the silane coupling agents having an addition-polymerizable reactive group containing an ethylenic double bond described in JP-A-H10-282679; the phosphorus compounds having a reactive group containing an ethylenic double bond described in JP-A-H2-304441; and the like.
The most preferred primer layers include those comprising a low molecular or high molecular compound having a crosslinkable group (preferably a group containing an ethylenically unsaturated bond), a functional group interacting with the surface of the support and a hydrophilic group described in JP-A2005-238816, JP-A2005-125749, JP-A2006-239867, and JP-A2006-215263.

Preferably, the coating mass of the primer layer is 0.001 to 1.5 g/m$^2$, more preferably 0.003 to 1.0 g/m$^2$, even more preferably 0.005 to 0.7 g/m$^2$.

<Methods for forming an intermediate layer>

An intermediate layer can be provided by applying a solution of the compound dissolved in water or an organic solvent such as methanol, ethanol, methyl ethyl ketone or the like or a mixed solvent thereof on the substrate and drying it, or immersing the substrate in a solution of the compound dissolved in water or an organic solvent such as methanol, ethanol, methyl ethyl ketone or the like or a mixed solvent thereof to allow the compound to be adsorbed, and then washing it with water or the like and drying it. In the former method, a solution of the compound at a concentration of 0.005 to 10 % by mass can be applied by various techniques.

Any technique can be used, such as bar coating, spin coating, spray coating, curtain coating and the like, for example. In the latter method, the concentration of the solution is 0.01 to 20 % by mass, preferably 0.05 to 5 % by mass, the immersion temperature is 20 to 90 °C, preferably 25 to 50 °C, and the immersion time is 0.1 second to 20 minutes, preferably 2 seconds to 1 minute.

[Back coating layer]

After the support has been subjected to a surface treatment or after a primer layer has been formed, a back coating layer can be provided on the bottom of the support, as appropriate. The back coat layer is preferably exemplified by a cover layer composed of the organic polymer compounds described in Japanese Laid-Open Patent Publication No. H05-45885, or composed of the metal oxides described in Japanese Laid-Open Patent Publication No. H06-35174 which are obtained by allowing organic metal compound or inorganic metal compound to hydrolyze or undergo polycondensation. Among them, alkoxy compounds of silicon, such as Si $(OCH_3)_4$, Si $(OC_2H_5)_4$, Si $(OC_3H_7)_4$, Si $(OC_4H_9)_4$ are preferable in view of inexpensiveness and availability of the source materials.

<Photosensitive layer>

The photosensitive layer in the present invention comprises (A) a polymerizable compound, (B) a polymerization initiator, (C) a polyvinyl acetal resin containing at least one hydroxyl group, (D) a crosslinker capable of reacting with at least one of the hydroxyl group and acid group in the polyvinyl acetal to form a crosslink, and (E) a (meth) acrylic resin. Further, it may comprise a sensitizer, and a colorant. Besides these components, it may also comprise other photosensitive layer components.

(A) Polymerizable Compound

The polymerizable compound used for the image recording layer in the present invention is an addition polymerizable compound having at least one ethylenic unsaturated double bond, and is selected from compounds having at least one, and preferably two, terminal ethylenic unsaturated bonds. These compounds typically have any of chemical forms including monomer; prepolymer such as dimer, trimer and oligomer; and mixtures of them. Examples of the monomer include unsaturated carboxylic acid (for example, acrylic acid, methacrylic acid, itaconic acid, crotonic acid, isocrotonic acid, maleic acid), esters of them, and amides of them. More preferable examples include esters formed between unsaturated carboxylic acid and polyhydric alcohol compound, and amides formed between unsaturated carboxylic acid and polyvalent amine compound. Still other preferable examples include adducts of unsaturated carboxylate esters or amides having nucleophilic substituent group such as hydroxy group, amino group, mercapto group or the like, formed together with monofunctional or polyfunctional isocyanates or epoxys; and dehydration condensation product formed together with monofunctional or polyfunctional carboxylic acid. Still other preferable examples include adducts of unsaturated carboxylate esters or amides having electrophilic substituent group such as isocyanate group and epoxy group, formed together with monofunctional or polyfunctional alcohols, amines, or thiols; and substitution products of unsaturated carboxylate esters or amides having eliminative substituent group such as halogen group and tosyloxy group, formed together with monofunctional or polyfunctional alcohols, amines, or thiols.

Also compounds obtained by replacing the above-described unsaturated carboxylic acid with unsaturated phosphonic acid, styrene, vinyl ether or the like are also adoptable.

Specific examples of the monomer in the form of acrylate ester formed between polyhydric alcohol compound and unsaturated carboxylic acid include ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanurate ethylene oxide (EO)-modified triacrylate, and polyester acrylate oligomer. Examples of methacrylate ester include tetramethylene glycol dimethacrylate, neopentyl glycol dimethacrylate, trimethylolpropane trimethacrylate, ethylene glycol dimethacrylate, pentaerythritol trimethacrylate, bis[*p*-(3-methacryl oxy-2-hydroxypropoxy)phenyl]dimethylmethane, and bis-[*p*-(methacryloxyethoxy)phenyl]dimethylmethane. Specific examples of the monomer in the form of amide formed between polyvalent amine compound and unsaturated carboxylic acid include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, and xylylene bismethacrylamide.

Also urethane-based addition polymerizable compound, obtainable by addition polymerization between the isocyanate and hydroxy group, is preferable. Preferable examples of this sort of compound include vinyl urethane compound having two or more polymerizable vinyl groups per one molecule, which is obtainable by addition reaction between a vinyl monomer having a hydroxy group represented by the formula (A) below, and a polyisocyanate compound having two or more isocyanate groups per one molecule, as described in Examined Japanese Patent Publication No. S48-41708.

$$CH_2=C (R^4) COOCH_2CH (R^5) OH \qquad (A)$$

(where, each of $R^4$ and $R^5$ represents H or $CH_3$.)

Also preferred are the urethane acrylates described in JP-A-S51-37193, JP-B-H2-32293, and JP-B-H2-16765, as well as the urethane compounds having an ethylene oxide skeleton described in JP-B-S58-49860, JP-B-S56-17654, JP-B-S62-39417, and JP-B-S62-39418.

Further, the photooxidizable polymerizable compounds described in JP-A2007-506125 are also preferred, among which the polymerizable compounds containing at least one urea group and/or tertiary amino group are especially preferred.

In the present invention, compounds containing a urethane bond and/or urea bond are especially preferred, and more preferred are (meth)acrylates containing a urethane bond and/or urea bond. In the present invention, multifunctional polymerizable compounds are also preferred, and more preferred are bi- or trifunctional polymerizable compounds. The advantages of the present invention tend to be provided more effectively by employing such compounds. Specifically,

the compound shown below is included.

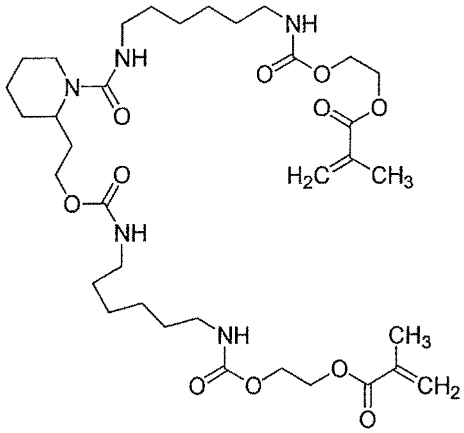

Details of methods for using these polymerizable compounds such as their structures, whether they should be used alone or in combination, the amount to be added and the like can be appropriately determined depending on the performance design of the final lithographic printing plate precursor. The polymerizable compounds described above are preferably used in the range of 5 to 75 % by weight, more preferably 25 to 70 % by weight, even more preferably 30 to 70 % by weight, still more preferably 40 to 70 % by weight, especially preferably 50 to 70 % by weight based on the total solids of the photosensitive layer.

(B) Polymerization initiator

The photosensitive layer of the present invention preferably contains a polymerization initiator (hereinafter also referred to as an "initiator compound"). In the present invention, a radical polymerization initiator is preferably used.

The initiator compound may be arbitrarily selected from compounds known among those skilled in the art without limitation. Specific examples include trihalomethyl compound, carbonyl compound, organic peroxide, azo compound, azide compound, metallocene compound, hexaarylbiimidazole compound, organic boron compound, disulfone compound, oxim ester compound, onium salt compound, and iron arene complex. In particular, the initiator compound is preferably at least one species selected from the group consisting of hexaarylbiimidazole compound, onium salt, trihalomethyl compound and metallocene compound, and is particularly hexaarylbiimidazole compound, or onium salt. Two or more species of them may be used in combination as the polymerization initiator.

The hexaarylbiimidazole compound is exemplified by lophine dimers described in European Patent Nos. 24, 629 and No. 107,792, and United States Patent No. 4,410,621, which are exemplified by 2,2'-bis(*o*-chlorophenyl)-4,4',5,5'-tetraphenylbiimidazo le, 2,2'-bis(*o*-bromophenyl)-4,4',5,5'-tetraphenylbiimidazol e, 2,2'-bis(*o,p*-dichlorophenyl)-4,4',5,5'-tetraphenylbiimi dazole, 2,2'-bis(*o*-chlorophenyl)-4,4',5,5'-tetra(*m*-methoxypheny l)biimidazole, 2,2'-bis(*o,o'*-dichlorophenyl)--4,4',5,5'-tetraphenylbiim idazole, 2,2'-bis(*o*-nitrophenyl)-4,4',5,5'-tetraphenylbiimidazol e, 2,2'-bis(*o*-methylphenyl)-4,4',5,5'-tetraphenylbiimidazo le, and 2,2'-bis(*o*-trifluorophenyl)-4,4',5,5'-tetraphenylbiimid azole. It is particularly preferable that the hexaarylbiimidazole compound is used in combination with a sensitizing dye which shows maximum absorption in the wavelength range from 300 to 450 nm.

Onium salts that are preferably used in the present invention include sulfonium salts, iodonium salts, and diazonium salts. Especially, diaryl iodonium salts, and triaryl sulfonium salts are preferably used. The onium salts are especially preferably used in combination with an infrared absorber having a maximum absorption between 750 and 1400 nm.

Details about the onium salts can be found in the description at paragraph 0049 of JP-A2012-031400.

More preferred are iodonium salts, sulfonium salts and azinium salts. Specific examples of these compounds are shown below, but it should be understood that the present invention is not limited to these examples.

The iodonium salt is preferably diphenyliodonium salt, more preferably diphenyliodonium salt substituted by an electron donor group such as alkyl group or alkoxyl group, and still more preferably asymmetric diphenyliodonium salts. Specific examples include diphenyliodonium hexafluorophosphate, 4-methoxyphenyl-4-(2-methylpropyl)phenyliodonium hexafluorophosphate, 4-(2-methylpropyl)phenyl-*p*-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate, and bis(4-t-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate, tris(4-chlorophenyl)sulfonium 3,5-bis(methoxycarbonyl)benzenesulfonate, and tris(4-chlorophenyl)sulfonium hexafluorophosphate.

Examples of the azinium salt include 1-cyclohexylmethyloxypyrydinium hexafluorophosphate, 1-cyclohexyloxy-4-phenylpyrydinium hexafluorophosphate, 1-ethoxy-4-phenylpyrydinium hexafluorophosphate, 1-(2-ethylhexyloxy)-4-phenylpyrydinium hexafluorophosphate, 4-chloro-1-cyclohexylmethyloxypyrydinium hexafluorophosphate, 1-ethoxy-4-cyanopyrydinium hexafluorophosphate, 3,4-dichloro-1-(2-ethylhexyloxy)pyrydinium hexafluorophosphate, 1-benzyloxy-4-phenylpyrydinium hexafluorophosphate, 1-phenetyloxy-4-phenylpyrydinium hexafluorophosphate, 1-(2-ethylhexyloxy)-4-phenylpyrydinium *p*-toluenesulfonate, 1-(2-ethylhexyloxy)-4-phenylpyrydinium perfluorobutanesulfonate, 1-(2-ethylhexyloxy)-4-phenylpyrydinium bromide, and 1-(2-ethylhexyloxy)-4-phenylpyrydinium tetrafluoroborate.

It is particularly preferable that the onium salt is used in combination with an infrared absorber which shows maximum absorption in the wavelength range from 750 to 1400 nm.

Besides them, also polymerization initiators described in paragraphs [0071] to [0129] of Japanese Laid-Open Patent Publication No. 2007-206217 are preferably used.

In the present invention, the polymerization initiators can be conveniently used alone or as a combination of two or more of them.

The amount of the polymerization initiators used in the photosensitive layer in the present invention is preferably 0.01 to 20 % by weight, more preferably 0.1 to 15 % by weight based on the weight of the total solids of the photosensitive layer. Even more preferably, it is 1.0 % by weight to 10 % by weight.

(C) Polyvinyl acetal resin containing at least one hydroxyl group

The polyvinyl acetal resin containing at least one hydroxyl group (hereinafter also referred to as binder polymer) refers to a polymer having a function as a binder and synthesized by reacting a polyvinyl alcohol obtained by partial or total saponification of polyvinyl acetate with butyl aldehyde under acidic conditions (acetalization reaction) in which at least one hydroxyl group remains. It also includes a polymer containing an acid group or the like introduced by reacting the remaining hydroxyl group with a compound containing the acid group or the like.

A preferred example of the polyvinyl acetal resin in the present invention is a copolymer having a repeat unit containing an acid group. Such acid groups include carboxylic acid group, sulfonic acid group, phosphonic acid group, phosphoric acid group, sulfonamide group and the like, among which carboxylic acid group is especially preferred so that those having a repeat unit derived from (meth) acrylic acid or represented by general formula (I) shown below are preferably used as polyvinyl butyral resins containing at least one hydroxyl group.

For example, polyvinyl butyral resins containing an acid group as shown by (II) below are also preferably used.

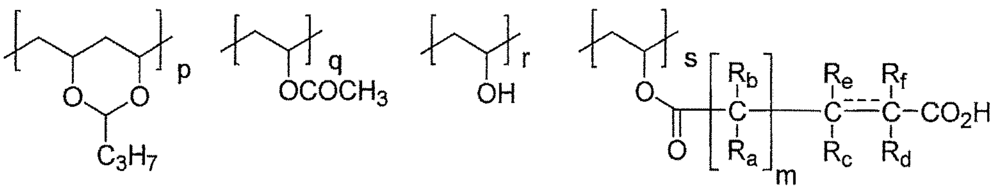
(II)

In general formula (II), the ratio of the repeat units p/q/r/s is preferably in the range of 50 to 78 mol % / 1 to 5 mol % / 5 to 28 mol % / 5 to 20 mol %. $R^a$, $R^b$, $R^c$, $R^d$, $R^e$, and $R^f$ each independently represent an optionally substituted monovalent substituent or a single bond, and m is an integer of 0 to 1.

Preferred substituents for $R^a$, $R^b$, $R^c$, $R^a$, $R^e$, and $R^f$ include a hydrogen atom, an optionally substituted alkyl group, a halogen atom, and an optionally substituted aryl group. More preferably, they include a hydrogen atom; a straight chain alkyl group such as methyl, ethyl, propyl or the like; an alkyl group substituted by a carboxylic acid group; a halogen atom; a phenyl group; and a phenyl group substituted by a carboxylic acid group. $R^c$ and $R^d$ as well as $R^e$ and $R^f$ can form a ring structure. The bond between the carbon atom to which $R^c$ and $R^e$ are attached and the carbon atom to which $R^d$ and $R^f$ are attached is a single bond or a double bond or an aromatic double bond, and in cases of a double bond or an aromatic double bond, $R^c$ - $R^d$ or $R^e$-$R^f$ or $R^c$-$R^f$ or $R^e$-$R^d$ combine to form a single bond.

Specific preferred examples of the units containing a carboxylic acid group described above are shown below.

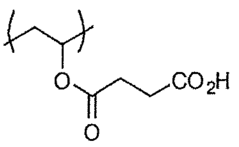
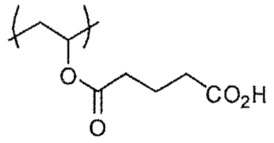
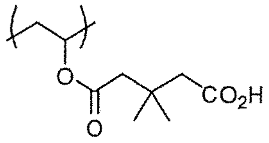

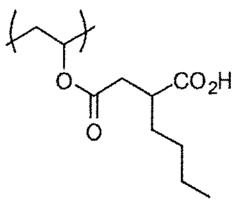
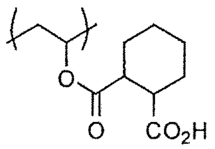
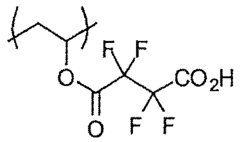
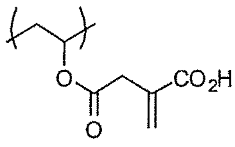

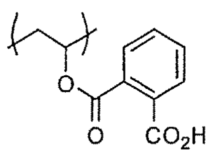
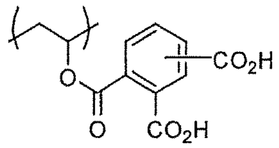
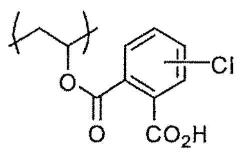

Further, the binder polymer is preferably modified polyvinyl butyral, or polyvinyl butyral modified with trimellitic acid. Further, the binder polymer is more preferably a polyvinyl butyral resin shown below.

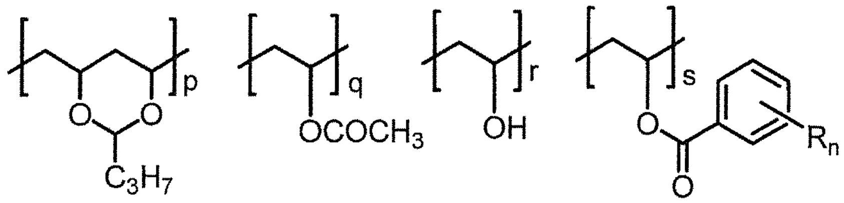

wherein p represents 10 to 90 mol %, q represents 0 to 25 mol %, r represents 1 to 40 mol %, s represents 0 to 25 mol %, and n represents an integer of 0 to 5. R represents a hydrogen atom, -COOH, or -COOR$^1$ wherein R$^1$ represents Na, K, or an alkyl group containing 1 to 8 carbon atoms.

p represents 10 to 90 mol %, preferably 30 to 90 mol %, more preferably 50 to 90 mol %, especially preferably 55 to 85 mol %.

q represents 0 to 25 mol %, preferably 0 to 20 mol %, more preferably 0 to 15 mol %, especially preferably 0 to 10 mol %. r represents 1 to 40 mol %, preferably 1 to 35 mol %, more preferably 5 to 35 mol %, especially preferably 10 to 35 mol %.

s represents 0 to 25 mol %, preferably 0 to 20 mol %, especially preferably 0 to 15 mol %.

Preferred proportions of the individual repeat units p/q/r/s are in the range of 50 to 78 mol % / 1 to 5 mol % / 5 to 28 mol % / 5 to 20 mol %.

R represents a hydrogen atom, -COOH, or -COOR$^1$ wherein R$^1$ represents Na, K, or an alkyl group containing 1 to 8 carbon atoms, preferably a hydrogen atom, -COOH, -COONa.

n represents an integer of 0 to 5, preferably 0 to 2.

Specific preferred examples of the binder polymer are shown below, but it should be understood that the present invention is not limited to these examples.

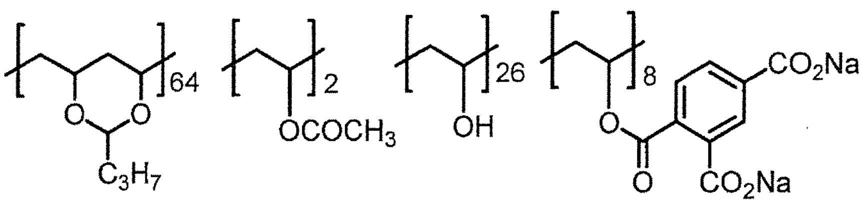

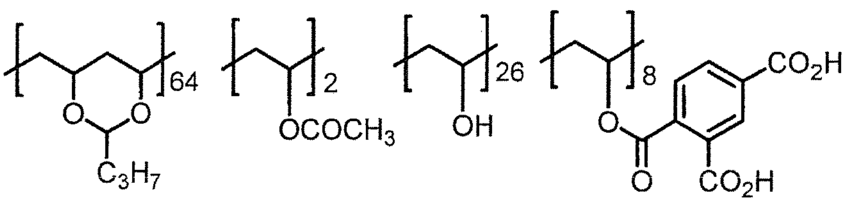

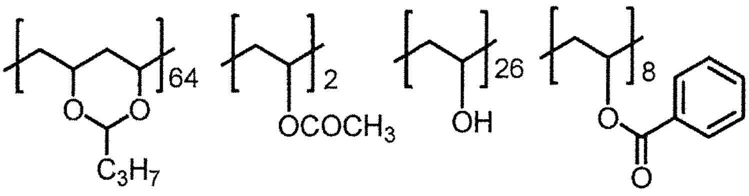

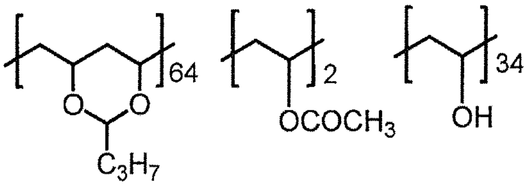

The binder polymer preferably has a weight average molecular weight of 5000 or more, more preferably 10,000 to 300,000, and preferably has a number average molecular weight of 1000 or more, more preferably 2000 to 250,000. Preferably, its polydispersity (weight average molecular weight / number average molecular weight) is 1.1 to 10.

Further, the acid group of acid group-containing polymers included as preferred examples of the binder polymer in the present invention may be neutralized by a basic compound, especially preferably by a basic nitrogen-containing compound such as amino, amidine, guanidine or the like group. Further, the basic nitrogen-containing compound preferably has an ethylenically unsaturated group. Specific compounds include the compounds described in WO 2007/057442.

The binder polymer may be used alone or as a mixture of two or more thereof. Preferably, the content of the binder polymer is 5 to 80 % by weight, more preferably 10 to 60 % by weight, even more preferably 10 to 40 % by weight based on the total solids of the photosensitive layer to achieve good strength and image-forming property in image areas. Further, the total content of the polymerizable compound and the binder polymer is preferably 90 % by weight or less based on the total solids of the photosensitive layer. If it exceeds 90 % by weight, sensitivity may decrease or developability may decrease. More preferably, it is 60 to 90 % by weight.

In the present invention, the penetration of the developer into the photosensitive layer is further improved and therefore developability is further improved by controlling the ratio between the polymerizable compound and the binder polymer in the photosensitive layer of the lithographic printing plate precursors. Thus, the weight ratio between the polymerizable compound and the binder polymer in the photosensitive layer is preferably 1.2 or more, more preferably 1.25 to 4.5, especially preferably 2 to 4.

In the present invention, the proportion of structural units having an ethylenically unsaturated bond in structural units constituting the binder polymer is preferably 1 mol % or less, more preferably substantially zero. As used herein, substantially zero means that, for example, the advantages of the present invention are not influenced.

(D) Crosslinker

The crosslinker capable of reacting with at least one of the hydroxyl group and acid group in the polyvinyl acetal to form a crosslink (D) typically has the function to use the hydroxyl group and/or acid group in the polyvinyl butyral as a reaction point to form a crosslink with another polyvinyl butyral resin, or a second binder polymer, or the polymerizable compound (A) via a chemical bond.

The crosslinker is not specifically limited so far as it has the property of reacting with the hydroxyl group and/or acid group in the polyvinyl butyral, and it may be a small molecule compound or an oligomer or a polymer. Specific reactions include bond formation via dehydration condensation, esterification, transesterification, chelation and the like. Specifically, the compounds described in "Polyvinyl Alcohol, New Revised Edition", by Koji Nagano et al., published by Polymer Publishing Ltd., 1970; "Crosslinker Handbook", edited by Shinzo Yamashita et al., published by Taiseisha Ltd.,

1981 and the like can be used.

More specifically, the following compounds are included:

(1) aldehydes : compounds having an aldehyde group, PVA having an aldehyde at each end, dialdehyde starch;
(2) methylols: compounds having a methylol group (N, N'-dimethylol urea, N,N',N''-methylol melamine), melamine resins;
(3) activated vinyl compounds: compounds having a vinylsulfonic acid group;
(4) epoxies: compounds having an epoxy group, epoxy resins;
(5) carboxylic acids: compounds having a carboxylic acid group, compounds having a carboxylic anhydride (phthalic anhydride, succinic anhydride, maleic anhydride);
(6) isocyanates: compounds having an isocyanate group;
(7) inorganic compounds: borane, boric acid and phosphoric acid compounds, metal alkoxides, especially alkoxides of titanium, zirconium and aluminum, alkoxysilane, silane coupling agents;
(8) phenol resins (novolac type, resol type);
(9) compounds bearing different types of functional groups; or combinations thereof.

The methylols (2) preferably include melamine resins. The melamine resins are not specifically limited, but synthetic resins obtained by co-condensation of triazines and formaldehydes and the like can be used, such as methylolated melamine resins, methylolated melamine-phenol co-condensed resins, methylolated melamine-urea co-condensed resins, methylolated melamine-epoxy co-condensed resins and the like.

Commercially available melamine resins include, for example, NIKALAC MX-270, MX-280, MX-290, MW-30HM, MW-390, MW-100LM, MX-750LM, MS-11, MX-45, MX-410, BL-60, and BX-4000 from SANWA Chemical Co., Ltd.; and U-VAN 20SB, 20SE60, 21R, 22R, 122, 125, 128, 220, 225, 228, 28-60, 2020, 132, 60R, 62, 62E, 360, 165, 166-60, 169 and 2061 including a butylated urea-melamine resin U-VAN 132, and iso-butylated melamine resins U-VAN 60R, 62, 62E, 360, 165, 166-60, 169 and 2061, and a modified melamine resin U-VAN 80S from Mitsui Chemicals, Inc.

The epoxies (4) are preferably epoxy resins. The epoxy resins are not specifically limited so far as they have two or more epoxy groups on average in one molecule. Representative epoxy resins include bisphenol type epoxy resins obtained by glycidylation of bisphenols such as bisphenol A, bisphenol F, bisphenol AD, bisphenol S, tetramethylbisphenol A, tetramethylbisphenol F, tetramethylbisphenol AD, tetramethylbisphenol S, tetrabromobisphenol A and the like; epoxy resins obtained by glycidylation of bivalent phenols such as biphenols, dihydroxynaphthalene, 9,9-bis(4-hydroxyphenyl)fluorene and the like; epoxy resins obtained by glycidylation of trisphenols such as 1,1,1-tris(4-hydroxyphenyl)methane, 4,4-(1-(4-(1-(4-hydroxyphenyl)-1-methylethyl)phenyl)eth ylidene)bisphenol and the like; epoxy resins obtained by glycidylation of tetrakisphenols such as 1,1,2,2-tetrakis(4-hydroxyphenyl)ethane and the like; novolac type epoxy resins obtained by glycidylation of phenol novolac, cresol novolac, bisphenol A novolac, brominated phenol novolac, brominated bisphenol A novolac and the like; aliphatic ether type epoxy resins obtained by glycidylation of polyalcohols such as glycerin, polyethylene glycol and the like; ether ester type epoxy resins obtained by glycidylation of hydroxycarboxylic acids such as p-oxybenzoic acid, β-oxynaphthoic acid and the like; ester type epoxy resins obtained by glycidylation of polycarboxylic acids such as phthalic acid, and terephthalic acid; amine type epoxy resins such as glycidylated products of amine compounds such as 4,4-diaminodiphenylmethane and m-aminophenol or triglycidyl isocyanurate and the like; alicyclic epoxides such as 3,4-epoxycyclohexylmethyl-3',4'-epoxycyclohexane carboxylate and the like; and these may be used alone or as a mixture of two or more of them.

The inorganic compounds (7) preferably include metal alkoxides, silane coupling agents, boron, and phosphoric acid compounds. The metal alkoxides include, for example, tetraisopropyl titanate, tetra-n-butyl titanate, tetrakis(2-ethylhexoxy) titanate, tetrastearoyl titanate, tetraoctylene glycol titanium, dihydroxybis(lactato)titanium, titanium lactate ammonium salt, dipropoxybis(acetylacetonato)titanium, titanium octylene glycolate, titanium ethyl acetoacetate, dipropoxytitanium bis(lactate), titanium triethanolaminate, butyl titanate dimer, isopropyl tristearoyltitanate, isopropyl tridodecyl benzenesulfonyl titanate, aluminum triisopropylate, aluminum sec-butylate, aluminum acetylacetonate, aluminum oxide isopropylate, aluminum trisacetylacetonate, zirconium trichloride, zirconium n-tetrapropylate, zirconium n-tetrabutylate and the like.

The silane coupling agents, boron, and phosphoric acid compounds include, for example, tetramethoxysilane, vinyltrimethoxysilane, γ-glycidoxypropyltrimethoxysilane, β-(3,4-epoxycyclohexyl)ethyltrimethoxysilane, borane, triethylamine-chloroborane, triethylenediamine-bischloroborane, boric acid, phosphoric acid, ethyl phosphite, pyrophosphoric acid, bisphenol A-modified polyphosphoric acid, triphenyl phosphite and the like.

The phenol resins (8) include phenols such as phenol, cresol and the like; or novolac type phenol resins obtained by reacting a mixture of a phenol modified with molasses, lignin, xylene, naphthalene or a petroleum aromatic hydrocarbon and formaldehyde or paraformaldehyde in an appropriate molar ratio in the presence of a catalyst; resol type phenol resins; combinations of a novolac type phenol resin and a resol type phenol resin and the like; and these can be used alone or as a mixture of two or more of them.

Among these crosslinkers, more preferred are compounds having an aldehyde group, compounds having a hydroxy group or methylol group, phenol resins (novolac type and resol type), melamine resins, compounds having two or more epoxy groups, epoxy resins, compounds having two or more carboxylic acids, compounds having a carboxylic anhydride, phosphoric acid, phosphoric acid ester compounds, and metal alkoxides, among which especially preferred are compounds having two or more epoxy groups, N,N'-dimethylolurea, N,N',N"-methylolmelamine, phenol resins (novolac type and resol type), melamine resins, epoxy resins, compounds having a carboxylic anhydride, and most preferred are phenol resins (novolac type), melamine resins, epoxy resins, and compounds having a carboxylic anhydride.

Specific examples of crosslinkers are shown below, but it should be understood that the crosslinkers are not limited to these specific examples.

Aldehydes

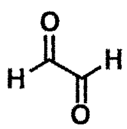

D-101

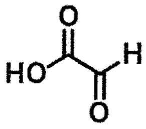

D-102

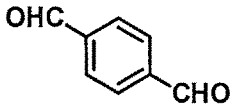

D-103

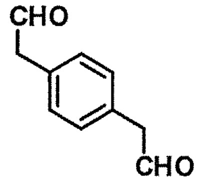

D-104

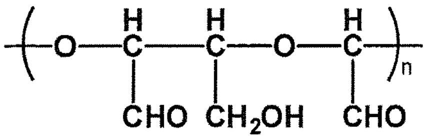

D-105 n=20
D-106 n=50
D-107 n=100

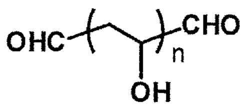

D-108 n=50
D-109 n=150
D-110 n=300

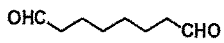

D-111

Mmethylols

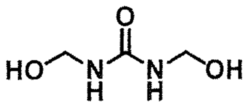

D-201

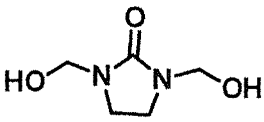

D-202

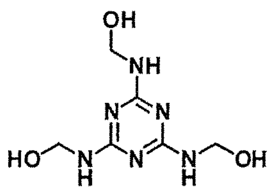

D-203

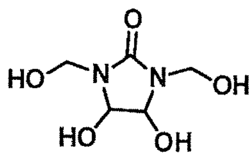

D-204

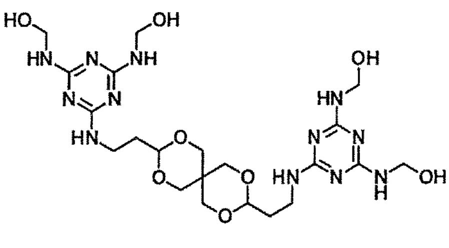

D-205

Activated vinyl compounds

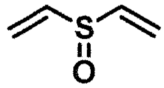

D-301

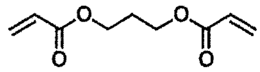

D-302

Epoxies:

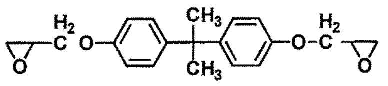

D-401

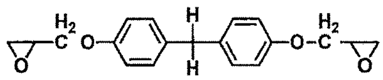

D-402

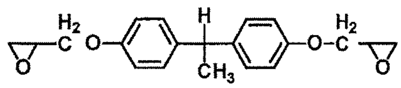

D-403

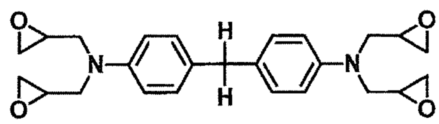

D-404

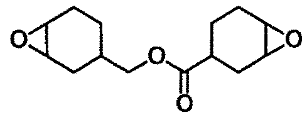

D-405

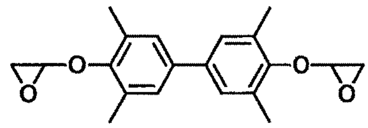

D-406

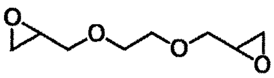

D-407

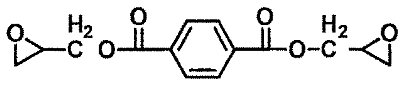

D-408

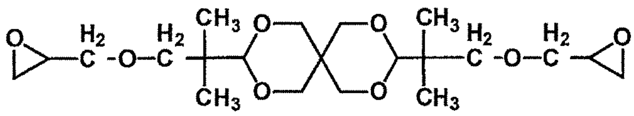

D-409

Carboxylic acids

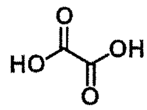
D-501

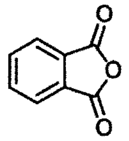
D-502

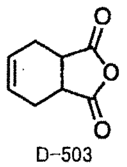
D-503

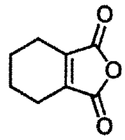
D-504

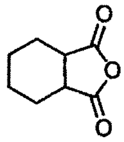
D-505

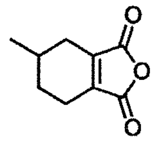
D-506

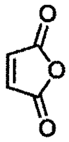
D-507

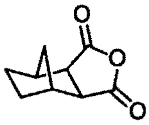
D-508

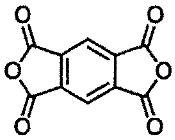
D-509

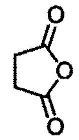
D-510

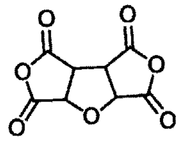
D-511

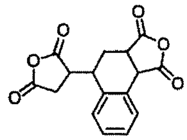
D-512

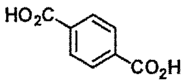
D-513

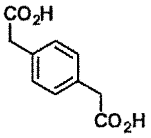
D-514

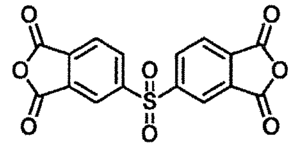
D-515

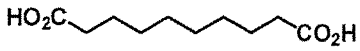
D-516

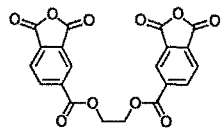
D-517

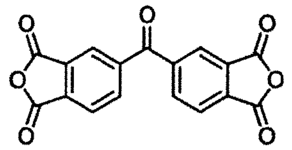
D-518

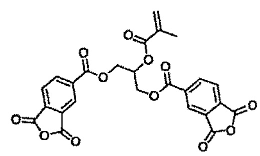
D-519

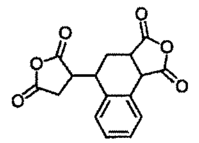
D-520

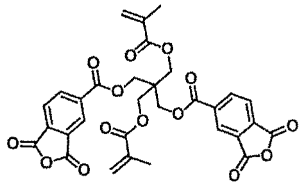
D-521

Compounds bearing different types of functional groups

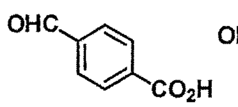
D-601

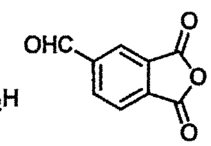
D-602

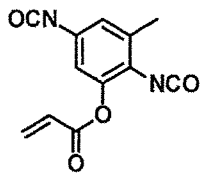
D-603

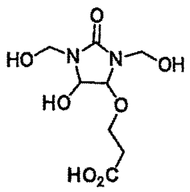
D-604

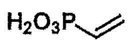
D-605

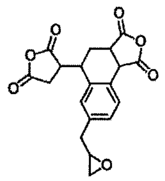
D-606

Thus, the proportion of compounds containing a polymerizable group having an ethylenically unsaturated bond in the crosslinker in the present invention is preferably 1 mol % or less, more preferably substantially zero. Without wishing to be bound by theory, this may be explained as follows. Compounds containing a polymerizable group are crosslinked with monomers. Crosslinking with monomers enhances film strength and improves printing durability, but slows down changes in the structure of the polymer blend so that developability, chemical resistance and scratch resistance are not improved. It should be noted that substantially zero means that, for example, the advantages of the present invention are not influenced.

Preferably, the crosslinker has a molecular weight of 5000 or more, more preferably 10,000 to 300,000 taking into account a balance with developability in unexposed (non-cured) areas and the fact that the crosslinker acts to change the structure of the crosslinked polymer blend more effectively. In cases of polymers, the molecular weight refers to weight average molecular weight. Two or more crosslinkers may be used in combination.

Preferably, the amount of the crosslinker to be added is 70 % by weight or less, more preferably 50 % by weight or less, most preferably 25 % by weight or less relative to the amount of the acetal resin added. It is not preferable to

add an excessive amount of the crosslinker, because the intrinsic polymer characteristics of the polyvinyl butyral and the acrylic resin would be annulled.

(E) (Meth)acrylic resin

In addition to the polyvinyl acetal resin (C), the photosensitive layer of the present invention comprises a (meth) acrylic resin (second binder polymer) functioning as a binder. A suitable second binder polymer is the one that allows photosensitive layer components to be carried on a support and that can be removed by a developer.
Alternatively, the second binder polymer may function as the crosslinker (D).

A preferred example of the second binder polymer in the present invention is a copolymer having a repeat unit containing an acid group. Acid groups that are preferably used include carboxylic acid group, sulfonic acid group, phosphonic acid group, phosphoric acid group, sulfonamide group and the like, among which carboxylic acid group is especially preferred so that those having a repeat unit derived from (meth)acrylic acid or represented by general formula (I) shown below are preferably used.

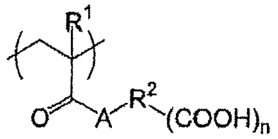

(I)

In the formula (I), $R^1$ represents a hydrogen atom or methyl group, $R^2$ represents a single bond or n+1 monovalent linking groups. $A^1$ represents an oxygen atom or $-NR^3-$, and $R^3$ represents a hydrogen atom or $C_{1-10}$ monovalent hydrocarbon group. $n_1$ represents an integer from 1 to 5.

The linking group represented by $R^2$ in the formula (I) is composed of hydrogen atom, carbon atom, oxygen atom, nitrogen atom, sulfur atom and halogen atom, with a total number of atoms of preferably 1 to 80. More specifically, the alkylene group, substituted alkylene group, arylene group, and substituted arylene group are exemplified. A plurality of these divalent groups may be linked with any of amide bond and ester bond. $R^2$ preferably has a structure in which a plurality of single bonds, alkylene groups and substituted alkylene groups; more preferably has a structure in which a plurality of single bonds, $C_{1-5}$ alkylene groups and $C_{1-5}$ substituted alkylene groups; and particularly has a structure in which a plurality of single bonds, $C_{1-3}$ alkylene group and $C_{1-3}$ substituted alkylene group.

The substituent group includes group of monovalent non-metallic atoms excluding hydrogen atom, wherein examples of which include halogen atom (-F, -Br, -Cl, -I), hydroxy group, alkoxy group, aryloxy group, mercapto group, alkylthio group, arylthio group, alkylcarbonyl group, arylcarbonyl group, carboxyl group and its conjugate base group, alkoxy carbonyl group, aryloxy carbonyl group, carbamoyl group, aryl group, alkenyl group, and alkynyl group.

$R^3$ is preferably a hydrogen atom or $C_{1-5}$ hydrocarbon group, more preferably a hydrogen atom or $C_{1-3}$ hydrocarbon group, and particularly a hydrogen atom or methyl group.

n is preferably 1 to 3, more preferably 1 or 2, and particularly 1.

Preferably, the proportion (mol %) of copolymer components containing a carboxylic acid group in all of the copolymer components of the second binder polymer is 1 to 70 mol %, more preferably 1 to 60 mol %, even more preferably 1 to 50 mol % to improve developability. More preferably, it is 5 to 30 mol %, especially preferably 5 to 25 mol % to improve developability and printing durability simultaneously.

It is preferable for the second binder polymer used in the present invention to additionally have a crosslinkable group. The crosslinkable group herein means a group capable of crosslinking the binder polymer, in the process of radical polymerization reaction which proceeds in the photosensitive layer, when the lithographic printing plate precursor is exposed to light. While the functional group is not specifically limited so long as it can exhibit the above-described function, examples of the functional group capable of proceeding addition polymerization reaction include ethylenic unsaturated binding group, amino group, and epoxy group. The functional group may also be a functional group capable of producing a radical upon being exposed to light, and this sort of crosslinkable group is exemplified by thiol group and halogen group. Among them, ethylenic unsaturated binding group is preferable. The ethylenic unsaturated binding group is preferably styryl group, (meth)acryloyl group, or allyl group.

The second binder polymer cures in such a way that a free radical (polymerization initiating radical, or propagating radical in the process of polymerization of radical or polymerizable compound) attaches to the crosslinkable functional group, and crosslinkage is formed among the polymer molecules thereof, by addition polymerization which proceeds directly among the polymer molecules or by sequential polymerization of the polymerizable compounds. Alternatively, the binder cures in such a way that atoms (for example, hydrogen atoms on carbon atoms adjacent to the functional crosslinking groups) in the polymer are abstracted by free radicals to produce polymer radicals, and the resultant polymer radicals then combine with each other to produce the crosslinkages among the polymer molecules.

The content of the crosslinkable group in the second binder polymer (content of radical polymerizable unsaturated double bond determined by iodometry) is preferably 0.01 to 10.0 mmol per one gram of the binder polymer, more preferably 0.05 to 5.0 mmol, and particularly 0.1 to 2.0 mmol.

Besides the above-described repeating unit having an acid group, and the polymerization unit having a crosslinkable group, the second binder polymer used in the present invention may have a polymerization unit of alkyl (meth) acrylate or aralkyl (meth) acrylate. The alkyl group of alkyl (meth)acrylate is preferably a $C_{1-5}$ alkyl group, and more preferably methyl group. The aralkyl (meth)acrylate is exemplified by benzyl (meth)acrylate.

Preferably, the second binder polymer has a weight average molecular weight of 5000 or more, more preferably 10,000 to 300,000, and a number average molecular weight of 1000 or more, more preferably 2000 to 250,000. Preferably, its polydispersity (weight average molecular weight / number average molecular weight) is 1.1 to 10.

The acrylic resins may be used alone or as a mixture of two or more of them. Preferably, the content of the binder polymers is 5 to 75 % by mass, more preferably 10 to 70 % by mass, even more preferably 10 to 60 % by mass based on the total solids of the photosensitive layer to achieve good strength and image-forming property in image areas.

The second binder polymer may be used alone or may be used as a mixture of two or more thereof. The content of the second binder polymer is preferably 1 to 30 % by weight, more preferably 1 to 20 % by weight, even more preferably 1 to 15 % by weight, still more preferably 1 to 12 % by weight, especially preferably 1 to 10 % by weight based on the total solids of the photosensitive layer to achieve good strength and image-forming property in image areas.

In the present invention, the penetration of the developer into the photosensitive layer is further improved and therefore developability is further improved by controlling the proportion of the polymerizable compound and the second binder polymer in the photosensitive layer of the lithographic printing plate precursors. Thus, the weight ratio between the radical polymerizable compound and the second binder polymer in the photosensitive layer is preferably 1.2 or more, more preferably 1.25 to 4.5, most preferably 2 to 4.

In the present invention, the polyvinyl acetal resin containing at least one hydroxyl group (C) is preferably present in an amount of 50 to 95 % by weight, more preferably 60 to 95 % by weight, especially preferably 65 to 95 % by weight relative to the total amount of the polyvinyl acetal resin containing at least one hydroxyl group (C) and the second binder polymer.

<Sensitizing dye>

Preferably, the photosensitive layer in the present invention comprises a sensitizing dye. Any sensitizing dye can be used without specific limitation so far as it is excited upon light absorption during imagewise exposure to impart energy to the polymerization initiator described later herein via electron transfer, energy transfer or heat generation or the like, thereby improving the polymerization-initiating function. Especially, sensitizing dyes having a maximum absorption between 300 and 450 nm or between 750 and 1400 nm are preferably used.

The sensitizing dyes showing maximum absorption in the wavelength range from 350 to 450 nm include merocyanines, benzopyranes, coumarines, aromatic ketones, anthracenes.

Among the sensitizing dyes showing maximum absorption in the wavelength range from 350 to 450 nm, preferable dyes are those represented by the formula (IX), from the viewpoint of large sensitivity.

Formula (IX)

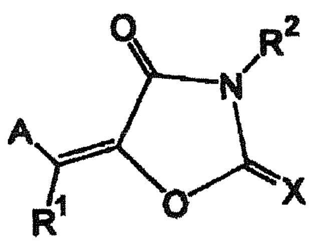

(IX)

In the formula (IX), A represents an aryl group or heteroaryl group which may have a substituent group, and X represents an oxygen atom, sulfur atom or $=N(R^3)$. Each of $R^1$, $R^2$ and $R^3$ independently represents a monovalent group of non-metallic atom, wherein A and $R^1$, or $R^2$ and $R^3$, may combine respectively to form an aliphatic or aromatic ring.

The formula (IX) will now be further detailed. The monovalent group of non-metallic atom represented by $R^1$, $R^2$ or $R^3$ is preferably substituted or unsubstituted alkyl group, substituted or unsubstituted alkenyl group, substituted or unsubstituted aryl group, substituted or unsubstituted heteroaryl group, substituted or unsubstituted alkoxy group, substituted or unsubstituted alkylthio group, hydroxy group, and halogen atom.

Next, A in general formula (IX) is explained. A represents an optionally substituted aromatic cyclic group or

heterocyclic group, and specific examples of optionally substituted aromatic rings or heterocycles include those similar to the examples mentioned for $R^1$, $R^2$ and $R^3$ in general formula (IX).

Specific examples of such sensitizing dyes that are preferably used include the compounds described in paragraphs [0047] to [0053] of JP-A2007-58170.

Further, sensitizing dyes represented by general formula (V) to (VI) shown below can also be used.

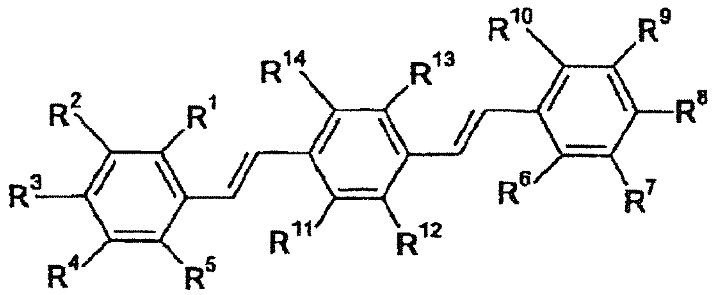

(V)

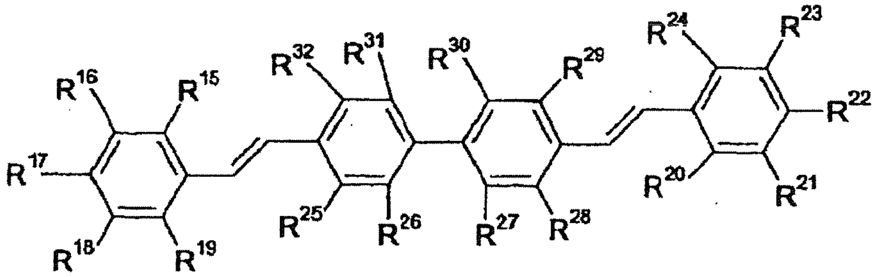

(VI)

In formula (V), $R^1$ to $R^{14}$ each independently represent a hydrogen atom, an alkyl group, an alkoxy group, a cyano group or a halogen atom, provided that at least one of $R^1$ to $R^{10}$ represents an alkoxy group containing two or more carbon atoms.

In formula (VI), $R^{15}$ to $R^{32}$ each independently represent a hydrogen atom, an alkyl group, an alkoxy group, a cyano group or a halogen atom, provided that at least one of $R^{15}$ to $R^{24}$ represents an alkoxy group containing two or more carbon atoms.

Specific examples of such sensitizing dyes that are preferably used include the compounds described in EP-A-1 349 006 and WO 2005/029187.

Further, the sensitizing dyes described in JP-A2007-171406, JP-A2007-206216, JP-A2007-206217, JP-A2007-225701, JP-A2007-225702, JP-A2007-316582, and JP-A2007-328243 can also be preferably used.

Next, sensitizing dyes having a maximum absorption between 750 and 1400 nm (hereinafter sometimes referred to as "infrared absorbers") that are preferably used in the present invention are explained in detail. Infrared absorbers that are preferably used include dyes or pigments.

Dyes include, for example, cyanine dyes, squarylium dyes, pyrylium salts, nickel thiolate complexes, and indolenine cyanine dyes. More preferred are cyanine dyes and indolenine cyanine dyes, and especially preferred examples include cyanine dyes represented by general formula (a) below. Specific examples of dyes include those described in JP-A2009-516602 and GB 2 192 792.

Formula (a)

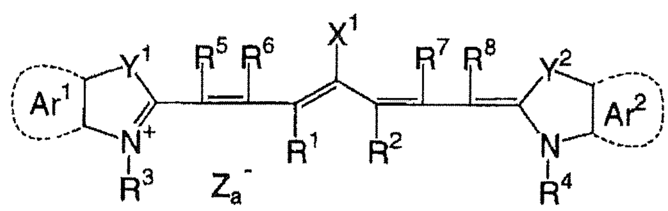

In the formula (a), $X^1$ represents a hydrogen atom, halogen atom, $-NPh_2$, $-X^2-L^1$ or the group shown below. In the formula, $X^2$ represents an oxygen atom, nitrogen atom or sulfur atom, and $L^1$ represents a $C_{1-12}$ hydrocarbon group, aryl group having a hetero atom (N, S, O, halogen, Se), and $C_{1-12}$ hydrocarbon group having a hetero atom. $X_a^-$ is

synonymous with $Z_a^-$ described later. $R^a$ represents a substituent group selected from hydrogen atom or alkyl group, aryl group, substituted or unsubstituted amino group, and halogen atom.

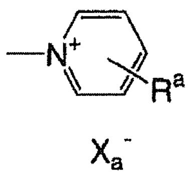

Each of $R^1$ and $R^2$ independently represents $C_{1-12}$ hydrocarbon group. From the viewpoint of stability of coating liquid for forming the photo sensitive layer, each of $R^1$ and $R^2$ is preferably a $C_2$ or longer hydrocarbon group. $R^1$ and $R^2$ may combine with each other to form a ring which is preferably a five-membered ring or six-membered ring.

$Ar^1$ and $Ar^2$ may be same or different, and each represents an aryl group which may have a substituent group. Preferable examples of the aryl group include benzene ring group and naphthalene ring group. Preferable examples of the substituent group include $C_{12}$ or shorter hydrocarbon group, halogen atom, and $C_{12}$ or shorter alkoxy group. $Y^1$ and $Y^2$ may be same or different, and each represents a sulfur atom or $C_{12}$ or shorter dialkylmethylene group. $R^3$ and $R^4$ may be same or different, and each represents a $C_{20}$ or shorter hydrocarbon group which may have a substituent group. Preferable examples of the substituent group include a $C_{12}$ or shorter alkoxy group, carboxyl group, and sulfo group. $R^5$, $R^6$, $R^7$ and $R^8$ may be same or different, and each represents a hydrogen atom or $C_{12}$ or shorter hydrocarbon group. From the viewpoint of availability of the source materials, hydrogen atom is preferable. $Z_a^-$ represents a counter anion. Note that $Z_a^-$ is not necessary if the cyanine colorant represented by the formula (a) has an anionic substituent group in the structure thereof, and is omissible if there is no need of neutralization of electric charge. Preferable examples of $Z_a^-$ include halide ion, perchlorate ion, tetrafluoroborate ion, hexafluorophosphate ion and sulfonate ion from the viewpoint of storage stability of coating liquid for forming the photo sensitive layer. Particularly preferable examples include perchlorate ion, hexafluorophosphate ion and aryl sulfonate ion. Especially preferred are those not containing a halogen ion as a counter ion.

Specific examples of cyanine dyes represented by general formula (a) that can be preferably used include those described in paragraphs [0017] to [0019] of JP-A2001-133969.

Further, other especially preferred examples include the specific indolenine cyanine dyes described in JP-A2002-278057, supra.

Pigments that can be used include commercially available pigments and the pigments described in Colour Index International (C.I.) database, "Latest Pigment Handbook" (edited by Japan Association of Pigment Technology, published in 1977), "Latest Pigment Applied Technology" (CMC Publishing Co., Ltd., published in 1986), and "Printing Ink Technology" (CMC Publishing Co., Ltd., published in 1984).

The preferred amount of these sensitizing dyes to be added is preferably in the range of 0.05 to 30 parts by weight, more preferably 0.1 to 20 parts by weight, most preferably 0.2 to 10 parts by weight per 100 parts by weight of the total solids in the photosensitive layer.

<Colorant>

The photosensitive layer in the present invention may also comprise a colorant. The colorant can be a dye or a pigment. Colorants that can be used include, but not limited to, the colorants described in JP-A2009-516222 and WO 2007/057348.

Pigments used as colorants include, for example, organic pigments, inorganic pigments, carbon black, metallic powder pigments, fluorescent pigments and the like, preferably organic pigments.

Specific examples of organic pigments include quinacridone pigments, quinacridone quinone pigments, dioxazine pigments, phthalocyanine pigments, anthrapyrimidine pigments, anthanthrone pigments, indanthrone pigments, flavanthrone pigments, perylene pigments, diketopyrrolopyrrole pigments, perinone pigments, quinophthalone pigments, anthraquinone pigments, thioindigo pigments, benzimidazolone pigments, isoindolinone pigments, azomethine pigments, and azo pigments, etc.

Specific examples of pigments usable as colorants include those described in JP-A2009-516222 and JP-A2010-139551.

In the present invention, blue colored pigments including cyan pigments are preferably used.

The pigments may be subjected to surface treatment of the pigment particles. Methods for surface treatment include methods of applying a surface coat of resin, methods of applying surfactant, and methods of bonding a reactive material (for example, a silane coupling agent, an epoxy compound, polyisocyanate, or the like) to the surface of the pigment and the like. Specific examples of surface-treated pigments are the modified pigments described in WO 02/04210,

and specifically the blue colored modified pigments described in WO 02/04210 are preferably used.

The pigments have a particle size which is preferably less than 10 μm, more preferably less than 5 μm, and especially preferably less than 3 μm. The method for dispersing the pigments may be any known dispersion method which is used for the production of ink or toner or the like. Dispersing machines include an ultrasonic disperser, a sand mill, an attritor, a pearl mill, a super mill, a ball mill, an impeller, a dispenser, a KD mill, a colloid mill, a dynatron, a three-roll mill and a press kneader and the like. Details are described in "Latest Pigment Applied Technology" (CMC Publications, published in 1986).

So-called self-dispersing pigments can also be used as pigments. Specific examples of self-dispersing pigments include those described in WO 02/04210.

The amount of the pigments to be used is preferably in the range of 0.005 $g/m^2$ to 2 $g/m^2$, more preferably 0.007 $g/m^2$ to 0.5 $g/m^2$, even more preferably 0.01 $g/m^2$ to 0.2 $g/m^2$, especially preferably 0.01 $g/m^2$ to 0.1 $g/m^2$.

The colorant can also be a dye. Dyes include known dyes such as commercially available dyes or the dyes described in "Dye Handbook" (edited by the Organic Synthetic Chemistry Association, published in 1970). Specific examples of dyes include, for example, azo dyes, metal complex salt azo dyes, pyrazolone azo dyes, anthraquinone dyes, phthalocyanine dyes, carbionium dyes, quinonimine dyes, methine dyes, and the like. Phthalocyanine dyes are preferred. These dyes are salt-forming organic dyes, and may be oil-soluble dyes and basic dyes.

Specific examples of dyes include those described in the specification of GB 2 192 729.

The amount of the dyes to be used is preferably in the range of 0.005 $g/m^2$ to 2 $g/m^2$, more preferably 0.007 $g/m^2$ to 0.5 $g/m^2$, even more preferably 0.01 $g/m^2$ to 0.2 $g/m^2$, especially preferably 0.01 $g/m^2$ to 0.1 $g/m^2$.

Low-Molecular-Weight Hydrophilic Compound

The photo sensitive layer may contain a low-molecular-weight hydrophilic compound, for the purpose of improving the on-press developability without degrading the printing durability.

Examples of the low-molecular-weight hydrophilic compound, categorized as water-soluble organic compound, include glycols such as ethylene glycol, diethylene glycol, triethylene glycol, propylene glycol, dipropylene glycol, and tripropylene glycol, and ether or ester derivatives thereof; polyols such as glycerin, pentaerythritol, and tris(2-hydroxyethyl) isocyanurate; organic amines such as triethanolamine, diethanolamine, and monoethanolamine, and salts thereof; organic sulfonic acids such as alkyl sulfonic acid, toluenesulfonic acid, and benzenesulfonic acid, and salts thereof; organic sulfamic acids such as alkyl sulfamic acid, and salt thereof; organic sulfuric acids such as alkyl sulfuric acid, alkyl ether sulfuric acid, and salts thereof; organic phosphonic acids such as phenylphosphonic acid, and salt thereof; organic carboxylic acids such as tartaric acid, oxalic acid, citric acid, malic acid, lactic acid, gluconic acid, and amino acid, and salts thereof; and betaines.

Among them, at least one selected from polyols, organic sulfuric acid salts, organic sulfonic acid salts, and betaines is preferably contained in the present invention.

Specific examples of the organic sulfonic acid salts include those described in paragraphs [0026] to [0031] of JP-A2007-276454, paragraphs [0020] to [0047] of JP-A2009-154525 and the like.

Specific examples of the organic sulfuric acid salts include those described in paragraphs [0034] to [0038] of JP-A2007-276454.

The betaines are preferably compounds bearing a hydrocarbon substituent containing 1 to 5 carbon atoms on the nitrogen atom, and specific examples include trimethylammonium acetate, dimethylpropylammonium acetate, 3-hydroxy-4-trimethyl-ammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-propanesulfonate, 3-(1-pyridinio)-1-propanesulfonate and the like.

The hydrophilic low molecular weight compounds have a small hydrophobic moiety so that they have little surface active effect, whereby the dampening water cannot penetrate into exposed areas (image areas) of the photosensitive layer and affect hydrophobicity and film strength in the image areas and the photosensitive layer can retain good ink receptivity and printing durability.

The content of the low-molecular-weight hydrophilic compound in the photo sensitive layer is preferably 0.5 to 20% by mass of the total solid content of the photo sensitive layer, more preferably 1 to 15% by mass, and more preferably 2 to 10% by mass. In this range, desirable levels of on-press developability and printing durability are obtained. The low-molecular-weight hydrophilic compound may be used alone, or in combination of two or more species.

(H)Sensitizer

The image recording layer may contain a sensitizer such as phosphonium compound, nitrogen-containing low-molecular-weight compound, and ammonium group-containing polymer, aiming at improving inking performance. In particular, for the case where the protective layer contains an inorganic layered compound, the sensitizer functions as

a surface coating agent of the inorganic layered compound, and prevent the inking performance from degrading in the process of printing, due to the inorganic layered compound.

Preferable examples of the phosphonium compound include those described in Japanese Laid-Open Patent Publication Nos. 2006-297907 and 2007-50660. Specific examples thereof include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate, and 1,9-bis(triphenylphosphonio)nonanenaphthalene -2,7-disulfonate.

The nitrogen-containing low-molecular-weight compound is exemplified by amine salts, and quaternary ammonium salts. Other examples include imidazolinium salts, benzoimidazolinium salts, pyrydinium salts, and quinolinium salts. Among them, quaternary ammonium salts and pyrydinium salts are preferable. Specific examples include tetramethylammonium hexafluorophosphate, tetrabutylammonium hexafluorophosphate, dodecyltrimethylammonium *p*-toluenesulfonate, benzyl triethylammonium hexafluorophosphate, benzyl dimethyloctylammonium hexafluorophosphate, benzyl dimethyldodecylammonium hexafluorophosphate, the compounds described in paragraphs [0021] to [0037] of Japanese Laid-Open Patent Publication No. 2008-284858, and the compounds described in paragraphs [0030] to [0057] of Japanese Laid-Open Patent Publication No. 2009-90645.

While the ammonium group-containing polymer may be arbitrarily selected so long as it has an ammonium group in the structure thereof, a preferable polymer contains, as a copolymerizable component, 5 to 80 mol% of (meth)acrylate having an ammonium group in the side chain thereof. Specific examples include the polymers described in paragraphs [0089] to [0105] of Japanese Laid-Open Patent Publication No. 2009-208458.

The ammonium salt-containing polymer preferably has a reduced specific viscosity (in ml/g), measured by the method of measurement described below, of 5 to 120, more preferably 10 to 110, and particularly 15 to 100. Mass average molecular weight, converted from the reduced specific viscosity, is preferably 10,000 to 150,000, more preferably 17,000 to 140,000, and particularly 20,000 to 130,000.

«Method of Measuring Reduced Specific Viscosity»

In a 20-ml measuring flask, 3.33 g (1 g as solid content) of a 30% polymer solution is weighed, and the flask is filled up with N-methylpyrrolidone. The obtained solution is allowed to stand in a thermostat chamber at 30°C for 30 minutes, and then placed in a Ubbelohde reduced viscosity tube (viscometer constant=0.010 cSt/s), and the time it takes for the solution to elute at 30 °C is measured. The measurement is repeated twice using the same sample, to thereby find an average value. The blank (N-methylpyrrolidone only) is also measured similarly, and the reduced specific viscosity (ml/g) is calculated by the formula below.

$$\text{Reduced specific viscosity (ml/g)} = \frac{\dfrac{\text{Elution time of sample solution (sec)} - \text{Elution time of blank (sec)}}{\text{Elution time of blank (sec)}}}{\dfrac{3.33\ (\text{g}) \times \frac{30}{100}}{20\ (\text{ml})}}$$

Specific examples of ammonium group-containing polymers that can be employed include those described in paragraph 0177 of JP-A2011-251431.

The content of the sensitizer is preferably 0.01 to 30.0% by mass of the total solid content of the photo sensitive layer, more preferably 0.01 to 15.0% by mass, and still more preferably 1 to 5% by mass.

(I)Hydrophobization Precursor

The image recording layer may contain a hydrophobization precursor, for the purpose of improving the on-press developability. The hydrophobization precursor means a fine particle capable of turning, upon heating, the image recording layer into hydrophobic. The fine particle is preferably at least one species selected from hydrophobic thermoplastic polymer particle, thermoreactive polymer particle, polymer particle having polymerizable group, and microcapsule and microgel (crosslinked polymer particle) containing hydrophobic compound. Among them, polymer particle and microgel having polymerizable group are preferable.

Preferable examples of the hydrophobic thermoplastic polymer particle include those described in Research Disclosure No.333003 published in January 1992, Japanese Laid-Open Patent Publication Nos. H09-123387, H09-131850, H09-171249, H09-171250 and European Patent No. 931647.

Specific examples of polymer composing the polymer particle include ethylene, styrene, vinyl chloride, methyl acrylate, ethyl acrylate, methyl methacrylate, ethyl methacrylate, vinylidene chloride, acrylonitrile, vinylcarbazole, acrylate or methacrylate having a polyalkylene structure, all of which being available in the form of monomer, homopolymer, copolymer and mixture. Among them, more preferable examples include polystyrene, copolymer containing styrene and acrylonitrile, and methyl polymethacrylate.

Average particle size of the hydrophobic thermoplastic polymer particle used in the present invention is preferably 0.01 to 2.0 μm.

The thermoreactive polymer particle used in the present invention is exemplified by polymer particle having a thermoreactive group which forms a hydrophobic domain as a result of crosslinking by thermal reaction and concomitant change in the functional group.

While the thermoreactive group contained in the polymer particle used in the present invention may be arbitrarily selected from those capable of proceeding any type of reaction so long as it can form a chemical bond, it is preferably a polymerizable group. The preferable examples include ethylenic unsaturated group which undergoes radical polymerization reaction (acryloyl group, methacryloyl group, vinyl group, allyl group, etc.); cation polymerizable group (vinyl group, vinyloxy group, epoxy group, oxetanyl group, etc.); isocyanate group or block thereof which undergoes addition reaction; epoxy group, vinyloxy group and functional group containing an activated hydrogen atom reactive with them (amino group, hydroxy group, carboxyl group, etc.); carboxyl group which undergoes condensation reaction, and functional group capable of reacting therewith and having a hydroxy group or amino group; and acid anhydride which undergoes ring-opening addition reaction, and amino group or hydroxy group allow to react therewith.

The microcapsule used in the present invention contains all of, or a part of, the constituents of the photo sensitive layer, typically as described in Japanese Laid-Open Patent Publication Nos. 2001-277740 and 2001-277742. The constituents of the image recording layer may also be contained outside the microcapsule. Still alternatively, the photo sensitive layer containing microcapsule may be configured so as to contain the hydrophobic constituents encapsulated in the microcapsule, and hydrophilic constituents outside the microcapsule.

The microgel used in the present invention may contain at least either therein or on the surface thereof, a part of constituents of the photo sensitive layer. In particular, an embodiment of reactive microgel, configured by attaching the radical-polymerizable group onto the surface thereof, is preferable from the viewpoint of image-forming sensitivity and printing durability.

Encapsulation of the constituents of the photo sensitive layer into the microcapsule or microgel is arbitrarily selectable from those known in the art.

Average particle size of the microcapsule or microgel is preferably 0.01 to 3.0 μm, more preferably 0.05 to 2.0 μm, and particularly 0.10 to 1.0 μm. Satisfactory levels of resolution and long-term stability may be ensured in the above-described ranges.

The content of the hydrophobization precursor is preferably 5 to 90% by mass relative to the total solid content of the photo sensitive layer.

<Other Components of Photo Sensitive Layer >

The photo sensitive layer preferably contains chain transfer agent. The chain transfer agent adoptable herein includes compound having SH, PH, SiH or GeH in the molecule thereof. These groups may produce a radical by donating a hydrogen to a low-active radical species, or, may produce a radical after being oxidized, followed by deprotonation. It is particularly preferable for the photo sensitive layer to contain a thiol compound (2-mercapto benzimidazoles, 2-mercapto benzthiazoles, 2-mercapto benzoxazoles, 3-mercapto triazoles, 5-mercapto tetrazoles, etc.). The photosensitive layer of the present invention can further comprise various additives, as appropriate. Additives that can be used include, for example, the compounds described in [0161] to [0215] of JP-A2007-206217. Printing-out agents and surfactants that can be used in the present invention are explained below.

<Printing-out agent>

In the present invention, the photosensitive layer may comprise a printing-out agent. The printing-out agent may be, but not limited to, a compound as described in EP-A-1 491 356, paragraphs [0116] to [0119] on pages 19 and 20, US 2005/8971, paragraphs [0168] to [0172] on page 17, JP-A2009-516222 and WO 2007/057348. Preferred printing-out agents are the compounds described in the unpublished PCT application PCT/EP 2005/053141 filed July 1, 2005, from line 1, page 9 to line 27, page 20. More preferred are the IR-dyes as described in the unpublished Patent Application EP 05 105 440.1 filed June 21, 2005, from line 32, page 5 to line 9, page 32.

<Surfactant>

In the present invention, surfactants may be contained to enhance developability and to improve the coated surface appearance. Both polymeric and small molecule surfactants can be used as the surfactants, and nonionic surfactants are preferred. Nonionic surfactants include polymers and oligomers containing one or more polyether (such as polyethylene glycol, polypropylene glycol, and copolymers of ethylene glycol and propylene glycol) segments; block copolymers of propylene glycol and ethylene glycol (also called block copolymers of propylene oxide and ethylene oxide) ; ethoxylated or propoxylated acrylate oligomers; and polyethoxylated alkylphenols and polyethoxylated fatty alcohols and the like.

Surfactants that can be used include, but not limited to, the surfactants described in JP-A2009-516222 and WO 2007/057348.

The amount of the nonionic surfactants to be contained in the photosensitive layer is preferably between 0.1 and 30 % by weight, more preferably between 0.5 and 20 %, even more preferably between 1 and 15 %.

The surfactants that may be added to the developer as described later herein can also be used.

<Contrast>

The contrast of an image is defined as the difference between optical densities at exposed areas and non-exposed areas, and the contrast is preferably higher.

The contrast increases with increasing optical density in the exposed areas and/or decreasing optical density in the non-exposed areas. The optical density in the exposed areas increases with the amount and the extinction coefficient of the colorant remaining in the exposed areas and the intensity of color formed by the printing-out agent. In the non-exposed areas, it is preferred that the amount of colorant is as low as possible and that the amount of the printing-out agent is also as low as possible. The optical density can be measured in reflectance by an optical densitometer equipped with several filters (e.g., cyan, magenta, yellow). The difference in optical density at the exposed areas and the non-exposed areas has preferably a value of at least 0.3, more preferably at least 0.4, most preferably at least 0.5. There is no specific upper limit for the contrast value, but typically the contrast is less than 3.0, or even less than 2.0. In order to obtain a good contrast, selection of the type of color of the colorant is important, and preferred colors are cyan or blue colors.

Details about contrast are described in JP-A2009-516222 and WO 2007/057348, and reference can be made to these documents.

<Formation of Photo Sensitive Layer>

The photo sensitive layer according to the present invention is formed by dispersing or dissolving the above-described necessary components of the photo sensitive layer into a solvent to prepare a coating liquid, and then coating the liquid. The solvent adoptable herein is exemplified by methyl ethyl ketone, ethylene glycol monomethyl ether, 1-methoxy-2-propanol, 2-methoxyethyl acetate, 1-methoxy-2-propyl acetate, and γ-butyrolactone, but not limited thereto. The solvent may be used alone, or in combination of two or more species. The solid content of the coating liquid is preferably 1 to 50% by mass.

Preferably, the coating mass (expressed as solids) of the photosensitive layer on the support obtained after coating and drying is 0.3 to 3.0 g/$m^2$. Various coating techniques can be used. For example, bar coating, spin coating, spray coating, curtain coating, dip coating, air knife coating, blade coating, roll coating and the like are included.

<Protective layer>

Preferably, the lithographic printing plate precursors of the present invention comprise a protective layer (oxygen barrier layer) on the photosensitive layer to block diffusion and penetration of oxygen interfering with polymerization reaction during exposure. Materials that can be used for the protective layer preferably include, for example, water-soluble polymer compounds having relatively high crystallizability, and specifically the best results are obtained in basic properties such as oxygen barrier property, developer removal and the like when polyvinyl alcohol is used as a major component.

Polyvinyl alcohol used for the protective layer may partially be substituted, at the hydroxy groups thereof, by ester, ether and acetal, so long as a certain amount of unsubstituted vinyl alcohol units, necessary for ensuring oxygen barrier performance and water-solubility, is contained. Similarly, polyvinyl alcohol may also contain other polymerizable component partially in the structure thereof. Polyvinyl alcohol may be obtained by hydrolyzing polyvinyl acetate. Specific examples of polyvinyl alcohol include those having a degree of hydrolysis of 71.0 to 100 mol%, and having a number of polymerizable repeating units of 300 to 2400. More specific examples include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613,and PVA L-8, all of which commercially available from Kuraray Co. Ltd. Polyvinyl alcohol may be used alone, or in the form of mixture.

In preferred embodiments, the amount of polyvinyl alcohol contained in the protective layer is 20 to 95 % by weight, more preferably 30 to 90 % by weight.

Further, known modified polyvinyl alcohols can also be preferably used. Especially, acid-modified polyvinyl alcohols containing a carboxylic acid group or a sulfonic acid group are preferably used. A preferred component used in mixture with polyvinyl alcohol is polyvinylpyrrolidone or a modified product thereof to improve oxygen barrier property and developer removal, and they are contained in the protective layer in an amount of 3.5 to 80 % by weight, preferably 10 to 60 % by weight, more preferably 15 to 30 % by weight.

In addition, the protective layer can contain other components such as glycerin, dipropylene glycol and the like in an amount equivalent to several percent by weight of the (co)polymer to impart flexibility; and can further contain anionic surfactants such as sodium alkyl sulfates, sodium alkyl sulfonates and the like; amphoteric surfactants such as alkyl aminocarboxylates, alkyl aminodicarboxylates and the like; nonionic surfactants such as polyoxyethylene alkyl phenyl ethers and the like in an amount of several percent by weight of the (co)polymer.

Further, the protective layer in the lithographic printing plate precursors of the present invention preferably contains the inorganic lamellar compounds described in [0018] to [0024] of JP-A2006-106700 to improve oxygen barrier property and surface protection of the photosensitive layer. Among the inorganic lamellar compounds, synthetic swelling fluorine mica, which is a synthetic inorganic lamellar compound, is especially useful.

Preferably, the coating mass of the protective layer is in the range of 0.05 to 10 g/$m^2$ expressed as the coating mass after drying, more preferably in the range of 0.1 to 0.5 g/$m^2$ when an inorganic lamellar compound is contained, or more preferably in the range of 0.5 to 5 g/$m^2$ when an inorganic lamellar compound is not contained.

Additionally, the processes for preparing a lithographic printing plate from any one of the lithographic printing plate precursors of the present invention may comprise overall heating before exposure, during exposure or between exposure and development, as appropriate. Such heating may promote the image-forming reaction in the photosensitive layer, thereby providing advantages such as improvement in sensitivity or printing durability and stabilization of sensitivity. Further, overall post-heating or overall exposure of the developed image is also effective to improve image strength and·printing durability. Typically, heating before development is preferably carried out under mild conditions at 150 °C or less. If the temperature is too high, unexposed areas cure or other problems occur. Heating after development employs very intense conditions. Typically, the temperature is in the range of 100 to 500 °C. If the temperature is low, a sufficient image-strengthening effect cannot be obtained, but if it is too high, such problems as deterioration of the support or thermal decomposition of image areas occur.

Prior to the developing process described above, the lithographic printing plate precursors are exposed to laser radiation through a transparent original bearing a line image, halftone dot image or the like or imagewise exposed by laser scanning using digital data or the like. Wavelength of light source is preferably 300 to 450 nm or 750 to 1400 nm. When the light source of 300 to 450 nm is used, the lithographic printing plate precursor preferably contains, in the photosensitive layer thereof, a sensitizing dye showing an absorption maximum in this wavelength. On the other hand, for the case where the light source of 750 to 1400 nm is used, the lithographic printing plate precursor preferably contains, in the photosensitive layer thereof, an infrared absorber, which is a sensitizing dye showing an absorption maximum in this wavelength range. The light source of 300 to 450 nm is preferably a semiconductor laser. The light source of 750 to 1400 nm is preferably a solid-state laser or semiconductor laser capable of emitting infrared radiation. An exposure mechanism may be based on any of internal drum system, external drum system, and flat bed system.

[Method of Manufacturing Lithographic printing plate]

The lithographic printing plate may be manufactured by exposing the lithographic printing plate precursor according to the present invention in a pattern-wise manner, followed by development.

The method of manufacturing the lithographic printing plate of the present invention include a step of exposing the lithographic printing plate precursor according to the present invention in a pattern-wise manner; and a step of developing the exposed lithographic printing plate precursor using a developer of pH2 to 14; wherein the step of development includes a step of concomitantly removing the unexposed area of the photosensitive layer and the protective layer, in the presence of the developer.

The method of manufacturing the lithographic printing plate of the present invention preferably includes a step of forming a protective layer on the surface of the photosensitive layer on the side opposite to the support; and the step of development further includes a step of concomitantly removing the photosensitive layer in the unexposed area and the protective layer (excluding water washing process), under the presence of the developer additionally containing a surfactant.

A second embodiment of the method of manufacturing the lithographic printing plate of the present invention

includes a step of exposing the lithographic printing plate precursor according to the present invention in a pattern-wise manner; and a step of removing the photosensitive layer selectively in the unexposed area, by feeding a printing ink and a fountain solution on a printing machine.

Preferable embodiments of the individual steps in the method of manufacturing the lithographic printing plate of the present invention will be explained in sequence. According to the method of manufacturing the lithographic printing plate of the present invention, the lithographic printing plate precursor according to the present invention may be manufactured for the case where the step of development includes a step of water washing.

<Exposure >

The method of manufacturing the lithographic printing plate of the present invention includes exposing the lithographic printing plate precursor according to the present invention in a pattern-wise manner. The lithographic printing plate precursor according to the present invention is exposed by laser shot through a transparent original having a line image or halftone image or the like, or laser scanning modulated by digital data.

Wavelength of light source is preferably 300 to 450 nm or 750 to 1400 nm. When the light source of 300 to 450 nm is used, the lithographic printing plate precursor preferably contains, in the photosensitive layer thereof, a sensitizing dye showing an absorption maximum in this wavelength. On the other hand, for the case where the light source of 750 to 1400 nm is used, the lithographic printing plate precursor preferably contains, in the photosensitive layer thereof, an infrared absorber, which is a sensitizing dye showing an absorption maximum in this wavelength range. The light source of 300 to 450 nm is preferably a semiconductor laser. The light source of 750 to 1400 nm is preferably a solid-state laser or semiconductor laser capable of emitting infrared radiation. The infrared laser preferably has an output of 100 mW or larger, exposure time per pixel is preferably 20 microseconds or shorter, and exposure energy is preferably 10 to 300 $mJ/cm^2$. A multi-beam laser device is preferably used in order to shorten the exposure time. An exposure mechanism may be based on any of internal drum system, external drum system, and flat bed system.

The pattern-wise exposure may be proceeded by a general method using a plate setter, for example. When the on-machine development is adopted, the lithographic printing plate precursor may be set on a printing machine and may be exposed pattern-wise on the printing machine

<Preheating>

Additionally, the processes for preparing a lithographic printing plate from any one of the lithographic printing plate precursors of the present invention may comprise overall heating before exposure, during exposure or between exposure and development, as appropriate. Such heating may promote the image-forming reaction in the photosensitive layer, thereby providing advantages such as improvement in sensitivity or printing durability and stabilization of sensitivity. Further, overall post-heating or overall exposure of the developed image is also effective to improve image strength and·printing durability. This preheating step is preferably carried out within a time period of less than 10 minutes, more preferably less than 5 minutes, even more preferably less than 1 minute. This preheating step is especially preferably carried out immediately after exposure, i.e., within less than 30 seconds. There is no specific time limit before the heating may start, but the precursor is transported to a preheating unit and heating is started in such a manner that it may be heated as soon as possible after exposure. This heating takes place at a temperature of preferably 80 °C to 150 °C and for a period of preferably 5 seconds to 1 minute. Typically, heating before development is preferably carried out under mild conditions at 150 °C or less. If the temperature is too high, unexposed areas cure or other problems occur. Heating after development employs very intense conditions. Typically, the temperature is in the range of 100 to 500 °C. If the temperature is low, a sufficient image-strengthening effect cannot be obtained, but if it is too high, such problems as deterioration of the support or thermal decomposition of image areas occur. The preheating unit is provided with heating elements such as IR-lamps, UV-lamps, heated air, a heated metal roll and the like. Details about preheating are described in JP-A2009-516222 and WO 2007/057348, and reference can be made to these documents.

<Development>

The development may be implemented by (1) a method of development using a developer of pH2 to 14 (developer process), or (2) a method of development on a printing machine, while feeding fountain solution and/or ink (on-machine development).

(Developer Process)

In the developer process, the lithographic printing plate precursor is treated using the developer of pH2 to 14, so as to remove the photosensitive layer in non-exposed areas, and thereby lithographic printing plate is manufactured.

In a general process of development using a strong alkaline developer (pH12 or above), the protective layer is removed by pre-water washing, subjected to alkaline development, post-water washing for removing alkali by water washing, gum solution treatment, and drying process, to thereby obtain the lithographic printing plate. According to a first preferable embodiment of the present invention, the developer used herein has pH value of 2 to 14. In this embodiment, the developer preferably contains a surfactant or water-soluble polymer compound, so as to concomitantly allow the development and gum solution treatment to proceed. Accordingly, the post-water washing is not indispensable, and the development and the gum solution treatment may be proceeded in a single solution.

Also the pre-water washing is not indispensable, so that also the removal of the protective layer may be proceeded concomitantly with the gum solution treatment. In the method of manufacturing the lithographic printing plate of the present invention, the development and gum solution treatment is preferably followed by removal of excessive developer using a squeeze roller for example, and drying.

The development by developer in the lithographic printing plate precursor of the present invention may be proceeded as usual at 0 to 60°C, preferably 15 to 40°C or around, typically by a method of dipping the exposed lithographic printing plate precursor into a developer followed by rubbing with a brush, or a method of spraying a developer followed by rubbing with a brush.

The development using the developer is successfully implemented on an automatic processor, equipped with a developer feeder and a rubbing member. The automatic processor having rotating brush rollers as the rubbing member is particularly preferable. The automatic processor preferably has a unit for removing excessive developer, such as squeeze rollers, and a drying unit such as a hot air blower, on the downstream side of the developing unit. Moreover, the automatic processor may have a pre-heating unit for heating the exposed lithographic printing plate precursor, on the upstream side of the developing unit.

An example of automatic processor used for the method of manufacturing a lithographic printing plate of the present invention will be briefed below, referring to FIG. 1.

The example of the automatic processor used for the method of manufacturing a lithographic printing plate of the present invention is illustrated in FIG. 1. The automatic processor illustrated in FIG. 1 is basically composed of a developing unit 6 and a drying unit 10, wherein the lithographic printing plate precursor 4 is developed in the developing tank 20, and dried in the drying unit 10.

The automatic processor 100 illustrated in FIG. 2 is composed of a chamber shaped by an equipment frame 202, and has a pre-heating section 200, a developing section 300 and a drying section 400 aligned in line in the direction of a feed path 11 along which the lithographic printing plate precursor is fed (indicated by arrow A).

The pre-heating section 200 has a heating chamber 208 with a feeding port 212 and an output port 218, and has tandem rollers 210, heaters 214 and a circulating fan 216 arranged therein.

The developing section 300 is partitioned by an outer panel 310 from the pre-heating section 200, and the outer panel 310 has an insertion slit 312.

Inside the developing section 300, there is provided a process tank 306 having therein a developing tank 308 filled with a developer, and an insertion roller pair 304 for guiding the lithographic printing plate precursor into the process tank 306. The upper portion of the developing tank 308 is covered with a shielding lid 324.

Inside the developing tank 308, there is provided a guide roller 344 and a guiding member 342, an immersed roller pair 316, a brush roller pair 322, a brush roller pair 326, and an output roller pair 318 which are aligned in sequence from the upstream side of the feeding direction. The lithographic printing plate precursor brought into the developing tank 308 is dipped in the developer, and allowed to pass through the rotating brush roller pairs 322, 326, to be removed with the non-image-forming area.

Below the brush roller pairs 322, 326, there is provided a spray pipe 330. The spray pipe 330 is connected to a pump (not illustrated), and the developer in the developing tank 308 sucked up by the pump is ejected through the spray pipe 330 into the developing tank 308.

On the sidewall of the developing tank 308, there is provided an overflow port 51 opened at the top end portion of a first circulating pipe C1, so as to allow an excessive portion of the developer to flow into the overflow port 51, run down through the first circulating pipe C1, to be discharged into an external tank 50 provided outside the developing section 300.

The external tank 50 is connected to a second circulating pipe C2. The second circulating pipe C2 is provided with a filter unit 54 and a developer feed pump 55. By the developer feed pump 55, the developer is fed from the external tank 50 to the developing tank 308. The external tank 50 is provided with a upper level gauge 52 and a lower level gauge 53.

The developing tank 308 is connected through a third circulating pipe C3 to a supplementary water tank 71. The third circulating pipe C3 is provided with a water supplement pump 72 by which water reserved in the supplementary water tank 71 is fed to the developing tank 308.

A liquid temperature sensor 336 is provided on the upstream side of the immersed roller pair 316, and a level gauge 338 is provided on the upstream side of the output roller pair 318.

A partition board 332 placed between the developing section 300 and the drying section 400 has an insertion

slit 334 provided thereto. On a path between the developing section 300 and the drying section 400, there is provided a shutter (not illustrated) which closes the path when the lithographic printing plate precursor 11 does not travel on the path.

The drying section 400 has a support roller 402, ducts 410, 412, a feed roller pair 406, ducts 410, 412, and a feed roller pair 408 aligned therein in sequence. Each of the ducts 410, 412 has a slit hole 414 provided to the tip thereof. The drying section 400 has provided thereto an unillustrated drying unit such as a hot air blower, heat generator or the like. The drying section 400 has a discharge port 404, through which the lithographic printing plate dried by the drying unit is ejected.

In the present invention, the developer used in the developing process comprises an aqueous solution at pH 2 to 14 or a surfactant. The developer preferably used in the present invention is an aqueous solution at pH 2 to 11. Preferred are aqueous solutions containing water as a major component (containing 60 % by mass or more of water), particularly aqueous solutions containing a surfactant (such as an anionic, nonionic, cationic, or amphoteric surfactant) or aqueous solutions containing a water-soluble polymer compound. Also preferred are aqueous solutions containing both of a surfactant and a water-soluble polymer compound. More preferably, the developer has a pH between 5 and 10.7, even more preferably between 6 and 10.5, most preferably between 6.5 and 10.3.

The developer may be used to protect the lithographic image of a printing plate against contamination, e.g. by oxidation, fingerprints, fats, oils or dust, or damaging, e.g. by scratches. The developer preferably has a surface tension of 20 to 50 mN/m, and preferably comprises a nonionic surfactant. In this case, the layer that remains on the plate after the developing process preferably comprises between 0.005 and 20 $g/m^2$, more preferably between 0.010 and 10 $g/m^2$, even more preferably between 0.020 and 5 $g/m^2$ of a surface protective compound. A developer (gum solution) that can be used is, but not limited to, the developer described in JP-A2009-516222 and WO 2007/057348.

Examples of the anionic surfactants used in the developer of the present invention include aliphates, abietates, hydroxyalkanesulfonates, alkanesulfonates, dialkylsulfosuccinates, straight-chain alkylbenzenesulfonates, branched alkylbenzenesulfonates, alkylnaphthalenesulfonates, alkylphenoxypolyoxyethylenepropylsulfonates, salts of polyoxyethylene alkyl sulfophenyl ethers, sodium N-methyl-N-oleyltaurates, monoamide disodium N-alkylsulfosuccinates, petroleum sulfonates, sulfated castor oil, sulfated tallow oil, salts of sulfuric esters of aliphatic alkyl esters, salts of alkylsulfuric esters, sulfuric esters of polyoxyethylene alkyl ethers, salts of sulfuric esters of aliphatic monoglycerides, salts of sulfuric esters of polyoxyethylene alkyl phenyl ethers, salts of sulfuric esters of polyoxyethylene styryl phenyl ethers, salts of alkylphosphoric esters, salts of phosphoric esters of polyoxyethylene alkyl ethers, salts of phosphoric esters of polyoxyethylene alkyl phenyl ethers, partially saponified compounds of styrene-maleic anhydride copolymers, partially saponified compounds of olefin-maleic anhydride copolymers, and naphthalenesulfonate-formalin condensates. Particularly preferred among these anionic surfactants are dialkylsulfosuccinates, salts of alkylsulfuric esters and alkylnaphthalenesulfonates.

Specific examples of anionic surfactants include sodium dodecyl phenoxy benzene disulfonate, the sodium salt of alkylated naphthalenesulfonate, disodium methylene-dinaphthalene-disulfonate, sodium dodecyl benzene sulfonate, sulfonated alkyl diphenyl oxide, ammonium or potassium perfluoroalkylsulfonate and sodium dioctylsulfosuccinate.

Cationic surfactants used in the developer of the present invention are not specifically limited, but those previously known can be used. For example, they include alkylamine salts, quaternary ammonium salts, polyoxyethylene alkyl amine salts, and polyethylene polyamine derivatives.

Examples of the nonionic surfactants used in the developer of the present invention include polyoxyethylene alkyl ethers, polyoxyethylene alkyl aryl ethers wherein the aryl group may be a phenyl group, a naphthyl group or an aromatic heterocyclic group, polyoxyethylene polystyryl phenyl ethers, polyoxyethylene polyoxypropylene alkyl ethers, polyoxyethylene-polyoxypropylene block polymers, partial esters of glycerin aliphatic acids, partial esters of sorbitan aliphatic acids, partial esters of pentaerythritol aliphatic acids, propylene glycol monoaliphatic esters, partial esters of sucrose aliphatic acids, partial esters of polyoxyethylene sorbitan aliphatic acids, partial esters of polyoxyethylene sorbitol aliphatic acids, polyethylene glycol aliphatic esters, partial esters of polyglycerin aliphatic acids, polyoxyethylenated castor oils, partial esters of polyoxyethylene glycerin aliphatic acids, aliphatic diethanolamides, N,N-bis-2-hydroxyalkylamines, polyoxyethylene alkylamines, triethanolamine aliphatic esters, and trialkylamine oxides. Particularly preferred among these nonionic surfactants are polyoxyethylene alkyl phenyl ethers, polyoxyethylene alkyl naphthyl ethers and polyoxyethylene-polyoxypropylene block polymers. Further, fluorinic and siliconic anionic and nonionic surfactants may be similarly used.

Two or more of the above surfactants may be used in combination. For example, a combination of two or more different anionic surfactants or a combination of an anionic surfactant and a nonionic surfactant may be preferred.

Amphoteric surfactants used in the developer of the present invention are not specifically limited, but include amine oxide surfactants such as alkyl dimethylamine oxides, betaine surfactants such as alkyl betaines, and amino acid surfactants such as sodium salts of alkylamino fatty acids. Especially, optionally substituted alkyl dimethylamine oxides, optionally substituted alkyl carboxybetaines, and optionally substituted alkyl sulfobetaines are preferably used. Specific examples of these surfactants that can be used include those described in paragraphs 0255 to 0278 of JP-A2008-203359,

paragraphs 0028 to 0052 of JP-A2008-276166 and the like.

Two or more of the surfactants may be used in the developer. The amount of the surfactants contained in the developer is preferably 0.01 to 20 % by weight, more preferably 0.1 to 10 % by weight.

<Surface protective components in the developer>

Further, surface protective water-soluble polymer compounds used in the developer of the present invention include soy polysaccharides, modified starches, gum arabic, dextrin, cellulose derivatives (e.g., carboxymethylcellulose, carboxyethylcellulose, methylcellulose and the like) and their modified products, pullulan, polyvinyl alcohol and derivatives thereof, polyvinylpyrrolidone, polyacrylamide and acrylamide copolymers, copolymers of vinyl methyl ether and maleic anhydride, copolymers of vinyl acetate and maleic anhydride, copolymers of styrene and maleic anhydride and the like.

The soybean polysaccharides are selectable from those known in the art, such as those commercially available under the trade name of Soyafive (from Fuji Oil Co. Ltd.) with a variety of grades. Among them, those showing a viscosity of a 10% by mass aqueous solution of 10 to 100 mPa/sec are preferably used.

Also the modified starch is selectable from those known in the art, which may be prepared for example by decomposing starch derived from corn, potato, tapioca, rice, wheat or the like by acid or enzyme, so as to give molecules having 5 to 30 glucose residues, and by adding thereto oxypropylene in an alkaline solution.

Further, the water-soluble polymer compounds may comprise homopolymers and/or copolymers of monomers containing carboxylic, sulfonic or phosphonic groups or the salts thereof, e.g. (meth) acrylic acid, vinyl acetate, styrene sulfonic acid, vinyl sulfonic acid, vinyl phosphonic acid or acrylamidopropanesulfonic acid.

Two or more of the water-soluble polymer compounds may also be used in combination. The amount of the water-soluble polymer compounds contained in the developer is preferably 0.1 to 20 % by weight, more preferably 0.5 to 10 % by weight.

Preferably, the pH of the developer is usually adjusted with a mineral acid, an organic acid or an inorganic salt in an amount of from 0.01 to 15 % by weight, preferably from 0.02 to 10 % by weight.

Mineral acids include, for example, nitric acid, sulfuric acid, phosphoric acid, metaphosphoric acid and the like. Organic acids include, for example, carboxylic acids, sulfonic acids, phosphonic acids or salts thereof, e.g. succinates, phosphates, phosphonates, sulfates and sulfonates. Organic acids may also be used as desensitizing agents. Specific examples of organic acids include citric acid, acetic acid, oxalic acid, malonic acid, p-toluenesulfonic acid, tartaric acid, malic acid, lactic acid, levulinic acid, phytic acid, organic phosphonic acid and the like.

The developer may further comprise an inorganic salt. Inorganic salts include, for example, magnesium nitrate, monobasic sodium phosphate, dibasic sodium phosphate, nickel sulfate, sodium hexametaphosphate, sodium tripolyphosphate and the like, especially preferably alkali metal monohydrogen phosphates, alkali metal dihydrogen phosphates, and alkali metal phosphates, such as $KH_2PO_4$ or $NaH_2PO_4$, $Na_2HPO_4$, and $Na_3PO_4$. Further, magnesium sulfate, zinc nitrate and the like, for example, can be used as corrosion inhibiting agents. The mineral acids, organic acids or inorganic salts may be used alone or in combination with one or more of them.

Preferably, the developer comprises a mixture of an anionic surfactant and an inorganic salt. In this mixture, the anionic surfactant is preferably an anionic surfactant having a sulfonic acid group, more preferably an alkali metal salt of mono- or di-alkyl-substituted diphenyl ether sulfonic acid, and the inorganic salt is preferably a mono-or dibasic phosphoric acid salt, more preferably an alkali metal monohydrogen phosphate, an alkali metal dihydrogen phosphate, or an alkali metal phosphate, such as $KH_2PO_4$ or $NaH_2PO_4$, $Na_2HPO_4$, or $Na_3PO_4$.

The developer used in the present invention may contain a pH buffering agent. For the developer of the present invention, the pH buffering agent is arbitrarily selectable without special limitation, so long as it exhibits a buffering action in the range from pH2 to 11. In the present invention, a weak alkaline buffering agent is preferably used, wherein the examples include (a) carbonate ion and hydrogen carbonate ion, (b) borate ion, (c) water-soluble amine compound and ion thereof, and combination of these ions. More specifically, (a) combination of carbonate ion and hydrogen carbonate ion, (b) borate ion, or (c) combination of water-soluble amine compound and ion thereof, for example, exhibits a pH buffering action in the developer, capable of suppressing pH from fluctuating even if the developer is used over a long period, and is therefore capable of suppressing degradation in the developability and generation of development scum due to fluctuation in pH. In the method of manufacturing the lithographic printing plate of the present invention, the combination of carbonate ion and hydrogen carbonate ion is particularly preferable.

In order to allow carbonate ion and hydrogen carbonate ion to reside in the developer, one possible method is to add a carbonate salt and a hydrogen carbonate salt into the developer, and another method is to adjust pH after the carbonate salt or hydrogen carbonate salt are added, so as to generate carbonate ion or hydrogen ion. While the carbonate salt and the hydrogen carbonate salt are not specifically limited, alkali metal salt is preferable. The alkali metal is exemplified by lithium, sodium, and potassium, wherein sodium is particularly preferable. The alkali metal may be used alone, or in combination of two or more species.

When a combination of carbonate ions and bicarbonate ions (a) is employed as a pH buffering agent, the total

amount of the carbonate ions and bicarbonate ions is preferably 0.05 to 5 mol/L, more preferably 0.1 to 2 mol/L, especially preferably 0.2 to 1 mol/L based on the total mass of the aqueous solution.

The developer used in the present invention may contain an organic solvent. Examples of the organic solvent adoptable herein include aliphatic hydrocarbons (hexane, heptane, Isopar E, Isopar H, Isopar G (from Esso), etc.), aromatic hydrocarbon (toluene, xylene, etc.), halogenated hydrocarbon (methylene dichloride, ethylene dichloride, trichloroethylene, monochlorobenzene, etc.), and polar solvent.

Polar solvents include alcohols, ketones, and esters.

When the organic solvent is insoluble in water, it may be used by solubilizing it in water using a surfactant or the like, and when the developer contains the organic solvent, the concentration of the solvent is desirably less than 40 % by weight taking into account safety and inflammability.

Besides the foregoing components, the developer of the present invention can contain an antiseptic agent, a chelate compound, an anti-foaming agent, an organic acid, an inorganic acid, an inorganic salt and the like. Specifically, the compounds described in paragraphs 0266 to 0270 of JP-A2007-206217 can be preferably used.

Besides the foregoing components, the developer may contain a wetting agent. Wetting agents include, for example, ethylene glycol, propylene glycol, triethylene glycol, butylene glycol, hexylene glycol, diethylene glycol, dipropylene glycol, glycerin, trimethylol propane, diglycerin and the like. The wetting agents can be used alone or in combination with one or more thereof. In general, the foregoing wetting agents are preferably contained in an amount of from 1 to 25 % by weight. Wetting agents that can be used include, but not limited to, the wetting agents described in JP-A2009-516222 and WO 2007/057348.

Further, the developer may contain a chelate compound. Calcium ions and other impurities contained in the diluting water can have adverse effects on printing and thus cause the contamination of printed matter. This problem can be eliminated by adding a chelate compound to the diluting water.

Chelate compounds include, for example, organic phosphonic acids, phosphonoalkanetricarboxylic acids and the like. Specific examples of chelate compounds include potassium or sodium salts of ethylenediaminetetraacetic acid, diethylenetriaminepentaacetic acid, triethylenetetraminehexaacetic acid, hydroxyethylethylenediaminetriacetic acid, nitrilotriacetic acid, 1-hydroxyethane-1,1-diphosphonic acid and aminotri(methylenephosphonic acid) and the like. Besides these sodium or potassium salts of these chelating agents, organic amine salts may also be used. The preferred amount of the chelate compounds to be added is from 0.001 to 5 % by weight relative to the developer in diluted form. Chelate compounds that can be used include, but not limited to, the chelate compounds described in JP-A2009-516222 and WO 2007/057348.

The developer may contain an antiseptic agent and/or an anti-foaming agent. Antiseptic agents include, for example, phenol, derivatives thereof, formalin, imidazole derivatives, sodium dehydroacetate, 4-isothiazoline-3-one derivatives, benzoisothiazoline-3-one, benzotriazole derivatives, amidineguanidine derivatives, quaternary ammonium salts, pyridine derivatives, quinoline derivatives, guanidine derivatives, diazine, triazole derivatives, oxazole and oxazine derivatives, etc. The preferred amount of such an antiseptic to be added is such that it can exert a stable effect on bacteria, fungi, yeast or the like, and depending on the kind of bacteria, fungi and yeast, it is preferably from 0.01 to 4 % by weight relative to the developer in diluted form. The antiseptic agents may be used alone or as a combination of two or more of them.

Anti-foaming agents include, for example, silicone antifoaming agents. Among the antifoaming agents, either an emulsion dispersion type or solubilized type anti-foaming agent may be used. The amount of the antifoaming agent to be added is preferably from 0.001 to 1.0 % by weight relative to the developer in diluted form. Antiseptic agents and anti-foaming agents that can be used include, but not limited to, the antiseptic agents and anti-foaming agents described in JP-A2009-516222 and WO 2007/057348.

Besides the foregoing components, the developer may contain an ink receptivity agent. Ink receptivity agents include, for example, turpentine oil, xylene, toluene, low heptane, solvent naphtha, kerosene, mineral spirit, hydrocarbons (e.g., a petroleum fraction having a boiling point of about 120 °C to about 250 °C), diester phthalates (e.g., dibutyl phthalate, diheptyl phthalate, di-n-octyl phthalate, di(2-ethylhexyl) phthalate, dinonyl phthalate, didecyl phthalate, dilauryl phthalate, butylbenzyl phthalate), aliphatic dibasic esters (e.g., dioctyl adipate, butylglycol adipate, dioctyl azelate, dibutyl sebacate, di(2-ethylhexyl) sebacate, dioctyl sebacate), epoxidated triglycerides (e.g., epoxy soybean oil), ester phosphates (e.g., tricresyl phosphate, trioctyl phosphate, trischloroethyl phosphate) and plasticizers having a solidification point of 15 °C or less and a boiling point of 300 °C or more at one atmospheric pressure such as esters of benzoates (e.g., benzyl benzoate) and the like. Ink receptivity agents that can be used in combination with these agents include, for example, ketones, halogenated hydrocarbons, ethylene glycol ethers, aliphatic acids and unsaturated aliphatic acids, preferably aliphatic acids which are liquid at a temperature of 50 °C, more preferably have from 5 to 25 carbon atoms, especially preferably have from 8 to 21 carbon atoms. The ink receptivity agents may be used alone or in combination with one or more of them. The amount of the ink receptivity agents to be added is preferably 0.01 to 10 % by weight, more preferably 0.05 to 5 % by weight. The ink receptivity agents may be present as oil-in-water emulsions or may be solubilized with the aid of a solubilizing agent. Ink receptivity agents that can be used include, but not limited to, the ink

receptivity agents described in JP-A2009-516222 and WO 2007/057348.

Further, the viscosity of the developer can be adjusted to e.g. between 1.7 and 5 mPa.s, by adding a viscosity increasing compound e.g. having a molecular weight between $10^4$ and $10^7$. Viscosity increasing compounds include, for example, poly(ethylene oxide), polyvinyl alcohol and the like. The viscosity increasing compounds are preferably present in a concentration of 0.01 to 10 g/l. Viscosity increasing compounds that can be used include, but not limited to, the viscosity increasing compounds described in JP-A2009-516222 and WO 2007/057348.

The developer described above can be used as a developer and a developer replenisher solution for exposed negative-working lithographic printing plate precursors, and it is preferably applied to the automatic processor described below. When development takes place using an automatic processor, the developer deteriorates with the amount processed and therefore a developer replenisher solution or a fresh developer may be used to restore the throughput.

The developing process using an aqueous solution at pH 2 to 11 in the present invention can be more conveniently performed by an automatic processor equipped with a means for supplying the developer and a rubbing member. An automatic processor using a rotating brush roll as a rubbing member is especially preferred.

Further, the automatic processor preferably comprises a means for removing an excess of the developer such as a squeeze roller or the like, and a drying mean such as a hot air dryer or the like downstream of the developing means.

<Baking gum>

In the present invention, a baking gum may be used instead of the developer. The baking gum has a similar composition to that of the developer and it is preferably a compound that does not evaporate at the usual bake temperatures. Baking gum solutions or baking gumming solutions include, for example, aqueous solutions of sodium dodecyl phenoxy benzene disulfonate, alkylated naphthalene sulfonic acid, sulfonated alkyl diphenyl oxide, methylene dinaphthalene sulfonic acid, etc., and they may contain a hydrophilic polymer component and an organic acid component, or may contain the potassium salt of hydroxyethylidene diphosphonic acid. Alternatively, they may contain a sulfosuccinamate compound and phosphoric acid.

Further, baking gums that can be used include, but not limited to, the baking gums described in JP-A2009-516222 and WO 2007/057348.

The contact angle between the baking gum solution and the plate is lowered by adding at least one surfactant. Such surfactants include nonionic polyglycols, perfluorinated aliphatic polyester acrylates and the like.

Further, the baking gumming solution may comprise (a) water, (b) at least one hydrophilic polymer and (c) at least one of organic acids containing at least two acid groups and water-soluble salts thereof. Specific examples of these solutions include those described in JP-A2009-516222, WO 2007/057348, EP 222297, EP 1025992, DE 2626473 and US Patent No. 4,786,581.

Further, baking gums that can be used include, but not limited to, the baking gums described in JP-A2009-516222 and WO 2007/057348.

<On-machine development System>

In the on-machine development system, the lithographic printing plate precursor after pattern-wise exposure is fed, on a printing machine, with an oil-based ink and water-based component, so as to remove the photosensitive layer selectively in the non-image-forming area, to thereby give a lithographic printing plate.

More specifically, the lithographic printing plate precursor is exposed pattern-wise and then set on the printing machine without development, or, the lithographic printing plate precursor is set on the printing machine and then exposed pattern-wise on the printing machine. Next, printing is started by feeding the oil-based ink and the water-based component. In the non-image-forming area, the uncured photosensitive layer is removed in the early stage of printing, by dissolution or dispersion with the aid of the oil-based ink and/or water-based component fed thereto, and thereby the hydrophilic surface exposes in the area. On the other hand, in the light-exposed area, the photosensitive layer cured by exposure forms an acceptance sites for oil-based ink where a lipophilic surface exposes. While it is arbitrary which of the oil-based ink and the water-based component is the first to be fed onto the surface of plate, it is more preferable to feed the oil-based ink first, in view of preventing the water-based component from being contaminated by components of the removed photosensitive layer. In this way, the lithographic printing plate precursor is developed on the printing machine, and is directly used in a large number of impressions. The oil-based ink and the water-based component are preferably a printing ink and fountain solution, respectively, which are used for general planographic printing.

In the method of manufacturing a lithographic printing plate from a lithographic printing plate precursor according to the present invention, the entire surface of the lithographic printing plate precursor may be heated before exposure, or during exposure, or between exposure and development, irrespective of the development style. By the heating, the image forming reaction in the recording layer may be accelerated, to thereby advantageously improve the sensitivity and printing durability, and stabilize the sensitivity. For the development by developer, it is also effective to subject the

developed plate to post-heating or exposure over the entire surface, aiming at improving the strength of the image-forming area and printing durability. In general, the pre-heating is preferably proceeded under a mild condition typically at 150 °C or lower. Too high temperature may result in curing of the non-image-forming area. On the other hand, the post-heating after development needs a very strong condition, typically at 100 to 500°C. Too low temperature may result in insufficient strength of the image-forming area, whereas too high temperature may degrade the support, or decompose the image-forming area.

Features of the present invention will further be detailed referring to Examples. Note that the amount of use, ratio, details of processes, and procedures of processes described in Examples below may be arbitrarily modified, without departing from the spirit of the present invention. The scope of the present invention is, therefore, not restrictively understood by the specific examples described below. As used in the Examples below with reference to the amounts added, the term "parts" means "parts by weight" unless otherwise specified.

1. Preparation of lithographic printing plate precursors

Any one of the photosensitive layers described below was formed on the support 1 having a primer layer formed from poly(vinylphosphonic acid) as described below, and further the protective layer 1 described below was formed on it to prepare a lithographic printing plate precursor.

<Preparation of support 1 having a primer layer>

An aluminum plate having a thickness of 0.24 mm (grade 1050, temper H16) was degreased by immersion in an aqueous solution of 5 % sodium hydroxide kept at 65 °C for 1 minute, and then washed with water. This degreased aluminum plate was neutralized by immersion in an aqueous solution of 10 % hydrochloric acid kept at 25 °C for 1 minute, and then washed with water. Then, this aluminum plate was subjected to an electrolytic surface-roughening treatment using AC at a current density of 100 A/$dm^2$ in an aqueous solution of 0.3 % by weight of hydrochloric acid at 25 °C for 60 seconds, and then desmutted in an aqueous solution of 5 % sodium hydroxide kept at 60 °C for 10 seconds. The surface-roughened and desmutted aluminum plate was subjected to an anodization treatment in an aqueous solution of 15 % sulfuric acid at 25 °C under conditions of a current density of 10 A/$dm^2$ and a voltage of 15 V for 1 minute, and further subjected to a hydrophilization treatment using an aqueous solution of 1 % poly (vinylphosphonic acid) at 75 °C to prepare a support. Its surface roughness was determined to be 0.44 μm (expressed as Ra according to JIS B0601).

<Formation of photosensitive layer 1>

A coating solution for photosensitive layer (1) having the composition shown below was applied using a bar coater on the primer layer described above, and then dried in an oven at 90 °C for 60 seconds to form a photosensitive layer.

<Coating solution for photosensitive layer (1)>

- Binder polymer (1) shown below (weight average molecular weight: 50,000) 0.06 g
- Binder polymer (2) shown below (weight average molecular weight: 80,000) the amount indicated in Table 1
- Condensation crosslinker the compound and amount indicated in Table 1
- Polymerizable compound (1) shown below 0.17 g (PLEX6661-O from Degussa Japan Co., Ltd.)
- Polymerizable compound (2) shown below 0.51 g
- Sensitizing dye (1) shown below 0.03 g
- Sensitizing dye (2) shown below 0.015 g
- Sensitizing dye (3) shown below 0.015 g
- Polymerization initiator (1) shown below 0.13 g
- Chain transfer agent: mercaptobenzothiazole 0.01 g
- Dispersion of a ε-phthalocyanine pigment 0.40 g (containing 15 parts by weight of the pigment, 10 parts by weight of a dispersing agent (allyl methacrylate / methacrylic acid copolymer (weight average molecular weight: 60, 000, molar ratio: 83/17)), and 15 parts by weight of cyclohexanone)
- Thermal polymerization inhibitor 0.01 g (N-nitrosophenylhydroxylamine aluminum salt)
- Water-soluble fluorosurfactant (1) shown below (weight average molecular weight: 10,000) 0.001 g
- 1-Methoxy-2-propanol 3.5 g
- Methyl ethyl ketone 8.0 g

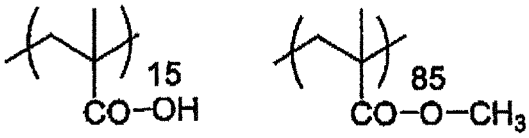

Binder polymer (1)
(Acid value = 85mgKOH/g)

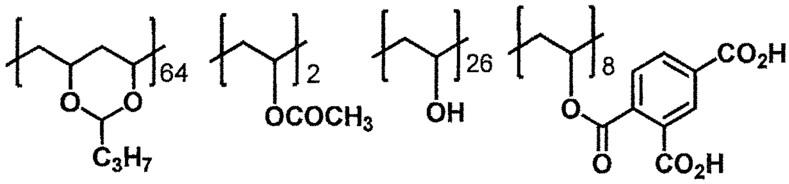

Binder polymer (2)
(Acid value = 66mgKOH/g)(Molar ratio is 64:2:26:8.)

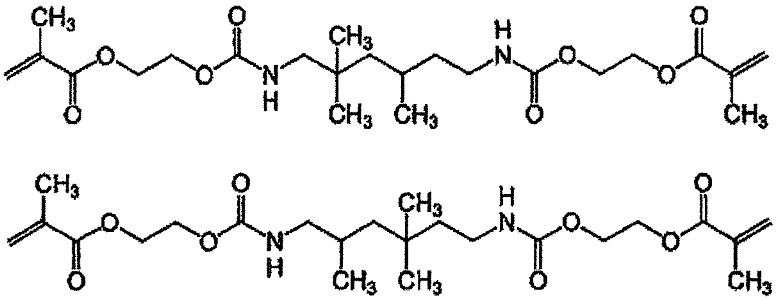

Polymerizable compound (1) [The mixture of the isomers]

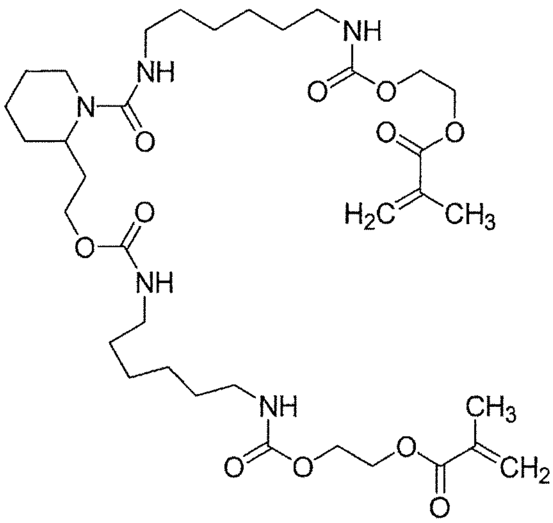

Polymerizable compound (2)

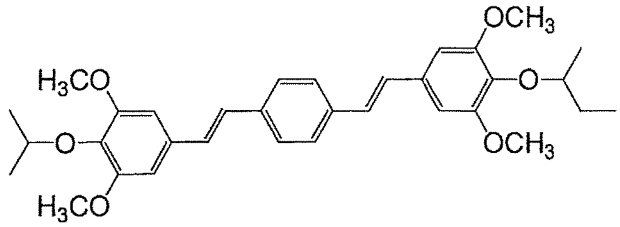

Sensitizing dye (1)

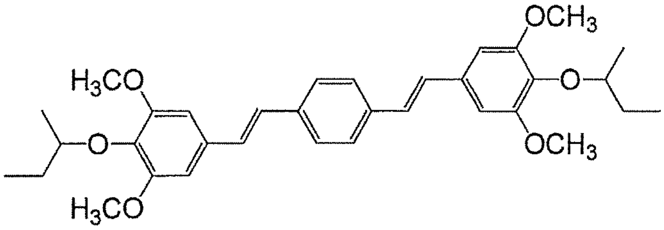

Sensitizing dye (2)

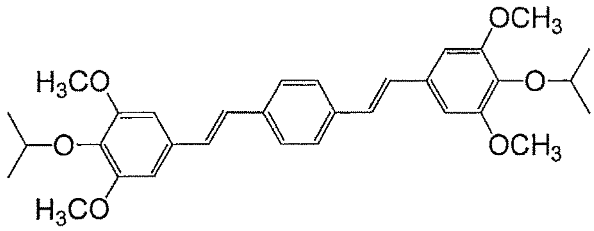

Sensitizing dye (3)

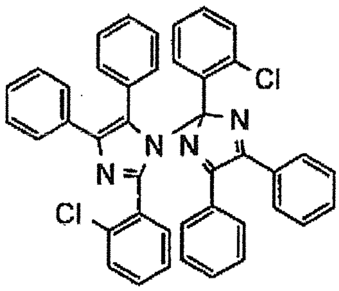

Polymerization initiator (1)

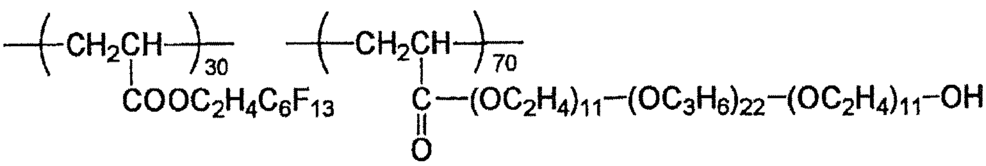

Fluorosurfactant (1)

[Formation of photosensitive layer 2]

A coating solution for photosensitive layer 2 having the composition shown below was applied using a bar coater on the primer layer described above, and then dried in an oven at 100 °C for 60 seconds to form photosensitive layer 2. The coating solution for photosensitive layer 2 was prepared by mixing the coating solution for photosensitive layer (2) and hydrophobizing solution (1) shown below and stirring the mixture immediately before it was applied.

<Coating solution for photosensitive layer (2)>

- Binder polymer (1) (weight average molecular weight: 50,000) 0.032 g
- Binder polymer (2) (weight average molecular weight: 80,000) the amount indicated in Table 1
- Condensation crosslinker the compound and amount indicated in Table 1
- Infrared absorber (1) shown below 0.030 g
- Polymerization initiator (3) shown below 0.162 g
- Polymerizable compound (1) 0.17 g (PLEX6661-O from Degussa Japan Co., Ltd.)
- Polymerizable compound (2) 0.51 g
- PIONIN A-20 (from TAKEMOTO OIL & FAT Co., Ltd.) 0.055 g
- Oil-sensitizer (1) shown below 0.044 g
- Fluorosurfactant (1) shown above 0.008 g
- Methyl ethyl ketone 1.091 g
- 1-Methoxy-2-propanol 8.609 g

Infrared absorbing dye (1):

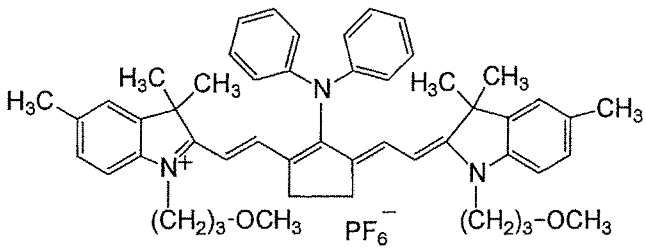

Polymerization initiator (3)

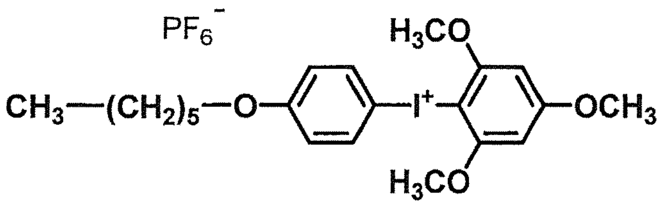

Oil-sensitizer (1)

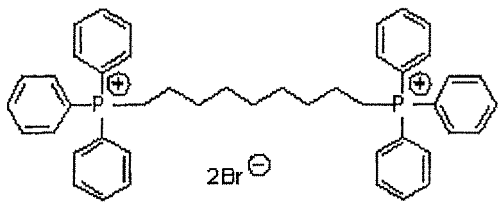

<Hydrophobizing solution (1)>

- Aqueous dispersion of hydrophobizing agent (1) shown below 2.640 g
- Distilled water 2.425 g

(Preparation of an aqueous dispersion of hydrophobizing agent (1))

A 1000-ml four-neck flask equipped with a stirrer, a thermometer, a dropping funnel, a nitrogen inlet, and a

reflux condenser was charged with distilled water (350 mL) under deoxygenation by nitrogen gas purging and heated until the internal temperature reached 80 °C. To this were added sodium dodecyl sulfate (1.5 g) as a dispersing agent, and ammonium persulfide (0.45 g) as an initiator, and then a mixture of glycidyl methacrylate (45.0 g) and styrene (45.0 g) was added dropwise via the dropping funnel over about one hour. After completion of the dropwise addition, the reaction was continued for 5 hours, and then unreacted monomers were removed by steam distillation. Then, the mixture was cooled and adjusted to pH 6 with aqueous ammonia, and finally pure water was added to reduce non-volatiles to 15 % by weight, thereby giving an aqueous dispersion of hydrophobizing agent (1) consisting of polymer microparticles. The particle size distribution of the polymer microparticles had a maximum at a particle size of 60 nm.

The particle size distribution was determined by taking an electron micrograph of the polymer microparticles and measuring the particle size of a total of 5000 microparticles on the photograph, and plotting the frequency of appearance of each of 50 particle sizes on a logarithmic scale from the maximum to zero of the measured particle sizes. The particle sizes of nonspherical particles were determined as the particle sizes of spherical particles having the same particle areas as those on the photograph.

[Formation of photosensitive layer 3]

A coating solution for photosensitive layer (3) prepared as described below was applied using a bar coater on the primer layer described above, and then dried in an oven at 100 °C for 60 seconds to form photosensitive layer 3.

<Coating solution for photosensitive layer (3)>

A coating solution for photosensitive layer (3) was prepared in the same manner as for the preparation of the coating solution for photosensitive layer (1) except that the binder polymer (2) was replaced by the binder polymer (3) shown below in the preparation of the coating solution for photosensitive layer (1).

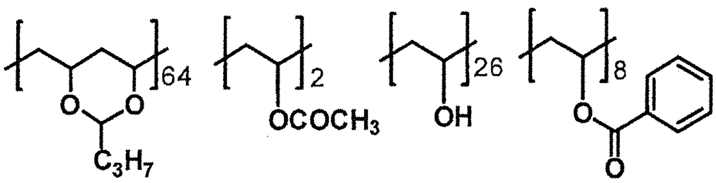

Binder polymer (3):

(Weight average molecular weight:80,000)(Molar ratio is 64:2:26:8)

[Formation of photosensitive layer 4]

A coating solution for photosensitive layer (4) prepared as described below was applied using a bar coater on the primer layer described above, and then dried in an oven at 100 °C for 60 seconds to form photosensitive layer 4 having a coating mass of 1.0 $g/m^2$ after drying.

<Coating solution for photosensitive layer (4)>

A coating solution for photosensitive layer (4) was prepared in the same manner as for the preparation of the coating solution for photosensitive layer (1) except that the binder polymer (2) was replaced by the binder polymer (4) shown below in the preparation of the coating solution for photosensitive layer (1).

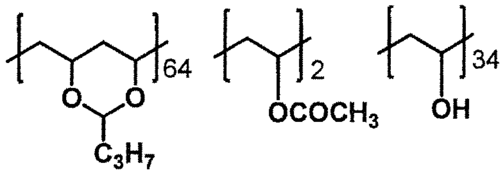

Binder polymer (4):

(Weight average molecular weight:80,000)

(Molar ratio is 64:2:34)

[Formation of photosensitive layer 5]

A coating solution for photosensitive layer (5) prepared as described below was applied using a bar coater on the primer layer described above, and then dried in an oven at 100 °C for 60 seconds to form photosensitive layer 5 having a coating mass of 1.0 g/$m^2$ after drying.

<Coating solution for photosensitive layer (5)>

This solution was prepared in the same manner as for the preparation of the coating solution for photosensitive layer (1) except that an equivalent amount of the binder polymer (2) was added in place of the binder polymer (1) in the preparation of the coating solution for photosensitive layer (1).

[Formation of photosensitive layer 6]

A coating solution for photosensitive layer (6) prepared as described below was applied using a bar coater on the primer layer described above, and then dried in an oven at 100 °C for 60 seconds to form photosensitive layer 6 having a coating mass of 1.0 g/$m^2$ after drying.

<Coating solution for photosensitive layer (6)>

This solution was prepared in the same manner as for the preparation of the coating solution for photosensitive layer (1) except that an equivalent amount of the polymerizable compound (1) was added in place of the polymerizable compound (2) in the preparation of the coating solution for photosensitive layer (1).

[Formation of photosensitive layer 7]

A coating solution for photosensitive layer (7) prepared as described below was applied using a bar coater on the primer layer described above, and then dried in an oven at 100 °C for 60 seconds to form photosensitive layer 7 having a coating mass of 1.0 g/$m^2$ after drying.

<Coating solution for photosensitive layer (7)>

This solution was prepared in the same manner as for the preparation of the coating solution for photosensitive layer (1) except that an equivalent amount of the polymerizable compound (3) shown below was added in place of the polymerizable compounds (1) and (2) in the preparation of the coating solution for photosensitive layer (1).

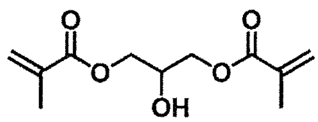

Polymerizable compound (3)

[Formation of photosensitive layer 8]

A coating solution for photosensitive layer (8) prepared as described below was applied using a bar coater on the primer layer described above, and then dried in an oven at 100 °C for 60 seconds to form photosensitive layer 8 having a coating mass of 1.0 g/$m^2$ after drying.

<Coating solution for photosensitive layer (8)>

This solution was prepared in the same manner as for the preparation of the coating solution for photosensitive layer (1) except that the binder polymer (2) was replaced by the binder polymer (5) shown below in the coating solution for photosensitive layer (1).

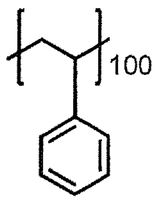

Binder polymer (5)

[Formation of photosensitive layer 9]

A coating solution for photosensitive layer (9) prepared as described below was applied using a bar coater on the primer layer described above, and then dried in an oven at 100 °C for 60 seconds to form photosensitive layer 9 having a coating mass of 1.0 g/m$^2$ after drying.

<Coating solution for photosensitive layer (9)>

This solution was prepared in the same manner as for the preparation of the coating solution for photosensitive layer (2) except that the binder polymer (2) was replaced by the binder polymer (5) in the coating solution for photosensitive layer (2).

[Formation of photosensitive layer 10]

A coating solution for photosensitive layer (10) prepared as described below was applied using a bar coater on the primer layer described above, and then dried in an oven at 100 °C for 60 seconds to form photosensitive layer 10 having a coating mass of

<Coating solution for photosensitive layer 10>

This solution was prepared in the same manner as for the preparation of the coating solution for photosensitive layer (1) except that an equivalent amount of the polymerizable compound (4) shown below was added in place of the polymerizable compounds (1) and (2) in the coating solution for photosensitive layer (1).

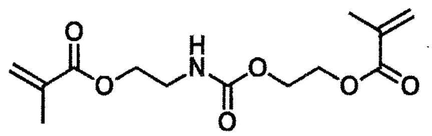

Polymerizable compound (4)

[Formation of photosensitive layer 11]

A coating solution for photosensitive layer (11) prepared as described below was applied using a bar coater on the primer layer described above, and then dried in an oven at 100 °C for 60 seconds to form photosensitive layer 11 having a coating mass of 1.0 g/m$^2$ after drying.

<Coating solution for photosensitive layer 11>

This solution was prepared in the same manner as for the preparation of the coating solution for photosensitive layer (1) except that an equivalent amount of the polymerizable compound (5) shown below was added in place of the polymerizable compounds (1) and (2) in the coating solution for photosensitive layer (1).

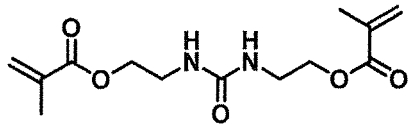

Polymerizable compound (5)

[Formation of photosensitive layer 12]

The coating solution was prepared in the same manner as for the preparation of the coating solution for photosensitive layer (1) except that an equivalent amount of the polymerizable compound (4) was added in place of the binder polymers in the coating solution for photosensitive layer (1).

<Formation of protective layer 1>

A coating solution for protective layer (1) having the composition shown below was applied using a bar coater on each of the photosensitive layers described above, and then dried at 125 °C for 70 seconds to form a protective layer.

Coating solution for protective layer (1)

- PVA-205 0.658 g (Partially hydrolyzed polyvinyl alcohol from KURARAY CO., LTD. , having a degree of saponification of 86.5 to 89.5 mol %, and a viscosity of 4.6 to 5.4 mPa.s (in an aqueous solution of 4 % by weight at 20 °C))
- PVA-105 0.142 g (Fully hydrolyzed polyvinyl alcohol from KURARAY CO., LTD., having a degree of saponification of 98.0 to 99.0 mol %, and a viscosity of 5.2 to 6.0 mPa.s (in an aqueous solution of 4 % by weight at 20 °C))
- Poly(vinylpyrrolidone/vinyl acetate (1/1)) (molecular weight: 70,000) 0.001 g
- Surfactant (EMALEX 710 from Nihon Emulsion Co., Ltd.) 0.002 g
- Water 13 g

2. Preparation of lithographic printing plate precursor C-1

A photosensitive layer was formed from the coating solution for photosensitive layer (1) described above on the support 2 described below, and further the protective layer 1 described above was formed on it to prepare lithographic printing plate precursor C-1.

< Preparation of support 2>

An aluminum plate having a thickness of 0.24 mm (grade 1050, temper H16) was degreased by immersion in an aqueous solution of 5 % sodium hydroxide kept at 65 °C for 1 minute, and then washed with water. This degreased aluminum plate was neutralized by immersion in an aqueous solution of 10 % hydrochloric acid kept at 25 °C for 1 minute, and then washed with water. Then, this aluminum plate was subjected to an electrolytic surface-roughening treatment using AC at a current density of 100 $A/dm^2$ in an aqueous solution of 0.3 % by weight of hydrochloric acid at 25 °C for 60 seconds, and then desmutted in an aqueous solution of 5 % sodium hydroxide kept at 60 °C for 10 seconds. The surface-roughened and desmutted aluminum plate was subjected to an anodization treatment in an aqueous solution of 15 % sulfuric acid at 25 °C under conditions of a current density of 10 $A/dm^2$ and a voltage of 15 V for 1 minute to prepare a support.

Table 1

| Lithographic printing plate | Coating solution for photosensitive layer | Type of (C) binder polymer | Amount of (C) binder polymer /g | (D) Condensation crosslinkers | Amount of (D) /g |
|---|---|---|---|---|---|
| A-1 | 1 | Binder polymer (2) | 0.19 | D-103 | 0.03 |
| A-2 | 1 | Binder polymer (2) | 0.19 | D-105 | 0.03 |

(continued)

| Lithographic printing plate | Coating solution for photosensitive layer | Type of (C) binder polymer | Amount of (C) binder polymer /g | (D) Condensation crosslinkers | Amount of (D) /g |
|---|---|---|---|---|---|
| A-3 | 1 | Binder polymer (2) | 0.19 | D-106 | 0.03 |
| A-4 | 1 | Binder polymer (2) | 0.19 | D-107 | 0.03 |
| A-5 | 1 | Binder polymer (2) | 0.19 | D-110 | 0.03 |
| A-6 | 1 | Binder polymer (2) | 0.19 | D-201 | 0.03 |
| A-7 | 1 | Binder polymer (2) | 0.19 | D-203 | 0.03 |
| A-8 | 1 | Binder polymer (2) | 0.19 | D-301 | 0.03 |
| A-9 | 1 | Binder polymer (2) | 0.19 | U-VAN 228 | 0.03 |
| A-10 | 1 | Binder polymer (2) | 0.19 | U-VAN 10S60 | 0.03 |
| A-11 | 1 | Binder polymer (2) | 0.19 | D-401 | 0.03 |
| A-12 | 1 | Binder polymer (2) | 0.19 | D-402 | 0.03 |
| A-13 | 1 | Binder polymer (2) | 0.19 | D-407 | 0.03 |
| A-14 | 1 | Binder polymer (2) | 0.19 | EPICLON 850-LC | 0.03 |
| A-15 | 1 | Binder polymer (2) | 0.19 | EPICLON N-695 | 0.03 |
| A-16 | 1 | Binder polymer (2) | 0.19 | EPICLON 830 | 0.03 |
| A-17 | 1 | Binder polymer (2) | 0.19 | EPICLON 153 | 0.03 |
| A-18 | 1 | Binder polymer (2) | 0.19 | EPICLON EXA-8183 | 0.03 |
| A-19 | 1 | Binder polymer (2) | 0.19 | YX4000 | 0.03 |
| A-20 | 1 | Binder polymer (2) | 0.19 | D-501 | 0.03 |
| A-21 | 1 | Binder polymer (2) | 0.19 | D-502 | 0.03 |
| A-22 | 1 | Binder polymer (2) | 0.19 | D-509 | 0.03 |
| A-23 | 1 | Binder polymer (2) | 0.19 | D-513 | 0.03 |

(continued)

| Lithographic printing plate | Coating solution for photosensitive layer | Type of (C) binder polymer | Amount of (C) binder polymer /g | (D) Condensation crosslinkers | Amount of (D) /g |
|---|---|---|---|---|---|
| A-24 | 1 | Binder polymer (2) | 0.19 | D-518 | 0.03 |
| A-25 | 1 | Binder polymer (2) | 0.19 | PHENOLITE TD-2090 | 0.03 |
| A-26 | 1 | Binder polymer (2) | 0.19 | PHENOLITE KH-6021 | 0.03 |
| A-27 | 1 | Binder polymer (2) | 0.19 | PHENOLITE KA-1165 | 0.03 |
| A-28 | 1 | Binder polymer (2) | 0.19 | PHENOLITE PR-100 | 0.03 |
| A-29 | 1 | Binder polymer (2) | 0.19 | PHENOLITE PR-110 | 0.03 |
| A-30 | 1 | Binder polymer (2) | 0.19 | PHENOLITE FG-1020 | 0.03 |
| A-31 | 1 | Binder polymer (2) | 0.19 | PHENOLITE AH-5600 | 0.03 |
| A-32 | 1 | Binder polymer (2) | 0.19 | Tetraisopropyl titanate | 0.03 |
| A-33 | 1 | Binder polymer (2) | 0.19 | Tetramethoxysilane | 0.03 |
| A-34 | 1 | Binder polymer (2) | 0.19 | Phosphoric acid | 0.03 |
| A-35 | 1 | Binder polymer (2) | 0.19 | Ethyl phosphite | 0.03 |
| A-36 | 1 | Binder polymer (2) | 0.19 | D-602 | 0.03 |
| A-37 | 1 | Binder polymer (2) | 0.19 | D-605 | 0.03 |
| A-38 | 3 | Binder polymer (3) | 0.19 | PHENOLITE KA-1165 | 0.03 |
| A-39 | 4 | Binder polymer (4) | 0.19 | PHENOLITE KA-1165 | 0.03 |
| A-40 | 5 | Binder polymer (2) | 0.19 | PHENOLITE KA-1165 | 0.03 |
| A-41 | 6 | Binder polymer (2) | 0.19 | PHENOLITE KA-1165 | 0.03 |
| A-42 | 7 | Binder polymer (2) | 0.19 | PHENOLITE KA-1165 | 0.03 |
| A-43 | 1 | Binder polymer (2) | 0.163 | PHENOLITE KA-1 165 | 0.057 |
| A-44 | 1 | Binder polymer (2) | 0.142 | PHENOLITE KA-1165 | 0.078 |

(continued)

| Lithographic printing plate | Coating solution for photosensitive layer | Type of (C) binder polymer | Amount of (C) binder polymer /g | (D) Condensation crosslinkers | Amount of (D) /g |
|---|---|---|---|---|---|
| A-45 | 1 | Binder polymer (2) | 0.126 | PHENOLITE KA-1165 | 0.094 |
| A-46 | 1 | Binder polymer (2) | 0.126 | PHENOLITE KA-1165 | 0.015 |
| | | | | D-401 | 0.015 |
| A-47 | 10 | Binder polymer (2) | 0.19 | PHENOLITE KA-1165 | 0.03 |
| A-48 | 11 | Binder polymer (2) | 0.19 | PHENOLITE KA-1165 | 0.03 |
| A-49 | 12 | Non | 0 | PHENOLITE KA-1165 | 0.22 |
| H-1 | 1 | Binder polymer (2) | 0.19 | Non | |
| H-2 | 8 | Binder polymer (5) | 0.19 | PHENOLITE KA-1165 | 0.03 |
| H-3 | 1 | Binder polymer (2) | 0.19 | Non | |
| C-1 | 1 | Binder polymer (2) | 0.19 | PHENOLITE KA-1165 | 0.03 |

Table 2

| Lithographic printing plate | Coating solution for photosensitive layer | Type of (C) binder polymer | Amount of (C) binder polymer /g | (D) Condensation crosslinkers | Amount of (D) /g |
|---|---|---|---|---|---|
| B-1 | 2 | Binder polymer (2) | 0.19 | D-103 | 0.03 |
| B-2 | 2 | Binder polymer (2) | 0.19 | D-107 | 0.03 |
| B-3 | 2 | Binder Dolvmer (2) | 0.19 | D-110 | 0.03 |
| B-4 | 2 | Binder polymer (2) | 0.19 | D-203 | 0.03 |
| B-5 | 2 | Binder polymer (2) | 0.19 | U-VAN 228 | 0.03 |
| B-6 | 2 | Binder polymer (2) | 0.19 | U-VAN 10S60 | 0.03 |
| B-7 | 2 | Binder polymer (2) | 0.19 | D-401 | 0.03 |
| B-8 | 2 | Binder polymer (2) | 0.19 | EPICLON 850-LC | 0.03 |
| B-9 | 2 | Binder polymer (2) | 0.19 | EPICLON N-695 | 0.03 |

(continued)

| Lithographic printing plate | Coating solution for photosensitive layer | Type of (C) binder polymer | Amount of (C) binder polymer /g | (D) Condensation crosslinkers | Amount of (D) /g |
|---|---|---|---|---|---|
| B-10 | 2 | Binder polymer (2) | 0.19 | EPICLON 830 | 0.03 |
| B-11 | 2 | Binder polymer (2) | 0.19 | EPICLON 153 | 0.03 |
| B-12 | 2 | Binder polymer (2) | 0.19 | YX4000 | 0.03 |
| B-13 | 2 | Binder polymer (2) | 0.19 | D-509 | 0.03 |
| B-14 | 2 | Binder polymer (2) | 0.19 | PHENOLITE TD-2090 | 0.03 |
| B-15 | 2 | Binder polymer (2) | 0.19 | PHENOLITE KH-6021 | 0.03 |
| B-16 | 2 | Binder polymer (2) | 0.19 | PHENOLITE KA-1165 | 0.03 |
| B-17 | 2 | Binder polymer (2) | 0.19 | PHENOLITE PR-100 | 0.03 |
| B-18 | 2 | Binder polymer (2) | 0.19 | PHENOLITE AH-5600 | 0.03 |
| B-19 | 2 | Binder polymer (2) | 0.19 | D-602 | 0.03 |
| B-20 | 2 | Binder polymer (2) | 0.19 | D-605 | 0.03 |
| B-21 | 2 | Binder polymer (2) | 0.126 | PHENOLITE KA-1165 | 0.015 |
| | | | | D-401 | 0.015 |
| H-4 | 2 | Binder polymer (2) | 0.19 | Non | |
| H-5 | 9 | Binder polymer (5) | 0.19 | PHENOLITE KA-1165 | 0.03 |
| H-6 | 1 | Binder polymer (2) | 0.19 | Non | |

The condensation crosslinkers (D) in Tables 1 and 2 represent the following compounds respectively.

- U-VAN 228: a melamine resin from Mitsui Chemicals, Inc.
- U-VAN 10S60: a urea resin from Mitsui Chemicals, Inc.
- EPICLON 850-LC: a bisphenol A epoxy resin from DIC Corporation
- EPICLON N-695: a cresol novolac epoxy resin from DIC Corporation
- EPICLON 830: a bisphenol F epoxy resin from DIC Corporation
- EPICLON 153: a tetrabromobisphenol A epoxy resin from DIC Corporation
- YX4000: an epoxy resin from Mitsubishi Chemical Corporation
- PHENOLITE TD-2090: a phenol novolac resin from DIC Corporation
- PHENOLITE KH-6021: a bisphenol novolac resin from DIC Corporation
- PHENOLITE KA-1165: a cresol novolac resin from DIC Corporation
- PHENOLITE PR-100: a phenol resin (Mw: 13000 to 15000) from DIC Corporation

- PHENOLITE PR-110: a phenol resin (Mw: 7500 to 8500) from DIC Corporation
- PHENOLITE FG-1020: a resol resin from DIC Corporation
- PHENOLITE AH-5600: a resol resin from DIC Corporation

D-103 (Terephthalaldehyde manufactured from Tokyo Chemical Industry Co., Ltd.):

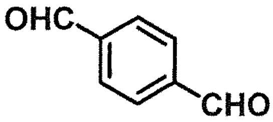

D-105

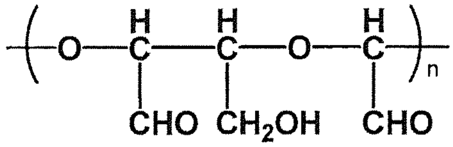

n=20

D-106

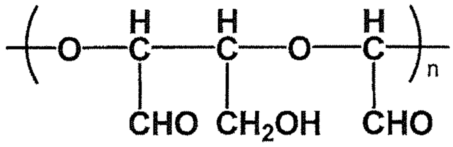

n=50

D-107

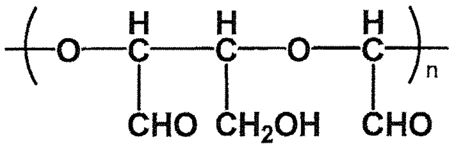

n=100

D-110

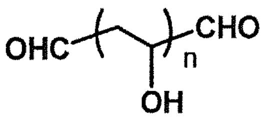

n=300

D-201 (N,N'-Dimethylolurea manufactured from Tokyo Chemical Industry Co., Ltd.):

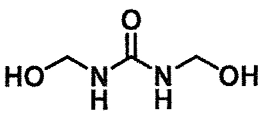

D-301 (Divinyl sulfone manufactured from Tokyo Chemical Industry Co., Ltd.):

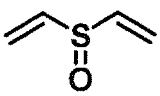

D-401

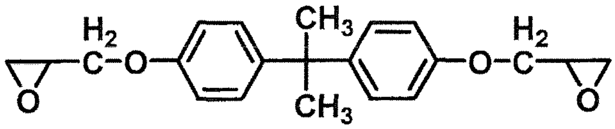

D-402

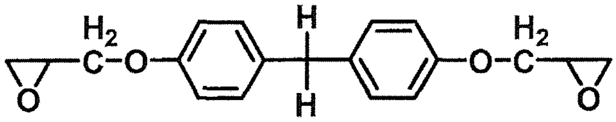

D-407

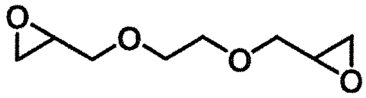

D-501 (Glyoxylic acid manufactured from Tokyo Chemical Industry Co., Ltd.):

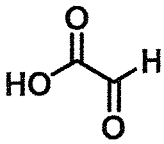

D-502 (Phthalic anhydride manufactured from Tokyo Chemical Industry Co., Ltd.):

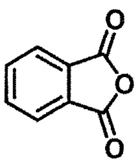

D-509 (Pyromellitic anhydride manufactured from Tokyo Chemical Industry Co., Ltd.):

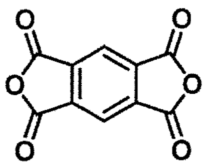

D-513 (Terephthalic acid manufactured from Tokyo Chemical Industry Co., Ltd.):

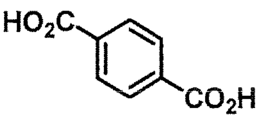

D-518 (3,3',4,4'-benzophenonetetracarboxylic dianhydride manufactured from Tokyo Chemical Industry Co., Ltd.):

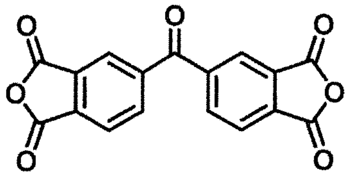

D-602

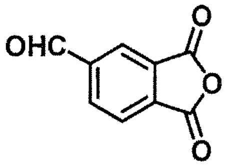

D-605 (Vinylphosphonic acid manufactured from Tokyo Chemical Industry Co., Ltd.):

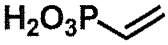

D-203

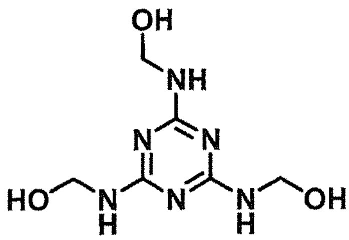

Synthesis of D-203:

This compound was isolated as a crystal having a melting point of 156 °C containing 2 mol of water of crystallization after 10 g of melamine and 19.2 g of formaldehyde were mixed in 5 g of water and the mixture was adjusted to PH 8.5 and allowed to stand at 15 °C for 15 hours.

2. Evaluation of the lithographic printing plate precursors

(1) Exposure, development and printing

The lithographic printing plate precursors described above were imagewise exposed using Violet semiconductor laser platesetter Vx9600 (incorporating an InGaN semiconductor laser (emission wavelength 405 nm ± 10 nm / output 30 mW)) from FUJIFILM Electronic Imaging Ltd. Imaging was performed at an intended 50 % tint using an FM screen (TAFFETA 20) from Fujifilm Corporation at a resolution of 2438 dpi and a surface exposure dose of 0.05 mJ/cm$^2$.

Then, the plate precursors were preheated at 100 °C for 10 seconds, and then the image was developed using developer (1) having the composition shown below in an automatic developing machine having a structure as shown in Figure 1 at a feed speed that allows an immersion time in the developer (developing time) of 20 seconds. When developer (2) (PL-10 from AGFA) was used, the plate precursors were washed with water before the drying step after development.

<Developer 1>

- Water 88.6 g
- Nonionic surfactant (W-1) 2.4 g
- Nonionic surfactant (W-2) 2.4 g
- Nonionic surfactant (EMALEX 710 from Nihon Emulsion Co., Ltd.) 1.0 g
- Phenoxypropanol 1.0 g
- Octanol 0.6 g
- N-(2-hydroxyethyl)morpholine 1.0 g
- Triethanolamine 0.5 g
- Sodium gluconate 1.0 g
- Trisodium citrate 0.5 g
- Tetrasodium ethylenediaminetetraacetate 0.05 g
- Polystyrene sulfonate (Versa TL77 (a 30 % solution) from Alco Chemical) 1.0 g

*The developer having the composition shown above was adjusted to pH 7.0 by adding phosphoric acid.

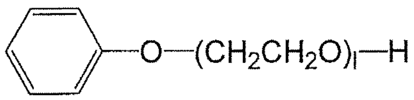

l=13-28

(W-1)

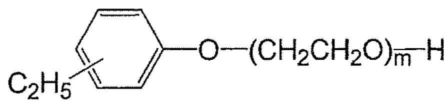

m=12-26

(W-2)

The lithographic printing plates obtained were mounted on the printing press SOR-M from Heidelberg Printing Machines AG to perform printing with a dampening water (EU-3 (an etching solution from Fujifilm Corporation) / water / isopropyl alcohol = 1/89/10 (volume ratio)) and TRANS-G(N) black ink (from DIC Corporation) at a printing speed of 6000 sheets/hr.

[Evaluation]

Each lithographic printing plate precursor was evaluated for printing durability, staining resistance, staining resistance over time and developability as described below. The results are shown in the tables below.

<Printing durability>

As the number of prints increased, the ink density on printing paper decreased because the photosensitive layer gradually wore and lost its ink receptivity. In each printing plate exposed at the same exposure dose, printing durability was evaluated by determining the number of prints when the ink density (reflection density) decreased by 0.1 as compared with the density at the start of printing. The evaluation of printing durability was reported as the relative printing durability defined below using Comparative examples 1 and 4 as references (100). Higher values of the relative printing durability indicate higher printing durability.

Relative printing durability = (Printing durability of test lithographic printing plate precursor) / (Printing durability of reference lithographic printing plate precursor).

<Staining resistance>

After printing was started, the 20th print was sampled to evaluate staining resistance by determining the density of the ink deposited on non-image areas. Ink deposition on non-image areas was reported as a score of visual evaluation per 75 $cm^2$ because it does not always occur uniformly. Scores of visual evaluation were assigned according to ink-deposited area fractions in non-image areas as follows: score 10: 0 %; score 9: more than 0 % and 10 % or less; score 8: more than 10 % and 20 % or less; score 7: more than 20 % and 30 % or less; score 6: more than 30 % and 40 % or less; score 5: more than 40 % and 50 % or less; score 4: more than 50 % and 60 % or less; score 3: more than 60 %

and 70 % or less; score 2: more than 70 % and 80 % or less; score 1: more than 80% and 90 % or less; and score 0: more than 90 %. Higher scores indicate better staining resistance.

<Chemical resistance>

A solution for testing chemical resistance having the composition shown below was dropped on image areas (dot area fraction 50 %) of each printing plate exposed at the same exposure dose, and the dropped solution was wiped off after a predetermined period. A piece of Scotch brand tape (from 3M) was attached to the region where the solution had been dropped, and then the tape was removed, and chemical resistance was evaluated on a relative basis by visually assessing the decrease in dot area fraction. Chemical resistance was visually evaluated, and rated on a scale of 1 to 10, where 10 is best. Higher scores indicate better chemical resistance.

(Solution for testing chemical resistance)

- Butyl diglycol 190.0 g
- Butyl glycol 140.0 g
- Malic acid 15.0 g
- Citric acid 8.0 g
- Sodium hydroxide 24.0 g
- Ammonium nitrate 15.0 g
- Distilled water 608.0 g

<Scratch resistance>

The 20 lithographic printing plates obtained were stacked without interleaving paper to form a stack. This stack was superposed on the same lithographic printing plate precursor to protrude over its edge by 5 cm, and then forced to horizontally slide on the lithographic printing plate precursor in such a way that the bottom of the support of the lowermost plate of the stacked 20 plates might rub the surface of a specific image layer of the lithographic printing plate precursor until the protruding edges of the 20 plates (stack) were flush with the edge of the precursor. This plate material having the surface of a specific protective layer rubbed by the bottom of the support was used as a plate material for evaluating scratch resistance. The resulting lithographic printing plate was visually evaluated for scratches generated in a tint image. An organoleptic evaluation was performed on a scale of 1 to 5, where 3 was the marginally acceptable level for practical use and 2 or less were unacceptable levels for practical use.

<Ink adhesion>

After printing is started, the ink gradually adheres to the image-recording layer, whereby the ink density on paper increases. Ink adhesion was determined by measuring the number of prints when the ink density reached a standard print density. Evaluation was performed on a scale of 1 to 4, where 4 corresponds to 12 prints or less, 3 corresponds to 14 prints or less, 2 corresponds to 20 prints or less, and 1 corresponds to 25 prints or more.

<Developability>

The developing step described above was performed at varying feed speeds, and the cyan density in non-image areas of the resulting lithographic printing plate was measured by a MacBeth densitometer. Developability was evaluated by determining the feed speed when the cyan density in non-image areas equaled to the cyan density in the aluminum support. The evaluation of developability was reported as the relative developability defined below using Comparative examples 1 and 4 as references (100). Higher values of the relative developability indicate higher developability and better performance.

Relative developability = (Feed speed of test lithographic printing plate precursor) / (Feed speed of reference lithographic printing plate precursor).

Table 3

| | Lithographic printing plate | Developer | Printing durability | Scratch resistance | Chemical resistance | Staining resistance | Ink adhesion | Developability |
|---|---|---|---|---|---|---|---|---|
| Example 1 | A-1 | 1 | 125 | 3 | 7 | 9 | 3 | 105 |
| Example 2 | A-2 | 1 | 135 | 4 | 7 | 9 | 3 | 105 |
| Example 3 | A-3 | 1 | 130 | 4 | 7 | 9 | 3 | 100 |
| Example 4 | A-4 | 1 | 130 | 4 | 7 | 9 | 3 | 100 |
| Example 5 | A-5 | 1 | 130 | 5 | 6 | 9 | 3 | 100 |
| Example 6 | A-6 | 1 | 140 | 4 | 7 | 9 | 3 | 105 |
| Example 7 | A-7 | 1 | 135 | 5 | 7 | 9 | 4 | 100 |
| Example 8 | A-8 | 1 | 120 | 3 | 7 | 9 | 3 | 100 |
| Example 9 | A-9 | 1 | 145 | 5 | 10 | 9 | 4 | 105 |
| Example 10 | A-10 | 1 | 150 | 5 | 7 | 9 | 4 | 105 |
| Example 11 | A-11 | 1 | 140 | 4 | 8 | 9 | 4 | 105 |
| Example 12 | A-12 | 1 | 135 | 5 | 7 | 9 | 4 | 110 |
| Example 13 | A-13 | 1 | 135 | 5 | 8 | 9 | 4 | 105 |
| Example 14 | A-14 | 1 | 180 | 5 | 10 | 10 | 4 | 110 |
| Example 15 | A-15 | 1 | 180 | 5 | 10 | 10 | 4 | 110 |
| Example 16 | A-16 | 1 | 180 | 5 | 10 | 10 | 4 | 105 |
| Example 17 | A-17 | 1 | 165 | 5 | 10 | 9 | 4 | 105 |
| Example 18 | A-18 | 1 | 160 | 4 | 9 | 9 | 4 | 100 |
| Example 19 | A-19 | 1 | 185 | 5 | 10 | 10 | 4 | 105 |
| Example 20 | A-20 | 1 | 130 | 5 | 9 | 9 | 3 | 100 |
| Example 21 | A-21 | 1 | 140 | 4 | 7 | 9 | 4 | 110 |
| Example 22 | A-22 | 1 | 155 | 5 | 8 | 9 | 4 | 105 |
| Example 23 | A-23 | 1 | 130 | 4 | 8 | 9 | 4 | 105 |
| Example 24 | A-24 | 1 | 150 | 5 | 9 | 9 | 4 | 105 |
| Example 25 | A-25 | 1 | 190 | 5 | 10 | 9 | 4 | 105 |

(continued)

| | Lithographic printing plate | Developer | Printing durability | Scratch resistance | Chemical resistance | Staining resistance | Ink adhesion | Developability |
|---|---|---|---|---|---|---|---|---|
| Example 26 | A-26 | 1 | 160 | 5 | 9 | 10 | 4 | 105 |
| Example 27 | A-27 | 1 | 190 | 5 | 10 | 10 | 4 | 110 |
| Example 28 | A-28 | 1 | 175 | 4 | 9 | 9 | 4 | 105 |
| Example 29 | A-29 | 1 | 170 | 5 | 10 | 9 | 4 | 105 |
| Example 30 | A-30 | 1 | 175 | 5 | 9 | 9 | 4 | 100 |
| Example 31 | A-31 | 1 | 155 | 5 | 9 | 9 | 4 | 100 |
| Example 32 | A-32 | 1 | 140 | 4 | 8 | 9 | 4 | 110 |
| Example 33 | A-33 | 1 | 130 | 4 | 7 | 9 | 3 | 105 |
| Example 34 | A-34 | 1 | 125 | 5 | 7 | 9 | 3 | 105 |
| Example 35 | A-35 | 1 | 135 | 5 | 8 | 9 | 3 | 100 |
| Example 36 | A-36 | 1 | 125 | 4 | 7 | 9 | 3 | 105 |
| Example 37 | A-37 | 1 | 120 | 3 | 6 | 9 | 3 | 100 |
| Example 38 | A-38 | 1 | 180 | 5 | 10 | 10 | 4 | 110 |
| Example 39 | A-39 | 1 | 170 | 5 | 10 | 9 | 4 | 105 |
| Example 41 | A-41 | 1 | 155 | 4 | 8 | 9 | 3 | 105 |
| Example 42 | A-42 | 1 | 145 | 4 | 8 | 9 | 3 | 105 |
| Example 43 | A-43 | 1 | 170 | 5 | 10 | 10 | 4 | 110 |
| Example 44 | A-44 | 1 | 150 | 4 | 9 | 10 | 4 | 105 |
| Example 45 | A-45 | 1 | 140 | 4 | 8 | 10 | 3 | 105 |
| Example 46 | A-46 | 1 | 150 | 5 | 9 | 10 | 4 | 105 |
| Example 91 | A-47 | 1 | 180 | 3 | 9 | 10 | 4 | 105 |
| Example 92 | A-48 | 1 | 175 | 3 | 9 | 10 | 4 | 105 |
| Comparative example 1 | H-1 | 1 | 100 | 2 | 5 | 7 | 2 | 100 |

(continued)

| | Lithographic printing plate | Developer | Printing durability | Scratch resistance | Chemical resistance | Staining resistance | Ink adhesion | Developability |
|---|---|---|---|---|---|---|---|---|
| Comparative example 2 | H-2 | 1 | 60 | 1 | 2 | 6 | 1 | 50 |
| Comparative example 3 | H-3 | 1 | 60 | 1 | 2 | 6 | 1 | 50 |
| Comparative example 4 | A-40 | 1 | 110 | 3 | 6 | 7 | 2 | 105 |
| Comparative example 5 | A-49 | 1 | 115 | 3 | 5 | 4 | 2 | 50 |
| Example 93 | C-1 | 1 | 170 | 5 | 9 | 7 | 4 | 70 |

Table 4

| | Lithographic printing plate | Developer | Printing durability | Scratch resistance | Chemical resistance | Staining resistance | Ink adhesion | Developability |
|---|---|---|---|---|---|---|---|---|
| Example 47 | A-9 | 2 | 145 | 4 | 8 | 8 | 4 | 105 |
| Example 48 | A-10 | 2 | 150 | 4 | 8 | 8 | 4 | 105 |
| Example 49 | A-14 | 2 | 175 | 5 | 10 | 9 | 4 | 110 |
| Example 50 | A-15 | 2 | 180 | 5 | 10 | 9 | 4 | 110 |
| Example 51 | A-16 | 2 | 170 | 4 | 10 | 10 | 4 | 110 |
| Example 52 | A-19 | 2 | 185 | 5 | 10 | 10 | 4 | 110 |
| Example 53 | A-25 | 2 | 175 | 4 | 10 | 10 | 4 | 110 |
| Example 54 | A-27 | 2 | 180 | 5 | 10 | 10 | 4 | 110 |
| Comparative example 7 | H-1 | 2 | 55 | 1 | 5 | 7 | 2 | 100 |

The tables above show that printing durability, chemical resistance, scratch resistance, and ink adhesion can be improved while retaining developability and staining resistance when the photosensitive layer comprises at least (C) a resin comprising a polyvinyl acetal containing one hydroxyl group, (D) a crosslinker capable of reacting with at least one of the hydroxyl group and acid group in the polyvinyl acetal to form a crosslink, and (E) a (meth) acrylic resin.

(2) Exposure, development and printing

Various lithographic printing plate precursors shown below were imagewise exposed at an intended 50 % tint using Trendsetter 3244VX (incorporating a water-cooled 40W infrared semiconductor laser (830 nm)) from Creo under conditions of an output power of 9 W, an external drum rotational speed of 210 rpm, and a resolution of 2,400 dpi. Then, the image was developed using each developer in an automatic developing machine having the structure shown in Figure 2 with heater settings that allow the plate surface to reach a temperature of 100 °C in the preheating section and at a feed speed that allows an immersion time in the developer (developing time) of 20 seconds. When developer 2 was used, the plate precursors were washed with water before the drying step after development.

The lithographic printing plates obtained were mounted on the printing press SOR-M from Heidelberg Printing Machines AG to perform printing with a dampening water (EU-3 (an etching solution from Fujifilm Corporation) / water / isopropyl alcohol = 1/89/10 (volume ratio)) and TRANS-G(N) black ink (from DIC Corporation) at a printing speed of 6000 sheets/hr.

Each lithographic printing plate precursor was evaluated for printing durability, staining resistance, chemical resistance, scratch resistance, ink adhesion, and developability in the same manner as in Example 1. The evaluation of printing durability and developability was performed by using Comparative examples 5 and 8 as references (100). The results are shown in the tables below.

Table 5

| | Lithographic printing plate | Developer | Printing durability | Scratch resistance | Chemical resistance | Staining resistance | Ink adhesion | Developability |
|---|---|---|---|---|---|---|---|---|
| Example 55 | B-1 | 1 | 110 | 4 | 8 | 7 | 3 | 105 |
| Example 56 | B-2 | 1 | 120 | 4 | 8 | 8 | 3 | 105 |
| Example 57 | B-3 | 1 | 115 | 4 | 8 | 8 | 3 | 105 |
| Example 58 | B-4 | 1 | 120 | 4 | 9 | 8 | 4 | 105 |
| Example 59 | B-5 | 1 | 135 | 4 | 10 | 9 | 4 | 105 |
| Example 60 | B-6 | 1 | 135 | 4 | 10 | 9 | 4 | 105 |
| Example 61 | B-7 | 1 | 130 | 4 | 9 | 8 | 3 | 105 |
| Example 62 | B-8 | 1 | 165 | 5 | 10 | 10 | 4 | 110 |
| Example 63 | B-9 | 1 | 170 | 5 | 10 | 10 | 4 | 105 |
| Example 64 | B-10 | 1 | 165 | 5 | 10 | 10 | 4 | 110 |
| Example 65 | B-11 | 1 | 150 | 5 | 9 | 10 | 4 | 105 |
| Example 66 | B-12 | 1 | 170 | 5 | 10 | 9 | 4 | 110 |
| Example 67 | B-13 | 1 | 140 | 4 | 9 | 9 | 4 | 105 |
| Example 68 | B-14 | 1 | 170 | 5 | 10 | 10 | 4 | 105 |
| Example 69 | B-15 | 1 | 155 | 4 | 9 | 10 | 4 | 105 |
| Example 70 | B-16 | 1 | 170 | 5 | 10 | 10 | 4 | 105 |
| Example 71 | B-17 | 1 | 150 | 5 | 9 | 10 | 4 | 105 |
| Example 72 | B-18 | 1 | 130 | 5 | 10 | 10 | 4 | 105 |
| Example 73 | B-19 | 1 | 110 | 4 | 8 | 7 | 3 | 105 |
| Example 74 | B-20 | 1 | 110 | 4 | 7 | 7 | 3 | 105 |
| Example 75 | B-21 | 1 | 130 | 5 | 10 | 9 | 4 | 110 |
| Comparative example 8 | H-4 | 1 | 100 | 2 | 5 | 6 | 2 | 100 |
| Comparative example 9 | H-5 | 1 | 60 | 1 | 2 | 6 | 1 | 50 |

(continued)

| | Lithographic printing plate | Developer | Printing durability | Scratch resistance | Chemical resistance | Staining resistance | Ink adhesion | Developability |
|---|---|---|---|---|---|---|---|---|
| Comparative example 10 | H-6 | 1 | 60 | 1 | 2 | 6 | 1 | 50 |

Table 6

| | Lithographic printing plate | Developer | Printing durability | Scratch resistance | Chemical resistance | Staining resistance | Ink adhesion | Developability |
|---|---|---|---|---|---|---|---|---|
| Example 76 | B-4 | 2 | 130 | 4 | 8 | 7 | 3 | 105 |
| Example 77 | B-5 | 2 | 150 | 4 | 9 | 8 | 4 | 105 |
| Example 78 | B-6 | 2 | 155 | 4 | 9 | 8 | 4 | 105 |
| Example 79 | B-8 | 2 | 170 | 5 | 10 | 10 | 4 | 110 |
| Example 80 | B-9 | 2 | 170 | 5 | 10 | 10 | 4 | 105 |
| Example 81 | B-10 | 2 | 175 | 4 | 10 | 10 | 4 | 105 |
| Example 82 | B-13 | 2 | 145 | 4 | 9 | 8 | 4 | 105 |
| Example 83 | B-16 | 2 | 175 | 5 | 10 | 10 | 4 | 110 |
| Comparative example 11 | H-4 | 2 | 100 | 2 | 5 | 7 | 2 | 100 |

The tables above show that printing durability, chemical resistance, scratch resistance, and ink adhesion can be improved while retaining developability and staining resistance when the photosensitive layer comprises at least (C) a resin comprising a polyvinyl acetal containing one hydroxyl group, (D) a crosslinker capable of reacting with at least one of the hydroxyl group and acid group in the polyvinyl acetal to form a crosslink, and (E) a (meth) acrylic resin.

3. Exposure, development and printing

Various lithographic printing plate precursors shown in the table below were exposed using Luxel PLATESETTER T-6000III incorporating an infrared semiconductor laser from Fuj ifilm Corporation, under conditions of an external drum rotational speed of 1000 rpm, a laser output of 70 %, and a resolution of 2400 dpi. The image formed by exposure included solid areas and halftone areas produced by 20 μm dot FM screening.

The exposed lithographic printing plate precursors were mounted on the plate cylinder of the printing press LITHRONE 26 from KOMORI Corporation without developing the image. The image was developed on press with a dampening water consisting of Ecolity-2 (from Fujifilm Corporation) / tap water = 2/98 (volume ratio) and Values-G(N) black ink (from DIC Corporation) by supplying the dampening water and the ink according to the standard automatic print starting mode of LITHRONE 26, followed by printing on 100 sheets of Tokubishi Art paper (76.5 kg) at a printing speed of 10000 sheets/hr.

[Evaluation]

Each lithographic printing plate precursor was evaluated for printing durability, staining resistance, chemical resistance, scratch resistance, and ink adhesion in the same manner as in Example 1. The evaluation of printing durability was performed by using Comparative example 9 as reference (100). The results are shown in the table below. Further, on-press developability was determined as follows.

<On-press developability>

On-press developability was evaluated by determining the number of sheets of printing paper required to complete on-press development in non-image areas of the photosensitive layer on the printing press until the ink was no longer transferred to the non-image areas. Lower numbers of sheets for on-press development indicate better developability.

Table 7

| | Lithographic printing plate | Printing durability | Scratch resistance | Chemical resistance | Staining resistance | Ink adhesion | Numbers of sheets for on-press development |
|---|---|---|---|---|---|---|---|
| Example 83 | B-4 | 120 | 2 | 3 | 7 | 3 | 150 |
| Example 84 | B-5 | 140 | 3 | 3 | 8 | 4 | 125 |
| Example 85 | B-6 | 140 | 3 | 3 | 8 | 4 | 130 |
| Example 86 | B-8 | 160 | 5 | 4 | 10 | 4 | 80 |
| Example 87 | B-9 | 160 | 5 | 4 | 10 | 4 | 75 |
| Example 88 | B-10 | 165 | 5 | 4 | 10 | 4 | 75 |
| Example 89 | B-13 | 145 | 3 | 3 | 9 | 4 | 120 |
| Example 90 | B-16 | 165 | 5 | 5 | 10 | 4 | 75 |
| Comparative example 12 | H-4 | 100 | 1 | 2 | 7 | 2 | 200 |

The table above shows that printing durability, chemical resistance, scratch resistance, ink adhesion, and on-press developability can be improved while retaining developability and staining resistance when the photosensitive layer comprises at least (C) a resin comprising a polyvinyl acetal containing one hydroxyl group, (D) a crosslinker capable of reacting with at least one of the hydroxyl group and acid group in the polyvinyl acetal to form a crosslink, and (E) a (meth)acrylic resin.

LEGENDS

4: Lithographic printing plate precursor
6: Developing part
10: Drying part
16: Feed roller
20: Developer tank
22: Feed roller
24: Brush roller
26: Squeeze roller
28: Backup roller
36: Guide roller
38: Segmented roller

11: Feed path for lithographic printing plate precursor
100: Automatic developing machine
200: Preheating part
300: Developing part
400: Drying part
202: Casing
208: Heating chamber
210: Segmented roller
212: Inlet
214: Heater
216: Circulation fan
218: Outlet
304: Feed-in roller pair
306: Process tank
308: Developer tank

310: Outer panel
312: Feed-in slot
316: Submerged roller pair
318: Feed-out roller pair
322: Brush roller pair
324: Shield cover
326: Brush roller pair
330: Spray pipe
332: Partition panel
334: Feed-through slot
336: Liquid temperature sensor
338: Liquid level meter
332: Partition panel
342: Guide member
344: Guide roller
402: Support roller
404: Exit
406: Feed roller pair
408: Feed roller pair
410: Duct
412: Duct
414: Slit opening

50: External tank
51: Overflow vent
52: Upper limit indicator
53: Lower limit indicator
54: Filter part
55: Developer feed pump
C1: First circulation pipe
C2: Second circulation pipe
71: Tank for replenishing water
72: Water replenishing pump
C3: Third circulation pipe

**Claims**

1. A lithographic printing plate precursor comprising a support and a photosensitive layer on the support, wherein the photosensitive layer comprises (A) a polymerizable compound, (B) a polymerization initiator, (C) a polyvinyl acetal resin containing at least one hydroxyl group, (D) a crosslinker capable of reacting with at least one of the hydroxyl group and acid group in the polyvinyl acetal to form a crosslink, and (E) a (meth)acrylic resin.

2. The lithographic printing plate precursor according to claim 1, wherein the polyvinyl acetal resin (C) is a polyvinyl butyral resin.

3. The lithographic printing plate precursor according to claim 1 or 2, wherein 1 mol % or less of the crosslinker (D) capable of reacting with at least one of the hydroxyl group and acid group in the polyvinyl acetal to form a crosslink is a compound containing a polymerizable group having an ethylenically unsaturated bond.

4. The lithographic printing plate precursor according to any one of claims 1 to 3, wherein 1 mol % or less of structural units constituting the polyvinyl acetal resin (C) containing at least one hydroxyl group and acid group is a structural unit having an ethylenically unsaturated bond.

5. The lithographic printing plate precursor according to any one of claims 1 to 4, wherein the polymerizable compound (A) contains a urethane bond.

6. The lithographic printing plate precursor according to any one of claims 1 to 5, wherein the polymerizable compound (A) contains a urea bond.

7. The lithographic printing plate precursor according to any one of claims 1 to 6, wherein the polyvinyl acetal resin containing at least one hydroxyl group (C) is a modified polyvinyl butyral resin.

8. The lithographic printing plate precursor according to claim 7, wherein the modified polyvinyl acetal resin is polyvinyl butyral modified with trimellitic acid.

9. The lithographic printing plate precursor according to any one of claims 1 to 8, wherein the support is treated with a polymer containing a phosphoric acid group.

10. The lithographic printing plate precursor according to any one of claims 1 to 8, wherein the support istreated with poly(vinylphosphonic acid).

11. The lithographic printing plate precursor according to any one of claims 1 to 10, wherein the crosslinker capable of reacting with at least one of the hydroxyl group and acid group in the polyvinyl acetal to form a crosslink (D) is selected from a group consisting of a compound having an aldehyde group, a compound having a hydroxy group or a methylol group, a phenol resin (novolac type or resol type), a melamine resin, a compound having a vinyl sulfone group, a compound having an epoxy group, an epoxy resin, a compound having a carboxylic acid, a compound having a carboxylic anhydride, a compound having an isocyanate group, borane, boric acid, phosphoric acid, a phosphoric acid ester compound, a metal alkoxide, alkoxysilane, or a compound having a combination thereof.

12. The lithographic printing plate precursor according to any one of claims 1 to 11, wherein the crosslinker capable of

reacting with at least one of the hydroxyl group and acid group in the polyvinyl acetal to form a crosslink (D) forms a crosslinking bond via any one of dehydration condensation, esterification, transesterification and chelation reactions.

**13.** The lithographic printing plate precursor according to any one of claims 1 to 12, wherein the crosslinker capable of reacting with at least one of the hydroxyl group and acid group in the polyvinyl acetal to form a crosslink (D) is selected from at least one of phenol resins, bisphenol epoxy resins, and novolac epoxy resins.

**14.** The lithographic printing plate precursor according to any one of claims 1 to 13, wherein the crosslinker capable of reacting with at least one of the hydroxyl group and acid group in the polyvinyl acetal to form a crosslink (D) has a weight average molecular weight (Mw) of 5000 or more.

**15.** The lithographic printing plate precursor according to any one of claims 1 to 14, wherein the crosslinker capable of reacting with at least one of the hydroxyl group and acid group in the polyvinyl acetal to form a crosslink (D) is present in an amount of 70 % by weight or less relative to the amount of the acetal resin added.

**16.** The lithographic printing plate precursor according to any one of claims 1 to 15, wherein the polyvinyl acetal resin containing at least one hydroxyl group (C) is a polyvinyl butyral resin represented by the structure shown below.

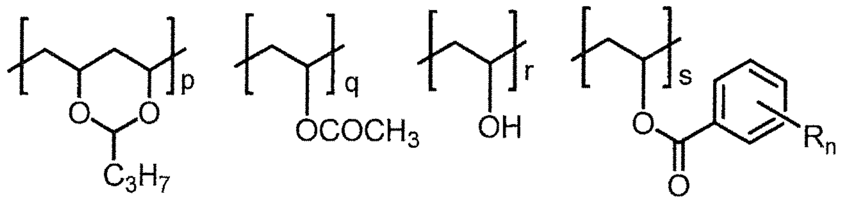

wherein p represents 10 to 90 mol %, q represents 0 to 25 mol %, r represents 1 to 40 mol %, s represents 0 to 25 mol %, and n represents an integer of 0 to 5. R represents a hydrogen atom, -COOH, or $-COOR^1$ wherein $R^1$ represents Na, K, or an alkyl group containing 1 to 8 carbon atoms.

**17.** A process for preparing a lithographic printing plate, comprising:

imagewise exposing a lithographic printing plate precursor according to any one of claims 1 to 16; and
developing the exposed lithographic printing plate precursor in the presence of a developer at pH 2 to 14 to remove the photosensitive layer in non-exposed areas.

**18.** The process for preparing a lithographic printing plate according to claim 17, wherein the exposing step comprises heating the exposed precursor at a temperature of 80 °C or more in a preheating unit.

**19.** The process for preparing a lithographic printing plate according to claim 17, wherein the developing step comprises removing the photosensitive layer in non-exposed areas and the protective layer simultaneously in the presence of the developer further containing a surfactant provided that no water-washing step is included.

**20.** The process for preparing a lithographic printing plate according to any one of claims 17 to 19, comprising controlling the pH of the developer at 2 to 14.

**21.** A process for preparing a lithographic printing plate, comprising:

imagewise exposing a lithographic printing plate precursor according to any one of claims 1 to 16; and
supplying a printing ink and a dampening water to remove the photosensitive layer in non-exposed areas on a printing press.

Fig.1

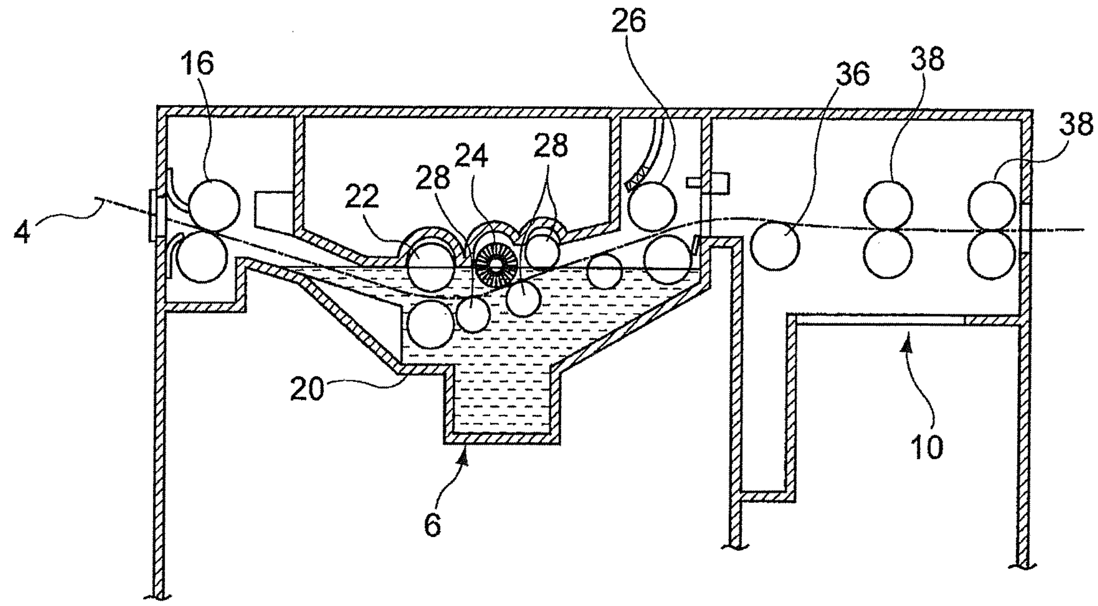

Fig.2

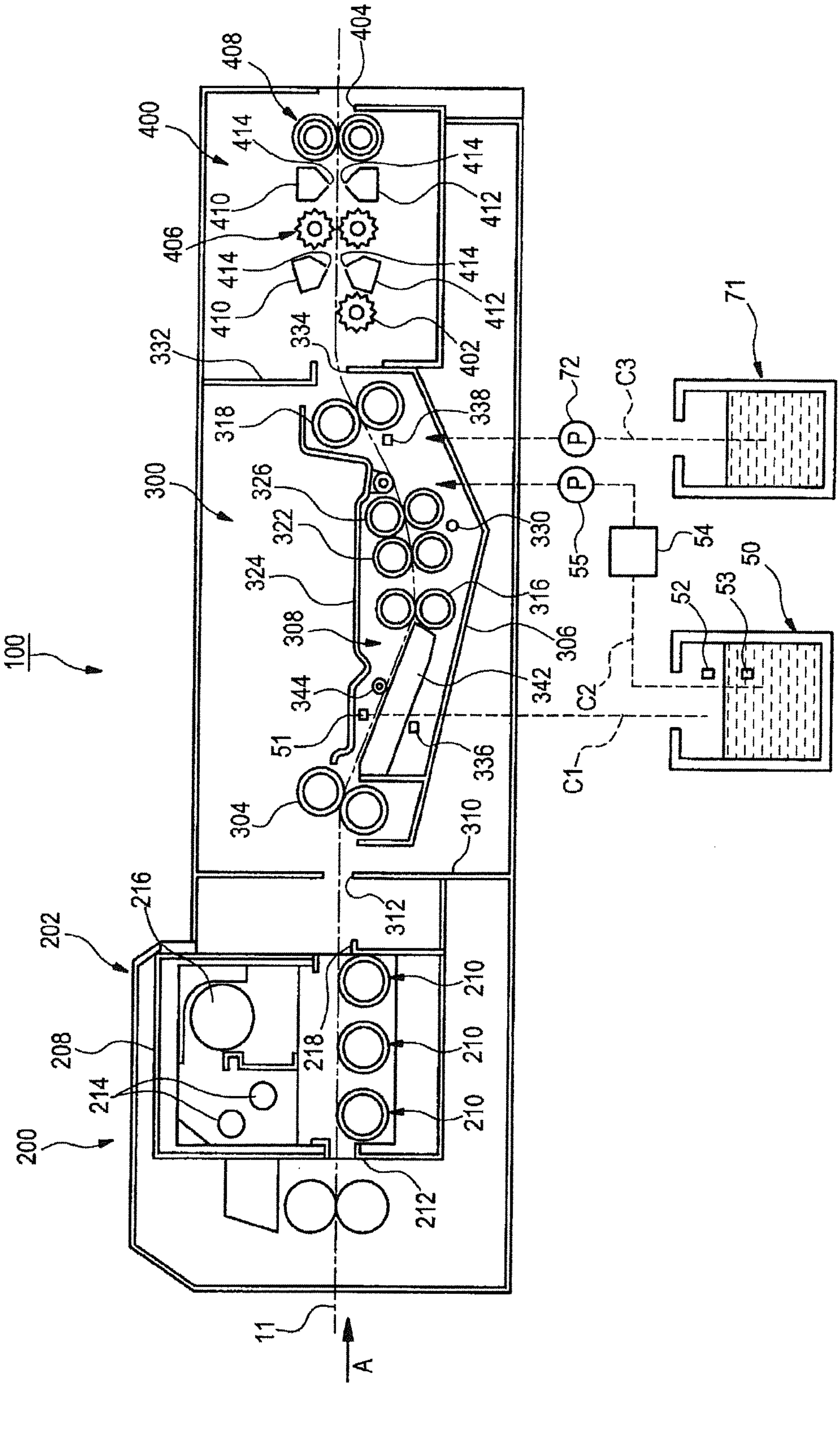
100
200
202
208
210
212
214
216
218
300
304
306
308
310
312
316
318
322
324
326
330
332
334
336
338
342
344
400
402
404
406
408
410
412
414
11
A
50
51
52
53
54
55
71
72
P
C1
C2
C3

**INTERNATIONAL SEARCH REPORT**

International application No.
PCT/JP2013/053617

A. CLASSIFICATION OF SUBJECT MATTER
*G03F7/033*(2006.01)i, *B41N1/14*(2006.01)i, *G03F7/00*(2006.01)i, *G03F7/004*(2006.01)i, *G03F7/027*(2006.01)i, *G03F7/11*(2006.01)i, *G03F7/32*(2006.01)i, *G03F7/38*(2006.01)i

According to International Patent Classification (IPC) or to both national classification and IPC

B. FIELDS SEARCHED

Minimum documentation searched (classification system followed by classification symbols)
G03F7/033, B41N1/14, G03F7/00, G03F7/004, G03F7/027, G03F7/11, G03F7/32, G03F7/38

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2009-244421 A (Fujifilm Corp.), 22 October 2009 (22.10.2009), & EP 2105796 A1 | 1-21 |
| A | JP 2010-504543 A (Eastman Kodak Co.), 12 February 2010 (12.02.2010), & US 2009/0202948 A1 & EP 1903399 A1 & WO 2008/034592 A1 & DE 602006009936 D & CN 101517493 A | 1-21 |
| A | JP 2006-142552 A (Konica Minolta Medical & Graphic, Inc.), 08 June 2006 (08.06.2006), (Family: none) | 1-21 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 March, 2013 (07.03.13) | 19 March, 2013 (19.03.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2013/053617

C (Continuation). DOCUMENTS CONSIDERED TO BE RELEVANT

| Category* | Citation of document, with indication, where appropriate, of the relevant passages | Relevant to claim No. |
|---|---|---|
| A | JP 2006-110884 A (Konica Minolta Medical & Graphic, Inc.), 27 April 2006 (27.04.2006), (Family: none) | 1-21 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4708925 A
- JP H8276558 A
- US 2850445 A
- JP S4420189 B
- JP 2938397 B
- JP 000211262 A
- JP 001277740 A
- JP 00229162 A
- JP 00246361 A
- JP 002137562 A
- JP 002326470 A
- JP 001166491 A
- JP 00363166 A
- JP 004276603 A
- JP 008213177 A
- JP 007118579 A
- JP 009516222 A
- WO 2007057348 A
- JP 007206217 A
- EP 1025992 A
- JP H10282679 A
- JP H2304441 A
- JP 005238816 A
- JP 005125749 A
- JP 006239867 A
- JP 2006215263 A
- JP H0545885 B
- JP H0635174 B
- JP S4841708 B
- JP S5137193 A
- JP H232293 B
- JP H216765 B
- JP S5849860 B
- JP S5617654 B
- JP S6239417 B
- JP S6239418 B
- JP 007506125 A
- EP 24629 A
- EP 107792 A
- US 4410621 A
- JP 2012031400 A
- JP 2007206217 A
- WO 2007057442 A
- JP 2007058170 A
- EP 1349006 A
- WO 2005029187 A
- JP 007171406 A
- JP 007206216 A
- JP 007225701 A
- JP 007225702 A
- JP 007316582 A
- JP 007328243 A
- JP 009516602 A
- GB 2192792 A
- JP 2001133969 A
- JP 002278057 A
- JP 2010139551 A
- WO 0204210 A
- GB 2192729 A
- JP 007276454 A
- JP 009154525 A
- JP 2007276454 A
- JP 2006297907 A
- JP 2007050660 A
- JP 2008284858 A
- JP 2009090645 A
- JP 2009208458 A
- JP 2011251431 A
- JP H09123387 B
- JP H09131850 B
- JP H09171249 B
- JP H09171250 B
- EP 931647 A
- JP 2001277740 A
- JP 2001277742 A
- EP 1491356 A
- US 20058971 B
- EP 2005053141 W
- EP 05105440 A
- JP 006106700 A
- JP 008203359 A
- JP 008276166 A
- EP 222297 A
- DE 2626473
- US 4786581 A

**Non-patent literature cited in the description**


- **F. R. MAYERS.** Management of Change in the Aluminium Printing Industry. *ATB Metallurgie Journal,* 2002, vol. 42 (1-2), 69
- **KOJI NAGANO et al.** Polyvinyl Alcohol, New Revised Edition. Polymer Publishing Ltd, 1970
- Crosslinker Handbook. Taiseisha Ltd, 1981
- Latest Pigment Handbook. Colour Index International (C.I.) database. 1977
- Latest Pigment Applied Technology. CMC Publishing Co., Ltd, 1986
- Printing Ink Technology. CMC Publishing Co., Ltd, 1984
- Dye Handbook. 1970